(19) **Europäisches Patentamt / European Patent Office / Office européen des brevets**

(11) **EP 4 250 890 A1**

(12) **EUROPEAN PATENT APPLICATION**
published in accordance with Art. 153(4) EPC

(43) Date of publication:
**27.09.2023 Bulletin 2023/39**

(21) Application number: **21894511.1**

(22) Date of filing: **09.11.2021**

(51) International Patent Classification (IPC):
*H05K 9/00* (2006.01)  *B32B 7/025* (2019.01)
*B32B 15/04* (2006.01)  *B32B 15/08* (2006.01)
*B32B 27/18* (2006.01)  *H01Q 17/00* (2006.01)

(52) Cooperative Patent Classification (CPC):
**B32B 7/025; B32B 15/04; B32B 15/08;
B32B 27/18; H01Q 17/00; H05K 9/00**

(86) International application number:
**PCT/JP2021/041096**

(87) International publication number:
**WO 2022/107637 (27.05.2022 Gazette 2022/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **18.11.2020  JP 2020191772
07.10.2021  JP 2021165145
07.10.2021  JP 2021165149
07.10.2021  JP 2021165150**

(71) Applicant: **TOPPAN INC.**
**Tokyo 101-0024 (JP)**

(72) Inventors:
• **AOKI, Atsuko**
  **Tokyo 110-0016 (JP)**
• **KONDO, Shinpei**
  **Tokyo 110-0016 (JP)**

(74) Representative: **TBK**
**Bavariaring 4-6**
**80336 München (DE)**

(54) **ELECTROMAGNETIC WAVE ATTENUATING FILM**

(57)    There is provided a thin electromagnetic wave attenuation film capable of attenuating electromagnetic waves having frequencies in millimeter-wave bands. The present invention provides an electromagnetic wave attenuation film including a dielectric substrate having a front surface and a rear surface, a thin-film conductive layer disposed on the front surface, and a planar inductor or a lamination layer disposed on the rear surface, wherein the thin-film conductive layer includes a plurality of metal plates, and values of natural logarithms obtained by normalizing a thickness T of the metal plates by a skin depth d thereof are in predetermined numerical ranges within a predetermined frequency range. The electromagnetic wave attenuation film is used in the predetermined frequency range, and may have a structure in which the front surface of the dielectric substrate has asperities which include at least two first regions as concavities located at a relatively low level, and a second region located at a relatively high level; the thin-film conductive layer includes a plurality of metal plates arranged in the at least two first regions; the at least two first regions are discretely arranged; and the second region is located between the two first regions. A top coat layer may be provided on the thin-film conductive layer.

FIG.7

EP 4 250 890 A1

**Description**

[Technical Field]

The embodiments of the present invention relate to electromagnetic wave attenuation films capable of capturing incident waves and attenuating reflected waves.

[Background Art]

Mobile communications such as cell phones, wireless LAN, electronic toll collection systems (ETC), and the like use radio waves with frequency ranges of several gigahertz (GHz).
As radio wave absorption sheets absorbing such radio waves, PTL 1 proposes a laminate sheet in which a rubber-like radio wave absorption sheet and a paper-like sheet member such as a cardboard are laminated with each other.
Furthermore, for the purpose of absorbing radio waves in higher frequency ranges, PTL 2 proposes a radio wave absorption sheet in which flat soft magnetic particles are oriented so that the long axes of the particles are parallel to the plane of the sheet to absorb radio waves in high frequency ranges of 20 GHz or more.
It is known that radio wave absorbers with a structure of densely packed particles having epsilon iron oxide ($\varepsilon$-$Fe_2O_3$) crystals in the magnetic phase exhibit radio wave absorption performance in a range of 25 to 100 GHz (see PTL 3).
PTL 4 proposes a thin metal film - plastic film composite film preferred to be used in electromagnetic wave absorbers, including a plastic film and a monolayer or multilayer thin metal film provided on at least one surface of the plastic film, with the thin metal film being provided with a plurality of substantially parallel intermittent linear marks in multiple directions with irregular widths and intervals.
PTL 5 discloses a radio wave absorption structure including a resonance layer in which multiple patch conductors having individual resonance frequencies are arrayed in a predetermined periodic pattern, a dielectric layer for multiple reflection of the radio waves resonating in the resonance layer, and a reflective conductor layer which reflects radio waves incident from the dielectric layer toward the dielectric layer.
The electromagnetic wave absorption sheets as mentioned above are used for building interiors and the like other than in electronic devices. As described in PTL 6, such electromagnetic wave absorbing materials include acrylate copolymer modified resins such as epoxy resins, polyurethane resins, chlorinated rubber resins, vinyl chloride resins, alkyd resins, unsaturated polyester resins, and epoxy acrylate resins. Furthermore, rubber-based materials such as polyamide-imide and synthesized rubber as described in PTL 7 are also used.

[Citation List]

[Patent Literature]

PTL 1: JP 2011-233834 A
PTL 2: JP 2015-198163 A
PTL 3: JP 2008-060484 A
PTL 4: WO2010/093027 A
PTL 5: JP 2020-009829 A
PTL 6: JP 2612592 B
PTL 7: JP 2006-86422 A

[Summary of the Invention]

[Solution to Problem]

In recent years, wireless communication using millimeter-wave bands at 30 GHz or higher has been put to practical use in order to enable high-capacity data transmission, high-speed communication, and simultaneous multipoint connection, and development of compatible devices is progressing. In addition, use of in-vehicle radar equipment that utilizes extremely narrow directivity is being promoted.
Interference due to irregular reflection of electromagnetic waves in device housings may cause these devices to malfunction. Accordingly, suppressing electromagnetic wave noise is important as an electromagnetic wave utilization technology.

As one method of suppressing electromagnetic wave noise, utilization of the electromagnetic wave absorption sheets as mentioned above may be considered; however, most of such sheets used currently are only compatible with frequencies of 20 GHz to several tens of GHz and are not compatible with millimeter-wave bands.

Electromagnetic wave absorption sheets absorbing electromagnetic waves in millimeter-wave bands are available currently; however, such practically used sheets have large thicknesses to maintain absorption performance.

Accordingly, it is difficult to incorporate such sheets in the housings of devices with increasing integration to suppress electromagnetic noise.

In light of the circumstances set forth above, it is an aim to provide a thin electromagnetic wave attenuation film capable of attenuating electromagnetic waves having frequencies in millimeter-wave bands. It is also an aim to provide an electromagnetic wave attenuation film having good environmental resistance, such as weather resistance and heat resistance, because the electromagnetic wave absorbers installed in electronic devices and building interiors are continuously used for a long period of time. The electromagnetic wave attenuation film of the present invention is considered to be a film capable of stationary localization of electromagnetic fields. In other words, the electromagnetic wave attenuation film of the present invention is considered to be a film capable of capturing electromagnetic fields. "Capturing" of electromagnetic fields can be a state in which electrical and magnetic fields are localized and stationary. The captured electromagnetic fields are partly absorbed by being converted into heat and partly re-emitted. In other words, the energy of the captured electromagnetic fields is converted into thermal energy and electromagnetic energy to be re-emitted. This re-emission is generally considered to have low directivity and, therefore, is considered to reduce electromagnetic waves in the direction of specular reflection and attenuate reflected waves. Accordingly, reflected waves of electromagnetic waves can be attenuated by being absorbed due to conversion of incident electromagnetic waves into heat or being scattered due to re-emission. Since electromagnetic waves are attenuated by a mechanism different from that of the conventional art, the attenuation can be achieved with a structure having 1/4 or less the thickness of the conventional art, for wavelengths that have been considered to be impossible to attenuate. Furthermore, according to an embodiment of the present invention, a film capable of attenuating electromagnetic waves can be obtained with a thickness of the order of $10^{-2}$ wavelengths.

[Solution to Problem]

The present invention relates to an electromagnetic wave attenuation film including: a dielectric substrate having a front surface and a rear surface; a thin-film conductive layer disposed on the front surface, the thin-film conductive layer including a plurality of discretely arranged metal plates; and a planar inductor or a lamination layer disposed on the rear surface, wherein the electromagnetic wave attenuation film is configured to attenuate millimeter waves within a predetermined frequency range. A top coat layer may be provided on the thin-film conductive layer.

In one of electromagnetic wave attenuation films according to the present invention, values of natural logarithms of values obtained by normalizing a thickness T of the metal plates by a skin depth d thereof are in predetermined numerical ranges in specific frequency ranges. Specifically, $-1.0 \leq \ln(T/d) \leq 0.0$ is satisfied in a frequency range of 27 GHz to 34 GHz, $-2.0 \leq \ln(T/d) < -0.5$ is satisfied in a frequency range of 35 GHz to 50 GHz, and $-2.5 \leq \ln(T/d) \leq -1.0$ is satisfied in a frequency range of 57 GHz to 90 GHz.

In another one of electromagnetic wave attenuation films according to the present invention, the dielectric substrate has asperities on the front surface, the asperities including at least two first regions as concavities located at a relatively low level, and a second region located at a relatively high level. The thin-film conductive layer includes a plurality of metal plates arranged in the at least two first regions. The at least two first regions are discretely arranged, and the second region is located between the two first regions. Specifically, the film is used in frequency ranges of 27 GHz to 34 GHz, 35 GHz to 50 GHz, and 57 GHz to 90 GHz.

[Advantageous Effects of the Invention]

According to an embodiment of the present invention, a thin electromagnetic wave attenuation film capable of attenuating electromagnetic waves having frequencies in millimeter-wave bands can be provided. Also, an electromagnetic wave attenuation film having good weather resistance can be provided.

[Brief Description of the Drawings]

Fig. 1 is a schematic plan view illustrating an electromagnetic wave attenuation film according to a first embodiment of the present invention.
Fig. 2 is a schematic diagram illustrating a part of a cross section taken along the line I-I of Fig. 1.

Fig. 3 is a schematic diagram illustrating the part of a cross section taken along the line I-I of Fig. 1, with a top coat layer provided.

Fig. 4 is a set of images showing an electrical field intensity simulation with no support cage, in which (b) is an enlarged image of part of (a).

Fig. 5 is a set of images showing an electrical field intensity simulation with a support cage, in which (b) is an enlarged image of part of (a).

Fig. 6 is a schematic plan view illustrating an electromagnetic wave attenuation film according to a second embodiment of the present invention.

Fig. 7 is a schematic diagram illustrating a part of a cross section taken along the line II-II of Fig. 6.

Fig. 8 is a schematic diagram illustrating the part of the cross section taken along the line II-II of Fig. 6, with a top coat layer provided.

Fig. 9 is a graph showing an attenuation simulation of electromagnetic waves by varying the thickness of metal plates.

Fig. 10 is a set of diagrams showing electromagnetic wave attenuation characteristics at 27 GHz in Example 1A.

Fig. 11 is a set of diagrams showing electromagnetic wave attenuation characteristics at 28 GHz in Example 1A.

Fig. 12 is a set of diagrams showing electromagnetic wave attenuation characteristics at 31 GHz in Example 1A.

Fig. 13 is a set of diagrams showing electromagnetic wave attenuation characteristics at 34 GHz in Example 1A.

Fig. 14 is a set of diagrams showing electromagnetic wave attenuation characteristics at 28 GHz in Example 1B as a function of the percentage of metal area.

Fig. 15 is a set of diagrams showing electromagnetic wave attenuation characteristics when the metal plates have a circular shape in Example 1C.

Fig. 16 is a set of diagrams showing electromagnetic wave attenuation characteristics when the metal plates have a rectangular shape in Example 1C.

Fig. 17 is a set of diagrams showing electromagnetic wave attenuation characteristics when the metal plates have a hexagonal shape in Example 1C.

Fig. 18 is a set of diagrams showing electromagnetic wave attenuation characteristics when the metal plates have a convex shape in Example 1C.

Fig. 19 is a set of diagrams showing electromagnetic wave attenuation characteristics when the metal plates have a triangular shape in Example 1C.

Fig. 20 is a set of diagrams showing electromagnetic wave attenuation characteristics when the metal plates have a cross shape in Example 1C.

Fig. 21 is a graph showing electromagnetic wave attenuation characteristics in Example 1D.

Fig. 22 is a graph showing electromagnetic wave attenuation characteristics when a top coat layer is provided in Example 1A.

Fig. 23 is a set of diagrams showing electromagnetic wave attenuation characteristics at 35 GHz in Example 2A.

Fig. 24 is a set of diagrams showing electromagnetic wave attenuation characteristics at 39 GHz in Example 2A.

Fig. 25 is a set of diagrams showing electromagnetic wave attenuation characteristics at 41 GHz in Example 2A.

Fig. 26 is a set of diagrams showing electromagnetic wave attenuation characteristics at 45 GHz in Example 2A.

Fig. 27 is a set of diagrams showing electromagnetic wave attenuation characteristics at 50 GHz in Example 2A.

Fig. 28 is a set of diagrams showing electromagnetic wave attenuation characteristics at 39 GHz in Example 2B as a function of the percentage of metal area.

Fig. 29 is a set of diagrams showing electromagnetic wave attenuation characteristics when the metal plates have a circular shape in Example 2C.

Fig. 30 is a set of diagrams showing electromagnetic wave attenuation characteristics when the metal plates have a rectangular shape in Example 2C.

Fig. 31 is a set of diagrams showing electromagnetic wave attenuation characteristics when the metal plates have a hexagonal shape in Example 2C.

Fig. 32 is a set of diagrams showing electromagnetic wave attenuation characteristics when the metal plates have a convex shape in Example 2C.

Fig. 33 is a set of diagrams showing electromagnetic wave attenuation characteristics when the metal plates have a triangular shape in Example 2C.

Fig. 34 is a set of diagrams showing electromagnetic wave attenuation characteristics when the metal plates have a cross shape in Example 2C.

Fig. 35A is a set of diagrams showing electromagnetic wave attenuation characteristics when the metal plates have a loop shape in Example 2C.

Fig. 35B is a set of diagrams showing electromagnetic wave attenuation characteristics according to a modification in which two electromagnetic wave attenuation films whose metal plates have a loop shape are overlapped with each other in Example 2C.

Fig. 36 is a graph showing electromagnetic wave attenuation characteristics in Example 2D.

Fig. 37 is a graph showing electromagnetic wave attenuation characteristics when a top coat layer is provided in Example 2A.

Fig. 38 is a set of diagrams showing electromagnetic wave attenuation characteristics at 57 GHz in Example 3A.

Fig. 39 is a set of diagrams showing electromagnetic wave attenuation characteristics at 66 GHz in Example 3A.

Fig. 40 is a set of diagrams showing electromagnetic wave attenuation characteristics at 71 GHz in Example 3A.

Fig. 41 is a set of diagrams showing electromagnetic wave attenuation characteristics at 81 GHz in Example 3A.

Fig. 42 is a set of diagrams showing electromagnetic wave attenuation characteristics at 86 GHz in Example 3A.

Fig. 43 is a set of diagrams showing electromagnetic wave attenuation characteristics at 90 GHz in Example 3A.

Fig. 44 is a set of diagrams showing electromagnetic wave attenuation characteristics at 81 GHz in Example 3B as a function of the percentage of metal area.

Fig. 45 is a set of diagrams showing electromagnetic wave attenuation characteristics when the metal plates have a rectangular shape in Example 3C.

Fig. 46 is a set of diagrams showing electromagnetic wave attenuation characteristics when the metal plates have a hexagonal shape in Example 3C.

Fig. 47 is a set of diagrams showing electromagnetic wave attenuation characteristics when the metal plates have a convex shape in Example 3C.

Fig. 48 is a set of diagrams showing electromagnetic wave attenuation characteristics when the metal plates have a triangular shape in Example 3C.

Fig. 49 is a set of diagrams showing electromagnetic wave attenuation characteristics when the metal plates have a cross shape in Example 3C.

Fig. 50 is a graph showing electromagnetic wave attenuation characteristics in Example 3A.

Fig. 51 is a graph showing electromagnetic wave attenuation characteristics in Example 3D.

Fig. 52 is a graph showing electromagnetic wave attenuation characteristics when a top coat layer is provided in Example 3A.

Fig. 53 is a graph showing a relationship between metal plate dimension and wavelength of attenuated electromagnetic waves.

[Description of the Embodiments]

An electromagnetic wave attenuation film 1 includes a dielectric substrate (dielectric layer) 10, a thin-film conductive layer 30 formed on a front surface 10a of the dielectric substrate 10, and a planar inductor 50 formed on a rear surface 10b of the dielectric substrate. The thin-film conductive layer is a layer of a thin conductor. The thin-film conductive layer includes a plurality of metal plates. The thin-film conductive layer may include a support cage (described layer). The planar inductor has electrical conductivity and produces a current in the vicinity of the surface inside the planar inductor due to external magnetic flux. With the current produced, the planar inductor has a function of generating a magnetic field in the vicinity of the external surface thereof. The planar inductor can have a shape of a flat plate (slab). The dielectric substrate is an insulating substrate sandwiched between the thin-film conductive layer and the planar inductor. In other words, the thin-film conductive layer and the planar inductor are separated from each other in the thickness direction of the dielectric substrate with the dielectric substrate sandwiched therebetween. The front surface can be a surface on which electromagnetic waves are incident. The rear surface can be a surface of the dielectric substrate facing away from the front surface. The dielectric substrate 10 may have first regions 121 in which the front surface is at a relatively low level, and a second region in which the front surface is at a relatively high level around the first regions. The thin-film conductive layer located in the second region 122 is referred to as a support cage. In other words, the thin-film conductive layer includes the support cage in the second region 122.

If the electromagnetic waves attenuated by the electromagnetic wave attenuation film have a single local minimum frequency f, this frequency f is defined to be an attenuation center frequency f. If the electromagnetic waves attenuated by the electromagnetic wave attenuation film have a plurality of local minimum values, the average frequency of a plurality of frequencies that are -3dB from the minimum value having the maximum attenuation is defined to be an attenuation center frequency. An attenuation center wavelength can be obtained by dividing the speed of light in the dielectric substrate by the attenuation center frequency f described later.

The electromagnetic wave attenuation film 1 may include a top coat layer 200 aiming for impedance matching with air and enhancing weather resistance of the sheet.

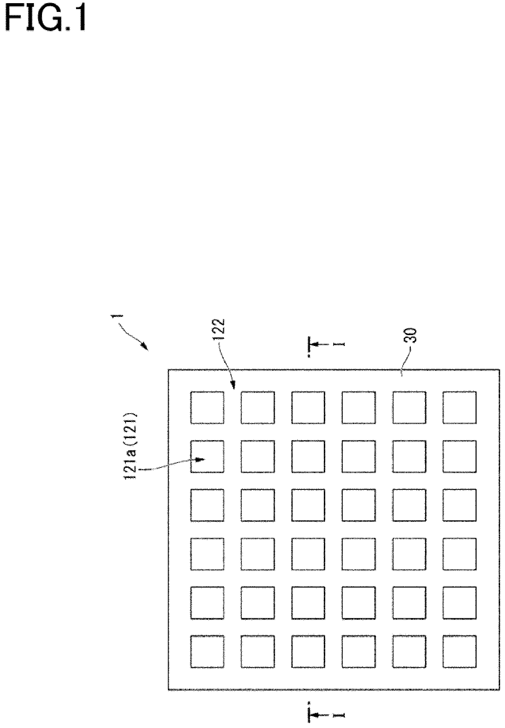

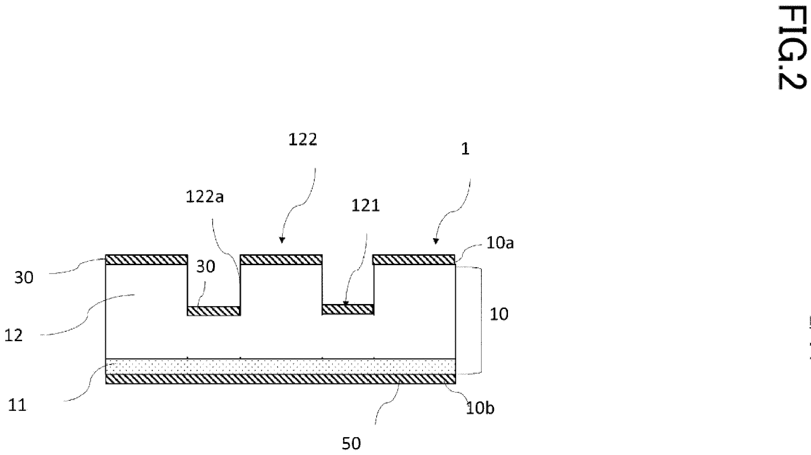

Fig. 1 is a schematic plan view illustrating the electromagnetic wave attenuation film 1 according to a first embodiment of the present invention. Fig. 2 is a schematic diagram illustrating a part of a cross section taken along the line I-I of Fig. 1.

The dielectric substrate 10 is formed of a dielectric and can form a capacitor by being sandwiched between conductive materials. The dielectric substrate 10 can be an insulating material.

Typical examples of the material for forming the dielectric substrate 10 are synthetic resins. The type of the synthetic resins is not particularly limited as long as the resins have sufficient strength, flexibility and processability in addition to insulation properties. The synthetic resins can be thermoplastic resins. Examples of the synthetic resins include polyesters such as polyethylene terephthalate (PET); polyarylene sulfide such as polyphenylene sulfides; polyolefins such as polyethylene and polypropylene; polyamides; polyimides; polyamide-imides; polyethersulfones; polyetheretherketones; polycarbonate; acrylic resins; and polystyrenes. These materials may be used singly or in combination of two or more, or may be used as a laminate. The dielectric substrate 10 may contain conductive particles, insulating particles, magnetic particles, or mixtures thereof.

In the embodiments of the present invention, the thickness of the dielectric substrate can be sufficiently reduced with respect to the wavelength of electromagnetic waves. It is known that if the thickness of the dielectric substrate is sufficiently small with respect to the wavelength of electromagnetic waves, no traveling waves are generated in the dielectric substrate. The expression "sufficiently small" can be less than 1/2 of the wavelength. Below 1/2 wavelength, traveling waves cannot be guided. This is a phenomenon called electromagnetic wave cut-off. Sufficiently small can be 1/10 or less of the wavelength. Generally, if the difference in propagation distance of electromagnetic waves is 1/10 or less of the wavelength, no substantial phase difference occurs. Specifically, if the distance between the metal plates and the planar inductor is 1/10 or less of the wavelength in the dielectric substrate, no substantial phase difference occurs between the electromagnetic waves re-emitted from the metal plates and the reflected waves from the planar inductor, because of the distance. Electromagnetic waves are considered not to be guided in a sufficiently thin dielectric substrate sandwiched between conductors. Usually, electromagnetic waves are cut off due to such thinness and no electrical or magnetic field is localized in such a dielectric substrate. This wavelength in the embodiments of the present invention can be an attenuation center wavelength. Even when the dielectric substrate is 1/100 or less of the wavelength, attenuation can be achieved. Such a thickness is of the same level as the asperities of a highest precision mirror surface, which means that attenuation is achieved with a structure having substantially no thickness relative to the scale of the electromagnetic waves.

As a result of various experiments and simulations, the present inventors have found that stationary localization of electrical and magnetic fields due to electromagnetic waves occurs even in a sufficiently thin dielectric substrate. The dielectric substrate 10 can have a thickness of 5 $\mu$m or more and 300 $\mu$m or less. The dielectric substrate 10 can more preferably have a thickness of 5 $\mu$m or more and 100 $\mu$m or less. This is smaller than 1/2 of the wavelength of millimeter-wave bands, or even smaller than 1/10 of the wavelength of millimeter-wave bands. Therefore, the electromagnetic wave attenuation film, although it is thin, can attenuate electromagnetic waves in millimeter-wave bands. The thickness of the dielectric substrate 10 may be constant or variable.

The dielectric substrate 10 may be a monolayer or multilayer. The front surface of the dielectric substrate 10 may have asperities. The dielectric substrate 10 may include a carrier 11 and a primer layer 12 disposed on the carrier 11. The front surface of the primer layer 12 may have asperities. The carrier 11 can be an extruded film. The extruded film can be an unstretched or stretched film. The primer layer 12 may be formed of two layers which are a forming layer and an anchor layer. An adhesive layer may be additionally provided to improve adhesion between the primer layer 12 and the metal plates or the planar inductor. The primer layer 12, the forming layer, the anchor layer, and the adhesive layer may be made of the same materials as those of the dielectric substrate.

The carrier 11 forms the rear surface 10b of the dielectric substrate 10, and the primer layer 12 forms the front surface 10a of the dielectric substrate 10. If the front surface 10a has asperities, the primer layer 12 may be provided with an uneven structure. Specifically, the front surface 10a of the dielectric substrate 10 has asperities conforming to the asperities of the primer layer 12, while the rear surface 10b of the dielectric substrate 10 is substantially planar.

Characteristics of the electromagnetic wave attenuation film 1 depends on the type of the asperities of the front surface 10a. This will be described later.

The thin-film conductive layer 30 covers all or part of the front surface 10a in plan view of the electromagnetic wave attenuation film 1. The planar inductor 50 covers all or part of the rear surface 10b. The peripheral edge of the electromagnetic wave attenuation film 1, for example, may include portions that are not covered with the thin-film conductive layer 30 or the planar inductor 50 as long as the performance of the electromagnetic wave attenuation film 1 is not significantly impaired.

Materials for the thin-film conductive layer 30 and the planar inductor 50 are not particularly limited as long as the materials have electrical conductivity. From the perspective of corrosion resistance and cost, it is preferred to use aluminum, copper, silver, gold, platinum, tin, nickel, cobalt, chromium, molybdenum, iron, or alloys thereof. The thin-film conductive layer 30 and the planar inductor 50 can be formed, for example, by subjecting the dielectric substrate 10 to vacuum deposition. The planar inductor 50 may be made of an electrically conductive compound. The planar inductor 50 may have a continuous surface or may have patterns such as mesh or patches.

The thickness of the thin-film conductive layer 30 can be 10 nm or more and 1,000 nm or less. If the thickness is less than 10 nm, the electromagnetic wave attenuation function may be deteriorated. If the thickness exceeds 1,000 nm, productivity may be reduced.

The planar inductor 50 may be a cast metal, a rolled metal plate, metal foil, deposited film, sputtered film, or plating. The thickness of the rolled metal plate can be 0.1 mm or more and 5 mm or less. The thickness of the metal foil can be 5 $\mu$m or more and less than 100 $\mu$m. If the planar inductor 50 is a vapor-deposited film, sputtered film, or plated film, the thickness can be 0.5 $\mu$m or more and less than 5 mm. The thickness of the planar inductor 50 can be 0.5 $\mu$m to 5 mm. If the planar inductor 50 is a cast metal, the thickness is not specified but the maximum dimension can be 10 mm or more. The thickness of the planar inductor 50 can be not less than the skin depth obtained from the attenuation center wavelength. The planar inductor 50 can be thicker than the thin-film conductive layer 30.

The same metal species can be used for the thin-film conductive layer 30 and the planar inductor 50. As the same metal species, the same pure metal or alloys of the same metal (e.g., both may be aluminum alloys) may be used, or the thin-film conductive layer 30 may be a pure metal and the planar inductor 50 may be an alloy of the metal of the thin-film conductive layer 30. The metal species of the thin-film conductive layer 30 may be different from that of the planar inductor 50.

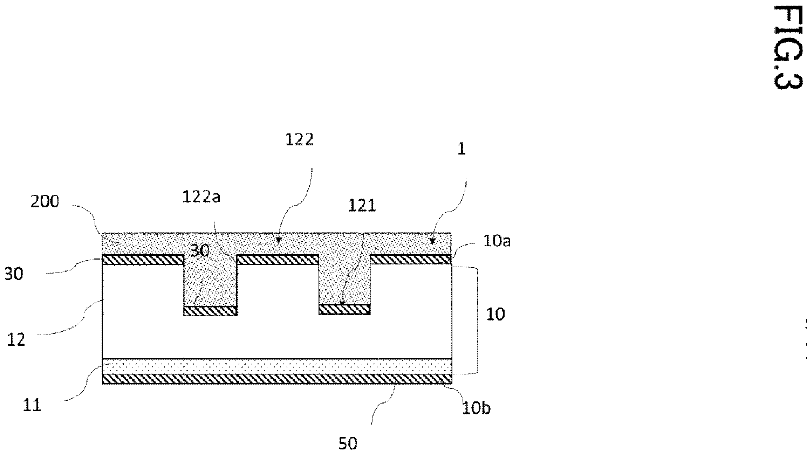

The thin-film conductive layer 30 may be provided with a top coat layer 200 on the surface facing away from the dielectric substrate. Fig. 3 is a schematic diagram illustrating the part of a cross section taken along the line I-I of Fig. 1, with a top coat layer provided. The planar inductor 50 may also be provided with a top coat layer 200 on the surface opposite to the dielectric substrate. The thickness of the top coat layer 200 can be 0.1 $\mu$m or more and 50 $\mu$m or less. The thickness can more preferably be 1 $\mu$m or more and 5 $\mu$m or less. The top coat layer 200 may be a monolayer or a multilayer. The top coat layer 200 can be made of a material that is a simple substance of a urethane resin, acrylic resin, polyamide, polyimide, polyamide-imide, epoxy resin, or silicone resin, or mixtures or composites thereof. The material may contain insulating particles, magnetic particles, conductive particles, or mixtures thereof. The particles can be inorganic particles. Provision of the top coat layer 200 can achieve impedance matching with the air through which radio waves are propagative and can effectively attenuate radio waves for the thin-film conductive layer. In addition, the thin-film conductive layer 30 and the planar inductor 50 can be imparted with corrosion resistance, chemical resistance, heat resistance, abrasion resistance, impact resistance, and the like. For example, using a crosslinked acrylic resin, crosslinked epoxy resin, polyamide, polyimide, polyamide-imide, silicone resin, or the like, heat resistance can be improved, in addition to improving solvent resistance. Furthermore, use of a urethane resin or the like can improve impact resistance, and use of a silicone resin can improve abrasion resistance.

The dielectric substrate 10 may have first regions 121 in which the front surface is at a relatively low level, and a second region in which the front surface is at a relatively high level. In plan view, the first regions 121 can have a square, hexagonal, or cross shape or other polygonal shapes, or a circular or elliptical shape. The square, hexagonal, or cross shape or other polygonal shapes can have round corners.

The first regions 121 are discretely arranged. The first regions 121 are arrange in a twodimensional matrix at a predetermined pitch. The second region 122 encloses the first regions 121 in plan view of the electromagnetic wave attenuation film 1. The thin-film conductive layer 30 portions in the respective first regions 121 include respective metal plates. Specifically, metal plates are provided in the respective first regions 121. In other words, each metal plate is provided in the corresponding first region 121. In plan view, the metal plates may have a square, hexagonal, or cross shape or other polygonal shapes, or a circular or elliptical shape. The square, hexagonal, or cross shape or other polygonal shapes can have round corners. The second region 122 is formed in a mesh or lattice pattern in plan view, depending on the above-mentioned forms of the first regions 121.

The surfaces of the first regions 121 and the second region 122 contacting the thin-film conductive layer 30 portions are substantially parallel to the rear surface. These surfaces may be partly or entirely roughened. As will be described later, electrical resistance of the thin-film conductive layer 30 can be controlled by partly or entirely roughening the surfaces of the first regions 121 and the second region 122 contacting the thin-film conductive layer 30 portions.

As shown in Fig. 2, the thin-film conductive layer 30 is formed on the upper surfaces of the first regions 121 and the second region 122. However, the thin-film conductive layer 30 is not provided to side surfaces 122a of the second region 122 extending upward from the first regions 121, and the dielectric substrate 10 is exposed at these side surfaces. Thus, the thin-film conductive layer 30 portions of the first regions 121 can be electrically insulated from the thin-film conductive layer 30 of the second region 122. As long as they are electrically insulated, part of the side surfaces 122a may be covered with the thin-film conductive layer 30.

The metal plates in the respective first regions can have a shape conforming to the shape of the first regions 121 in plan view. Specifically, the metal plates can have a shape that is the same as or similar to the shape of the first regions 121 in plan view. The dielectric substrate 10 may include a plurality of metal plates with a constant shape and size in plan view. The first regions 121 can be discretely arranged while being parallel to each other, and the placement density on the front surface can be substantially uniform.

The electromagnetic wave attenuation film 1 is considered to develop a unique mechanism at a specific wavelength with the structure described above.

Electromagnetic waves incident on the electromagnetic wave attenuation film of the present invention behave as described below. Specifically, the electromagnetic fields and current generated by the incident waves are considered to behave as follows.

First, fluctuations in the magnetic flux of the incident waves passing through the metal plates induce an alternating current in the planar inductor 50 that is parallel to the incidence surface of the planar inductor 50 according to Faraday's law. The alternating current generates a fluctuating magnetic field in the dielectric substrate adjacent to the planar inductor 50 according to Ampere's law. The fluctuating magnetic field becomes a magnetic flux that fluctuates with the magnetic permeability as a coefficient.

Electrical fields generated by fluctuating magnetic fluxes normally induce current in the direction of suppressing the magnetic fluxes according to Henry's law. However, conversely, with the structure of the present invention, the electrical fields act in the direction of increasing the current. Thus, a current that is larger than the current induced by the incident waves passes through the metal plates. Specifically, the metal plates, whose area is smaller than the area of the planar inductor 50, can produce a current that is approximately of the same level as in the planar inductor 50.

The direction of the current produced in the metal plates is the reverse of the current in the planar inductor 50. The current passing through the metal plates and the planar inductor 50 in opposite directions and the displacement current passing therebetween can form closed circuits. If closed circuits are formed only by the metal plates and the planar inductor 50 and if no electrical flux is generated parallel to the electromagnetic wave attenuation film in the space external to the film, reflected waves cannot be generated. The reflected waves from the planar inductor 50 are deviated in phase by $\pi$ from the electromagnetic waves re-emitted due to the current of the metal plates, and thus these waves cancel each other.

According to the above principle, the reflected waves from the electromagnetic wave attenuation film are attenuated. From the perspective of energy, multiple mechanisms are considered to be synergistically acting as follows.

As will be shown later using a magnetic field density simulation, the first mechanism is generation of a non-travelling, cyclically oscillating electromagnetic field caused by incident waves. First, a magnetic flux is induced by the planar inductor 50 located on the rear surface of the dielectric substrate 10, in the tangential direction of the planar inductor 50.

The induced magnetic flux generates an electrical field in the direction extending from two opposing sides of each thin-film conductive layer 30 portion (i.e., each metal plate) in the corresponding first region 121, i.e., in the direction perpendicular to the planar inductor 50. Next, when electromagnetic waves are incident on the planar inductor, a current is induced due to the fluctuating magnetic flux so as to approach the vicinity of the surface of the planar inductor. The current induced in the planar inductor generates a magnetic field in the dielectric substrate 10 close to the surface of the planar inductor. This electrical field and the current of the metal plate and the planar inductor 50 generate a magnetic field in the same direction as that of the magnetic flux induced between the metal plate and the planar inductor 50, by the planar inductor 50. Herein, the metal plates each have a plate-like shape and are made of metal. The electrical field generated in the dielectric substrate fluctuates in the same cycle as that of the incident waves. The cyclic fluctuations of the magnetic field cyclically fluctuate the electrical field between each thin-film conductive layer 30 portion and the planar inductor 50. As a result, a non-travelling cyclically fluctuating electromagnetic field is generated between the thin-film conductive layer 30 portion and the planar inductor 50. As will be shown later using a current density simulation, the magnetic field in the cyclically fluctuating electromagnetic field induces an alternating current in the metal plate. Also, the cyclically fluctuating electrical field generates a cyclically fluctuating potential in the metal plate. The electromagnetic field does not progress but remains in place and the power of the induced alternating current dissipates, resultantly converting the energy of the electromagnetic field into heat, thereby absorbing the electromagnetic waves. The alternating current induced in the metal plate is considered to re-emit electromagnetic waves from the surface of the metal plate facing away from the surface contacting the dielectric substrate 10.

In other words, the energy of the electromagnetic waves captured by the electromagnetic wave attenuation film is considered to be partly converted to thermal energy with the remaining energy re-emitted. According to the classical theory of electromagnetism expressed by Maxwell's equations, etc., the frequency of an induced alternating current matches the frequency of incident waves and, therefore, the frequency of the re-emitted electromagnetic waves matches the frequency of the incident waves. As a result, electromagnetic waves whose frequency matches that of the incident waves are re-emitted. Furthermore, if an oscillating electromagnetic field is considered as quanta, the quanta are considered to lose energy and re-emit electromagnetic waves with longer wavelength and lower energy. The re-emission is considered to include induced emission due to incident electromagnetic waves and spontaneous emission. In the induced emission, electromagnetic waves coherent with the reflected waves of the incident waves are considered to be emitted in the reflection direction of the incident waves, i.e., the specular direction. The spontaneous emission is considered to attenuate over time. The spatial distribution of the spontaneous emission is considered to be close to Lambertian reflectance if the electromagnetic wave attenuation film has no diffraction structure, interference structure, or refraction structure.

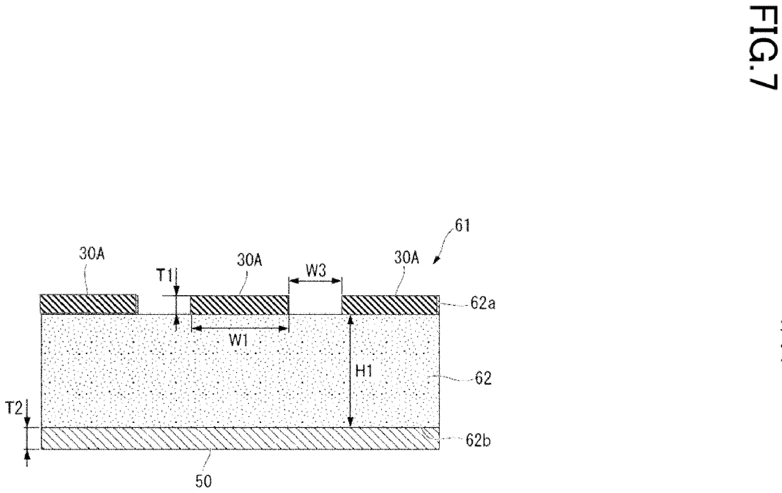

The attenuation center wavelength correlates to a dimension W1 (which may be termed width W1 hereinafter; refer to Fig. 7) parallel to the plane of the thin-film conductive layer 30 portion formed in each first region 121 shown in Fig. 2. Specifically, the wavelength of electromagnetic waves preferably attenuated by the first mechanism can be changed by changing the dimension W1 and, in the electromagnetic wave attenuation film 1, attenuation of electromagnetic waves can be easily set with high flexibility. Accordingly, it is easy to provide a structure that can capture linearly polarized electromagnetic waves in the range of 15 GHz or more and 150 GHz or less.

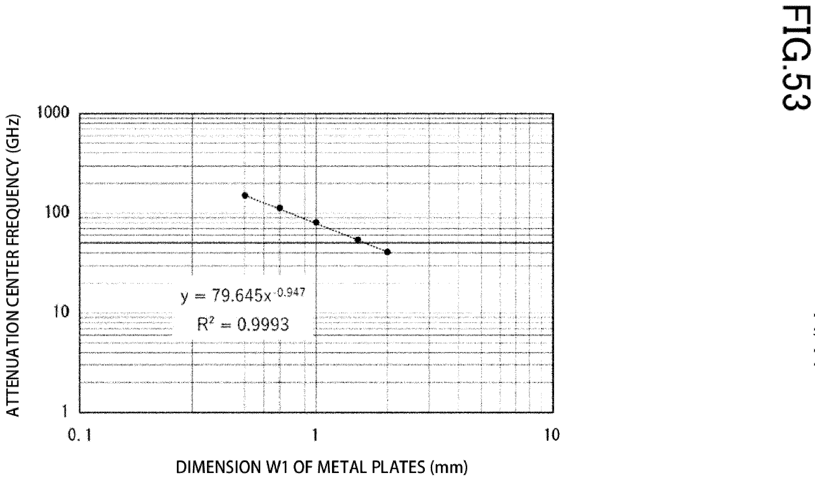

The non-travelling cyclic fluctuations of the electromagnetic field are considered to occur between the opposing sides of the metal plate in plan view. Accordingly, in order for the first mechanism to develop, sides with a predetermined length are preferred to face each other. Based on this and the studies of the present inventors, the sections each having the width W1 of 0.25 mm or more in the thin-film conductive layer can be provided with metal plates. If metal plates can have several widths W1, the maximum value of them can be defined to be the width W1 of the metal plates. With the width W1 in the range of around 0.25 mm to 4 mm, electromagnetic waves in the range of 15 GHz or more and 150 GHz or less can be attenuated. As shown in Fig. 53, the relationship between the frequency of attenuated electromagnetic waves and the width of the metal plates can be expressed as a straight line on a graph in which they are plotted logarithmically. In other words, the frequency of attenuation electromagnetic waves is a power function of the width of the metal plates. The power of the function is approximately -1 and substantially inversely proportional.

The plurality of metal plates in the thin-film conductive layer can be of several types with different dimensions W1. In this case, the electromagnetic wave attenuation peaks of these metal plates are overlapped to broaden the range of the electromagnetic waves that can be attenuated.

The second mechanism is confinement of electromagnetic fields by the thin-film conductive layer 30 portions and the planar inductor 50. In the electromagnetic wave attenuation film 1, the dielectric substrate 10 is sandwiched between the thin-film conductive layer 30 portions and the inductor 50 in the individual first regions 121. Therefore, the electrical field generated in the dielectric substrate 10 of the electromagnetic wave attenuation film 1 due to electromagnetic waves is confined in the dielectric substrate 10 between each thin-film conductive layer 30 portion including the corresponding metal plate and the inductor 50 due to the charge and current in the metal plate. Specifically, each metal plate suppresses the electromagnetic field and confines the electromagnetic field in the dielectric substrate 10. More specifically, the metal plate functions as a choke. In other words, the metal plate can be a choke plate functioning as a choke.

Magnetic flux is also considered to be induced in each first region by the cyclic fluctuations of the confined electrical field. Thus, oscillating electromagnetic fields accumulate in the first regions and increase the energy density of the electromagnetic fields. In general, as the energy density increases, attenuation is likely to progress accordingly and, therefore, electromagnetic waves are efficiently attenuated by this mechanism. In the second mechanism, as the dielectric substrate 10 has a higher dielectric loss tangent, the energy loss of the electromagnetic fields accumulated in the dielectric substrate becomes larger. The magnetic fields accumulated in the dielectric substrate accompany a large current in the metal plates, and the electrical fields accumulated in the dielectric substrate produce a large potential difference. Power loss, which is a product of the large current and the large potential difference, can increase power loss. The energy of the electromagnetic waves can be consumed as a power loss, resultantly attenuating the electromagnetic waves.

The third mechanism is a power loss in electrical circuits including capacitors, which are formed by the thin-film conductive layer 30 portions and the inductor 50 facing these portions and the dielectric substrate 10 located therebetween. In the electromagnetic wave attenuation film 1, the dielectric substrate 10 is sandwiched between the thin-film conductive layer 30 portions and the inductor 50 in the individual first regions 121 and in the second region 122. Therefore, the first regions 121, the second region 122, and the dielectric substrate 10 function as capacitors. Accordingly, electromagnetic waves incident on the dielectric substrate 10 of the electromagnetic wave attenuation film 1 are attenuated by the electrical circuits including the capacitors.

As the capacitance of the capacitors increases, stored charge increases accordingly to increase energy to be stored. Therefore, the higher the capacitance is, the higher is the energy that can be handled.

Capacitance is inversely proportional to the thickness of the dielectric substrate 10 and, from this perspective, it is more preferable that the dielectric substrate 10 has a smaller thickness. Since the distance between each thin-film conductive layer 30 portion and the planar inductor 50 is determined by the thickness of the dielectric substrate 10, the resistance therebetween is proportional to the thickness of the dielectric substrate 10. If the resistance of the dielectric substrate 10 is small, leakage current increases in the dielectric substrate 10, which increases the current passing through the electrical circuits of the thin-film conductive layer 30 portions and the planar inductor 50 including the capacitors. Therefore, power loss due to the leakage current easily increases, and the energy of the electromagnetic waves can be easily absorbed using the power loss. In the electromagnetic wave attenuation film 1 according to the embodiment of the present invention, the wavelength of the attenuation electromagnetic fields does not shift even when the thickness of the dielectric substrate 10 is changed in portions where the metal plates are arranged and, therefore, the thickness of the dielectric substrate 10 can be designed according to the characteristics of the electrical circuits including the capacitors.

As described above, electromagnetic waves incident on the electromagnetic wave attenuation film 1 generate electromagnetic fields in the dielectric substrate 10 near the surface of the planar inductor through the first mechanism, and the electromagnetic fields generated by the electromagnetic waves are confined and captured through the second mechanism. Thus, the electromagnetic wave attenuation film 1 is capable of capturing electromagnetic waves. The captured electromagnetic waves are attenuated due to the electrical field loss and power loss through the second mechanism, and due to the power loss by the electrical circuits through the third mechanism. Furthermore, provision of the top coat layer 200 can achieve impedance matching with the air through which electromagnetic waves are propagative and can effectively attenuate electromagnetic waves for the thin-film conductive layer. As shown in Fig. 53, the wavelength of the attenuated electromagnetic waves can be changed by changing the dimension W1 of the metal plates. More specifically, as shown in Fig. 53, the frequency that minimizes the reflected waves, i.e., the frequency that maximizes attenuation, shows extremely high proximity to a power of the size of the metal plates. Therefore, in the electromagnetic wave attenuation film 1, electromagnetic wave attenuation characteristics can be easily determined with high flexibility. Accordingly, the characteristics can be easily determined so as to capture electromagnetic waves with linear, circular, or elliptical polarization in the range of 15 GHz or more and 150 GHz or less.

In the simulation shown in Fig. 53, the metal plates have a square shape and W1 represents the length of one side.

The dielectric substrate of the electromagnetic wave attenuation film 1 of the first embodiment includes the first regions 121 and the second region 122, with at least part of the side surfaces 122a of the second region 122 exposed without being covered with the thin-film conductive layer 30. As a result, locations at which electromagnetic waves can be incident can be easily increased without increasing the area of the electromagnetic wave attenuation film in plan view to thereby efficiently capture and attenuate electromagnetic waves.

In the electromagnetic wave attenuation film 1 of the first embodiment, the thin-film conductive layer 30 serving as a support cage in the second region 122 can improve attenuation of electromagnetic waves by mainly enhancing the second and third mechanisms.

Furthermore, according to the studies made by the present inventors, the electrical fields are enhanced in the peripheries of the metal plates and, therefore, electrical potential is considered to be produced in the support cage near the peripheries.

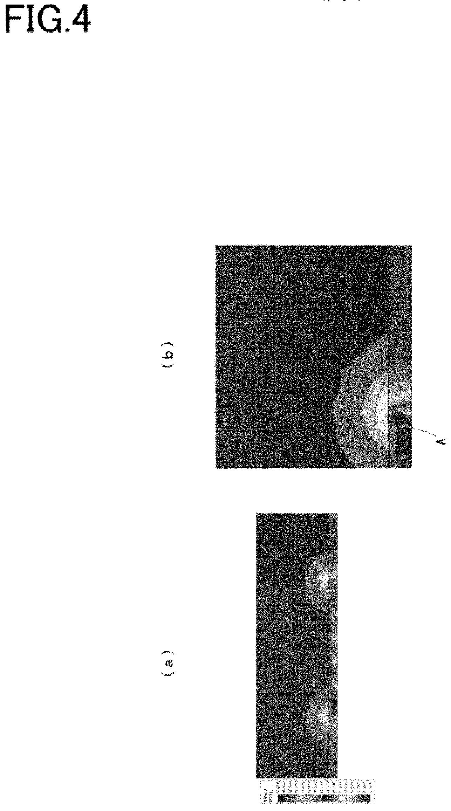

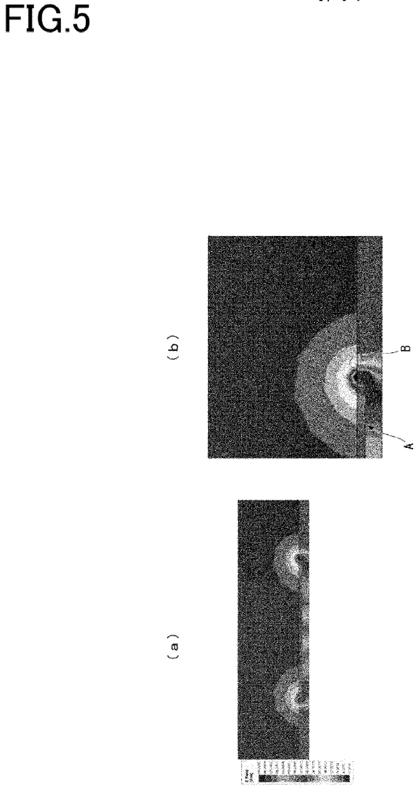

Fig. 4 shows a simulation of electrical field strength with no support cage provided, and Fig. 5 shows a simulation of electrical field strength with a support cage provided. In Figs. 4 and 5, the periphery of a metal plate in (a) is enlarged in (b) where the reference sign A represents the metal plate and the reference sign B represents the support cage.

From comparison between Figs. 4(b) and 5(b), it is understood that the electrical field strength is larger in the periphery of the metal plate of Fig. 5(b). Specifically, the electrical potential produced in the support cage is considered to contribute to further increasing the power loss in the first mechanism.

The role of the third mechanism is also important in the electromagnetic wave attenuation film 1. If electrical fields are generated in the dielectric substrate 10, electromagnetic fields are confined below the metal plates. In other words, electromagnetic fields with high energy density are generated below the metal plates. The confined electromagnetic fields are considered to be attenuated due to the power loss through the second mechanism, and due to the dielectric loss through the third mechanism.

According to the studies made by the present inventors, it has been found that attenuation through the first mechanism varies due to admittance (reciprocal of electrical resistance) of the metal forming the metal plates. Good electromagnetic wave attenuation was achieved with an admittance (siemens/m) of 10,000,000 or more. Silver is known as a substance with the highest admittance among normal conductors. Since the admittance of silver is 61 to $66 \times 10^6$, the upper limit thereof is approximately 70,000,000. Metals whose admittance is 5,000,000 or more and 70,000,000 or less can be used. Metals forming the metal plates can be ferromagnetic materials, paramagnetic materials, diamagnetic materials, and antiferromagnetic materials. Examples of the ferromagnetic metal include nickel, cobalt, iron, and alloys thereof. Examples of the paramagnetic metal include aluminum, tin ($\beta$-tin), and alloys thereof. Examples of the diamagnetic metal include gold, silver, copper, tin ($\alpha$-tin), zinc, and alloys thereof. Examples of the diamagnetic alloys include brass that is an alloy of copper and zinc. Examples of the antiferromagnetic metal include chromium. Good electromagnetic wave attenuation was shown by the metal plates of these metals.

On the other hand, in the present invention, the surfaces of the metal plates may be oxidized, nitrided or oxynitrided. The oxidized metal or nitrided metal on the surfaces of the metal plates can be formed by a surface treatment. The surface treatment can be a chemical treatment using chemicals, heat treatment, or both. The metal plates may each include a metal oxide film or may include a layer that is a mixture of a metal and a metal oxide With this configuration, resistance of the metal plates increases and voltage drop increases to increase power loss and improve attenuation of electromagnetic waves.

Metal plates 30A may each be a multilayer film in which films of different materials are laminated. The materials of the laminated films can be conductors or insulators.

An example of the procedure of producing an electromagnetic wave attenuation film 1 will be described.

First, a dielectric substrate 10 is formed. A resin for forming asperities is arranged in layers on a carrier 11, and first regions and a second region are formed on the surface to complete a dielectric substrate 10 having a primer layer 12. The resin for forming the primer layer 12 can be a photosensitive resin. In this case, photolithography can be used. The photosensitive resin can be a negative or positive resist. The primer layer 12 can also be formed using a photocurable resin. The primer layer 12 can also be formed using a thermoplastic resin. In this case, thermal transfer can be used. The primer layer 12 can also be formed using a thermosetting resin. The resin may be a soluble resin (oil-based ink) soluble in solvents. The resin may be a water-soluble resin (waterbased ink).

Next, a thin-film conductive layer 30 and a planar inductor 50 are formed respectively on the front surface 10a and the rear surface 10b of the dielectric substrate 10. The thin-film conductive layer 30 and the planar inductor 50 can be formed using physical deposition. The physical deposition can be vapor deposition or sputtering. Either the thin-film conductive layer 30 or the planar inductor 50 may be formed first and the materials of the both may be different from each other. The planar inductor 50 can be any of a cast metal, a rolled metal plate, metal foil, deposited film, sputtered film, and plating. The cast metal can be cast iron or an aluminum alloy. The rolled metal plate can be made of steel, stainless steel, aluminum, or aluminum alloys. The plating can be electroplating or electroless plating. The plating can be copper plating, electroless nickel plating, electrolytic nickel plating, zinc plating, electrolytic chromium plating, or laminates thereof.

It is important that, in the thin-film conductive layer 30, the metal plates and other parts are not continuous. If they are continuous, the width W1 mentioned above may vary and, therefore, attenuation of electromagnetic waves may be different from what has been expected. Therefore, a step of removing the thin-film conductive layer 30 portions formed on the side surfaces of the second region may be added. Laser etching or the like can be utilized for this step.

If a top coat layer 200 is provided, the coating method is not particularly limited and may be appropriately selected from methods used for producing films. Examples of the coating method include gravure coating, reverse coating, gravure reverse coating, die coating, flow coating, and the like.

In the production procedure described above, the carrier 11 may be separated after forming the primer layer 12. With this procedure, a monolayer dielectric substrate formed of only a primer layer 12 can be obtained.

As another example of the production procedure, after forming the thin-film conductive layer 30 and the planar inductor 50 on the dielectric substrate, asperities may be formed on the thin-film conductive layer 30. In this case, transfer using a plate is preferred. If thermal transfer is performed, the thin-film conductive layer 30 is heated with the plate pressed against it.

In this production procedure, the thin-film conductive layer 30 pressed by the plate may tend to stretch, bringing about a state in which metal plates and other parts are continuous. As a method of eliminating this occurrence, a method of devising the plate shape may be used other than the above method using laser etching. For example, the perimeters of the convexities in the plate for forming the first regions may be sharply formed, so that the perimeters of the metal plates are cut when the thin-film conductive layer 30 is pressed against the plate. This can secure the state in which the metal plates and other parts are not continuous during transfer.

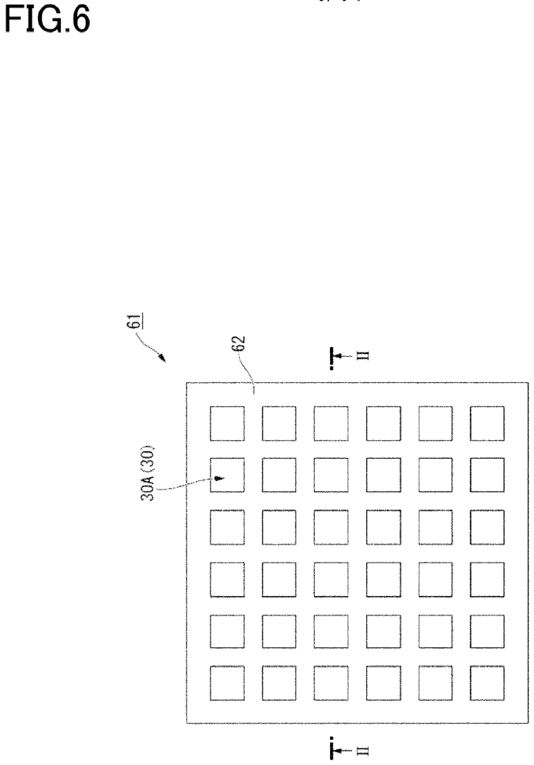

Referring to Figs. 6 to 9, a second embodiment of the present invention will be described. In the following description, like reference signs designate common parts already described to omit duplicate description. In the second embodiment, the first, second and third mechanisms described above are also considered to occur.

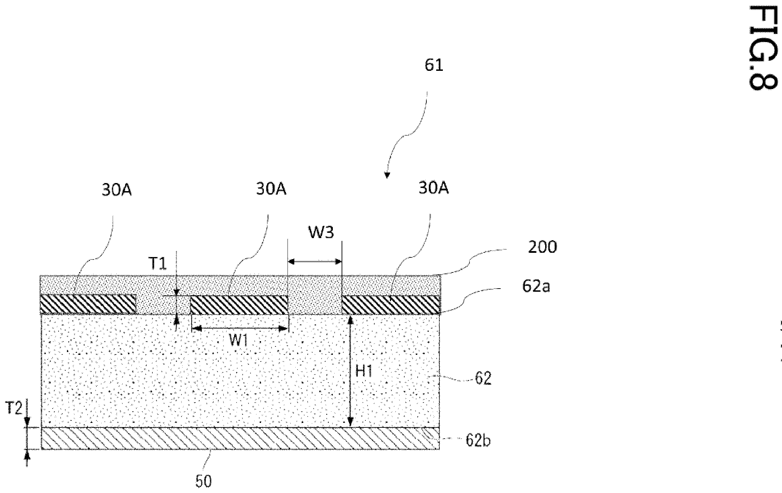

Figs. 6 and 7 show an electromagnetic wave attenuation film 61 according to the second embodiment. Fig. 6 is a schematic plan view illustrating the electromagnetic wave attenuation film of the second embodiment, and Fig. 7 is a schematic diagram illustrating a part of a cross section taken along the line II-II of Fig. 6. Fig. 8 is a schematic diagram illustrating the part of a cross section taken along the line II-II of Fig. 6, with a top coat layer provided.

The electromagnetic wave attenuation film 61 includes a dielectric substrate 62, a plurality of metal plates 30A, and a planar inductor 50. The metal plates 30A have a thickness of 1,000 nm or less.

The dielectric substrate 62 of the second embodiment can use the same materials and structures as in the dielectric substrate of the first embodiment. The dielectric substrate 62 may have a structure in which a primer layer is provided on a carrier 11 or a structure which is formed of only a carrier 11. A front surface 62a and a rear surface 62b may each be planar or roughened. The rear surface 62b is provided with the planar inductor 50, and an adhesive layer may further be provided therebetween. The adhesive layer and the planar inductor 50 can be formed using the same materials and production methods as in the first embodiment. A plurality of metal plates 30A are arranged on the front surface 62a. The metal plates 30A can be formed using a deposition method, followed by etching. The deposition method can be physical or chemical deposition. Physical deposition is suitable for forming the metal plates. The physical deposition can be vacuum vapor deposition or sputtering. Vacuum vapor deposition is preferred due to having high productivity. The metal plates can be formed by printing a mask layer in a metal-plate pattern, followed by etching away the extra thin-film conductive layer portions. The etchant used for the etching can be a sodium hydroxide solution. The sodium hydroxide solution can have a concentration of 0.001 mol/L or more and 1 mol/L or less. Metals that can be used for the metal plates 30A can be the same as in the first embodiment. The metal plates are discretely arranged. The attenuation center frequency can be expressed as a power function of the width of the metal plates. The plurality of metal plates 30A may have a constant shape and size and may be arranged at regular intervals. In other words, two or more metal plates 30A with a constant shape and size may be arranged at regular intervals. Specifically, not the entire front surface 62a is covered with a metal layer, but the dielectric substrate 62 is exposed at locations at which the metal plates 30A are not arranged.

Furthermore, a plurality of metal plates 30A with different shapes and/or sizes, including a plurality of plates 30A that are different to others and having a constant shape and size, may be arranged. In other words, a plurality of metal plates with different shapes and/or sizes may be arranged, and a plurality of metal plates having a constant shape and size may be arranged. The metal plates can be arranged at regular intervals in a fixed orientation. Alternatively, the intervals may be different from each other and the orientations may be different from each other. Alternatively, the intervals may be different from each other but the orientations may be the same. Alternatively, the intervals may be partly regular and the orientations may be partly the same. Furthermore, a plurality of metal plates with different shapes and/or sizes may be arranged as a metal plate set. All or part of the arrangement intervals of the metal plate set may be fixed, or all of the intervals thereof may be different. All or part of the orientations of the metal plate set may be fixed, or all of the orientations thereof may be different. In a metal plate set including metal plates of different shapes and/or sizes with different spectra of attenuation frequencies, a plurality of frequency ranges can be attenuated, or the attenuation frequency range can be broadened. If the arrangement intervals of the metal plates are different from each other, the spectra of attenuation frequencies can also be different from each other. If the orientations are different from each other in the metal plate set, dependency of attenuation wave polarization can be made different between the plates. The plurality of metal plates forming the metal plate set may have different attenuation frequencies, and the frequency difference may be regular.

A plurality of metal plate sets may be arranged. A plurality of metal plate sets may be arranged and, between these sets, the shape, size and arrangement of the metal plates are identical. With the thin-film conductive layer including a plurality of different metal plates, frequency range can be broadened, electromagnetic waves of a plurality of frequencies can be attenuated, or both of these can be achieved.

Each metal plate may be divided into a plurality of metal segments. In other words, the metal plate may be formed of a plurality of metal segments. The plurality of metal segments in the metal plate may be electrically connected to each other. The plurality of metal segments in the metal plate may be electrically connected to each other using wiring. The wiring may have an impedance. This impedance may be matched to that of the metal segments. The wiring and the plurality of metal segments in the metal plate may function cooperatively. The plurality of metal segments may be different in properties from the case where they are individually present. Specifically, the resonant frequency or attenuation may be different between the case where the metal segments are individually present and the case where they form a metal plate. The metal plate may have a cross-sectional shape that is flat, polyhedral or curved. If it is polyhedral or curved, the distance between the bottom and the top, i.e., the height can be 50 $\mu$m or less. The ratio between the height and the distance between the opposing sides of the metal plate can be 1:100 or more and 1:10 or less.

As in the first embodiment, attenuation due to the electromagnetic wave attenuation film of the second embodiment can be determined by changing the width W 1 of the metal plates. Thus, it is easy to determine attenuation so as to capture linearly polarized electromagnetic waves in the range of 15 GHz or more and 150 GHz or less.

Furthermore, since a plastic film carrier 11 can be directly used as a dielectric substrate 62, the electromagnetic wave attenuation film of the second embodiment can be produced more easily than in the first embodiment.

A carrier having roughness in part or all of the front and rear surfaces 62a and 62b can be used as a dielectric substrate 62. With the front surface 62a partly or entirely roughened, admittance of the metal plates 30A can be controlled.

In the conventional art including PTL 5, it has been considered that a sufficient alternating current can be generated in a resonance layer by making the resonating conductor thicker than the skin depth, and that electromagnetic waves can be attenuated by the power loss of the alternating current. However, the present inventors have found that if the thickness of the metal plates 30A is not more than the skin depth, attenuation of electromagnetic waves rather is enhanced.

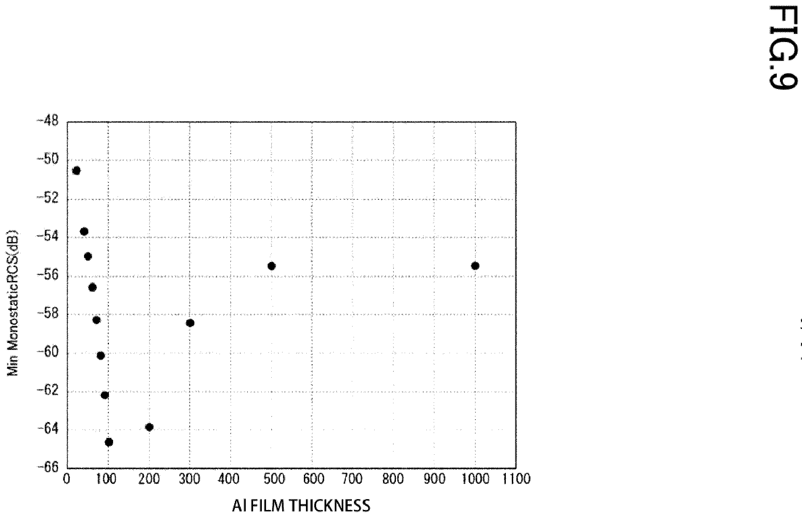

Fig. 9 is a graph showing an attenuation simulation of electromagnetic waves by varying the thickness of the metal plates 30A. The material of the metal plates is aluminum. The incident waves are linearly polarized sine waves vertically incident on the electromagnetic wave attenuation film. In the simulation, the planar inductor is a perfect conductor. Attenuation of electromagnetic waves as an electromagnetic wave attenuation film is expressed as a monostatic RCS based on the case of a planar inductor only. The vertical axis indicating attenuation of electromagnetic waves is expressed in decibels. The monostatic RCS (radar cross-section) is an index expressing the ease of detecting a target with a monostatic radar, and can be calculated through the following Formula 1. A monostatic radar performs transmission and reception at the same location.

[Math. 1]

$$\sigma = \lim_{R \to \infty} 4\pi R^2 \frac{|E_r|^2}{|E_i|^2} \quad \cdots (1)$$

where,

|Er|: Incident electrical field intensity
|Ei|: Received/scattered electrical field intensity
R: Distance between target and radar

As a result of simulation, as shown in Fig. 9, electromagnetic waves were greatly attenuated when the thickness was 40 nm or more and 400 nm or less. If the thickness was less than 40 nm, electromagnetic wave attenuation was reduced.

If the metal plates 30A include conductive layer portions and cladding, the film can be stably formed as long as the thickness of the metal plates 30A together with the conductive layer portions and cladding is 1,000 nm or less.

The phenomenon shown in Fig. 9 has an interesting relationship with the skin depth. The skin depth of aluminum at a frequency of 41 GHz is approximately 400 nm. Specifically, if the thickness of the metal plates becomes not more than the skin depth of the material, electromagnetic wave attenuation increases. If the thickness is less than $1/e^2$ of the skin depth, attenuation of the electromagnetic waves decreases. This is considered to be because, if the conductive layer is thicker than the skin depth, sufficient resistance is not achieved and thus voltage drop required for power loss cannot be achieved, and because current is concentrated only in the vicinity of the centers of the metal plates and thus current is reduced in the regions where potential difference occurs. On the other hand, if the thickness of the conductive layer is not more than the skin depth, it is also considered that sufficient current is not obtained for power loss if the thickness is less than $1/e^2$ of the skin depth. As a matter of course, power loss is given as the product of current and voltage. Specifically, sufficient electromagnetic wave attenuation can be achieved if the range of the following LN function Formula 2 is satisfied, which is expressed using the natural logarithm of the value obtained by normalizing a thickness T of the metal plates by a skin depth d.

$$-2 \leq \ln(T/d) \leq 0 \quad \text{... (2)}$$

If a metal having a low admittance is used for the metal plates, electromagnetic wave attenuation can be achieved even in the range of the following Formula 3. If the area ratio of the metal plates to the front surface of the dielectric substrate is large, electromagnetic wave attenuation can be achieved even in the range of the following Formula 3. The area ratio of the metal plates to the front surface of the dielectric substrate can be regarded to be large if it is 50% or more and 90% or less.

$$0 < \ln(T/d) \leq 1 \quad \text{... (3)}$$

Based on Formulas 1 and 2, electromagnetic wave attenuation can be achieved in the range of the following Formula 4.

$$-2 \leq \ln(T/d) \leq 1 \quad \text{... (4)}$$

In the embodiments of the present invention, the skin depth can be calculated using the attenuation center frequency f. Specifically, if the attenuation center frequency f is used, the skin depth d can be calculated through Formula 5 as already known.

[Math. 2]

$$d = \sqrt{\frac{2\rho}{\omega\mu}} \quad \text{... (5)}$$

where,

$\rho$: Electrical resistivity of metal plates
$\omega$: Angular frequency of current = $2\pi \times$ attenuation center frequency f
$\mu$: Absolute magnetic permeability of metal plates

According to the simulation, attenuation was enhanced when the thickness of the metal plates was smaller than the skin depth. This is considered to be because the current produced in the metal plates due to the magnetic flux in the dielectric substrate also reached the opposite surface of the dielectric substrate, and the current caused emission of electromagnetic waves having a phase deviated by $\pi$ from the reflected waves of the dielectric inductor causing cancellation of these reflected waves. Also, it is considered to be because, as the metal plate thickness became smaller than the skin depth, the current of the metal plates was regulated, as a result of which magnetic fields were generated not only in the vicinity of the centers of the metal plates but also across the metal plates, the current induced by the generated magnetic fields was also produced across the metal plates, and emission of electromagnetic waves cancelling the reflected waves of the dielectric inductor increased which further attenuated the reflected waves.

The electrical fields of the dielectric substrate between the metal plates and the dielectric inductor attract the metal plates and the dielectric inductor. If the electrical fields cyclically fluctuate, the force that attracts the metal plates also cyclically fluctuates. Therefore, the electrical fields of the dielectric substrate between the metal plates and the dielectric inductor oscillate the metal plates. The energy of the oscillation is converted to heat and lost. Therefore, the mechanics of the electromagnetic fields acting on the metal plates is also considered to contribute to electromagnetic wave attenuation.

If the non-travelling cyclical fluctuations of the electromagnetic fields are regarded as quanta, the quanta can be considered to be constrained and trapped in the electromagnetic fields and in a zero momentum state. In addition, the thickness of the metal plates that is at the level of several hundred nm is also considered to have a probability of affecting the energy level in the metal plates.

Thus, the phenomena in the embodiments of the present invention can be interpreted not only by classical electromagnetism but also by classical mechanics or quantum mechanics.

Therefore, if Formula 4 is interpreted, although its range is reasonably defined, the range is not necessarily strictly calculated considering all physical phenomena. Accordingly, when determining whether a target product is in the range of the formula, it can be said that it is appropriate to interpret the formula considering the physical phenomena manifested.

In the conventional art, examples of using conductors having a thickness of about the skin depth to less than the skin depth cannot be usually found. Therefore, the embodiments of the present invention are considered to be different from the conventional art in the mechanism of the interaction with electromagnetic waves in millimeter-wave bands.

For specific frequency ranges, the relationship between the metal plate thickness and the skin thickness showing preferred electromagnetic wave attenuation will be described in detail in the examples of the second embodiment provided later.

The embodiments of the present invention will be further described using examples.

(Examples of first embodiment)

First, a master plate for nickel electrocasting was prepared. A resist pattern was formed on the surface of the silicon wafer using photolithography. The photoresist used was a positive type and the thickness of the photoresist was 10 $\mu$m. The resist pattern formed was a pattern in which square openings were arranged in a square area with a side of 14 cm, at coordinates forming a constant-period square lattice array in an X-Y coordinate system, and the area exposed to the i-line was the inner area of the square.

Furthermore, electrocasting was performed using the master plate to obtain a nickel mold having a pattern in which square convexities in plan view were regularly arranged on the surface.

Next, a UV curable resin was dripped onto the patterned surface of the nickel mold, and a PET film that had undergone adhesion enhancement treatment on one surface was placed on the UV curable resin with the adhesion-enhancement surface facing the resin. The UV curable resin was evenly spread over the patterned surface using a roller, and UV light was applied to the surface via the transparent PET film to cure the UV curable resin.

The PET film was released from the nickel mold to obtain a dielectric part formed of an uneven layer of the UV curable resin and the PET film.

Using vacuum vapor deposition, an Al film was formed with a thickness of 500 nm on each of the both surfaces of the dielectric substrate to provide a thin-film conductive layer and a planar inductor.

The above is the production procedure in the examples of the first embodiment. Through this procedure, a plurality of nickel molds with the parameters of the uneven layer surfaces varied were produced to provide electromagnetic wave attenuation films of Examples 1 to 3.

The electromagnetic wave attenuation films of the examples all had a thickness of about 60 $\mu$m and a weight of about 0.02 g and thus were thin and light.

(Modifications with top coat layer provided to examples of first embodiment)

Top coat layers 200 produced through the following procedure were provided to the respective examples of the first embodiment to prepare electromagnetic wave attenuation films.

An acrylic resin composition that was a mixture of 80 parts by mass of methyl methacrylate monomer and 20 parts by mass of cyclohexyl methacrylate was prepared as a main component, and 6 parts by mass of hydroxyphenyltriazine UV absorber (ADK STAB LA-46 manufactured by ADEKA Corp.), 6 parts by mass of hydroxyphenyltriazine UV absorber with a different composition (Tinuvin 479 manufactured by Ciba Specialty Chemicals Corp.), 3 parts by mass of benzotriazole UV absorber (Tinuvin 329 manufactured by Ciba Specialty Chemicals Corp.), and 5 parts by mass of hindered amine radical scavenger (Tinuvin 292 manufactured by Ciba Specialty Chemicals Corp.) were added to the acrylic resin composition, with respect to 100 parts by mass of the solid content of the composition, followed by further mixing thereto a base resin solution with a solid content of 33 parts by mass to which an ethyl acetate solvent was added for solid content control and a hexamethylene diisocyanate-type curing agent solution with a solid content of 75 parts by mass to which an ethyl acetate solvent was added for solid content control so that the ratio of the base resin solution to the curing agent solution was 10:1 (in this case, the ratio of the number of hydroxyl groups in the base resin solution to the number of isocyanate groups in the curing agent solution was 1:2), further adding methyl acetate as the solvent component to prepare a coating liquid with the solid content controlled to 20 parts by mass, and this coating liquid was applied so that the thickness after solvent volatilization was 6 $\mu$m, thereby obtaining a top coat layer 200. The prepared electromagnetic wave attenuation films of the examples all had a thickness of about 70 $\mu$m and a weight of about 0.02 g and thus were thin and light.

(Examples of second embodiment)

[27 GHz to 34 GHz]

(Example 1A)

For the general theory described for Formula 4, a range of the Relational Formula ln(T/d) of the thickness T and the skin depth d of the metal plates showing preferred electromagnetic wave attenuation could be found in specific frequency ranges in the millimeter-wave bands, and this will be described below.

Simulations conducted for the range of 27 GHz to 34 GHz will be described. As a dielectric substrate, a PET film having a thickness (H1) of 50 $\mu$m was prepared and metal plates as thin-film conductive layer portions were provided to one surface thereof at regular intervals in both of the X and Y coordinates. A planar aluminum inductor having a thickness (T2) of about 2 mm was provided to the other surface of the dielectric substrate, and simulations were conducted.

The simulations were conducted for the frequencies of 27 GHz, 28 GHz, 31 GHz and 34 GHz for individual metal species in terms of the relationship between electromagnetic wave attenuation and ln(T1/d).

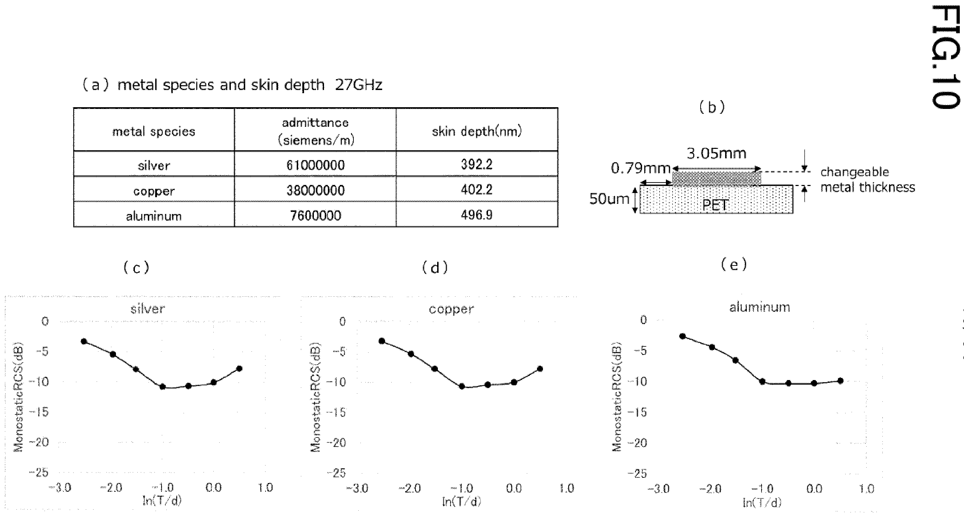

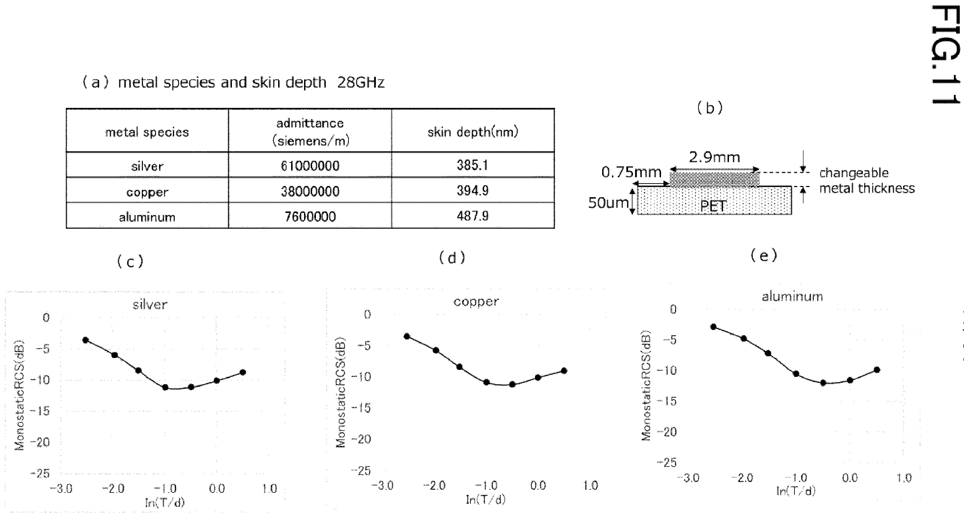

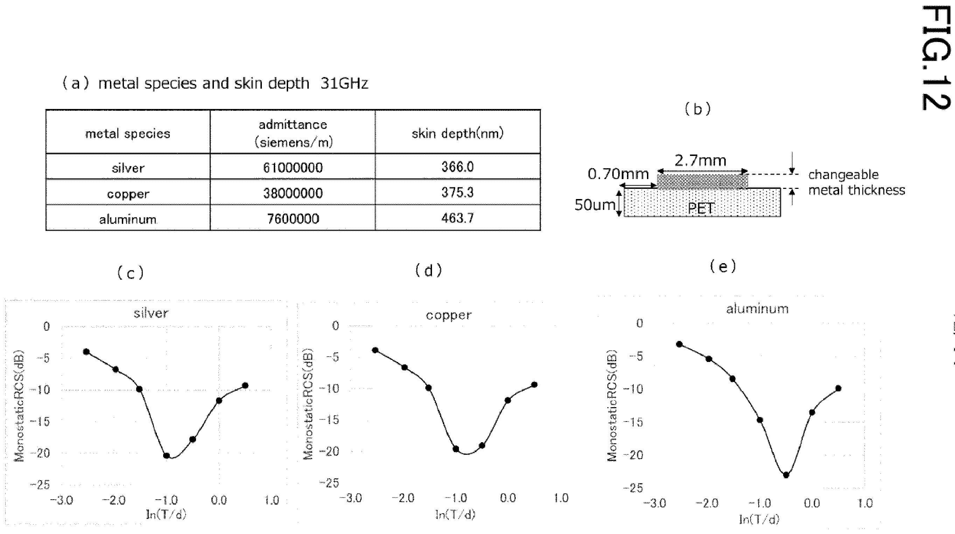

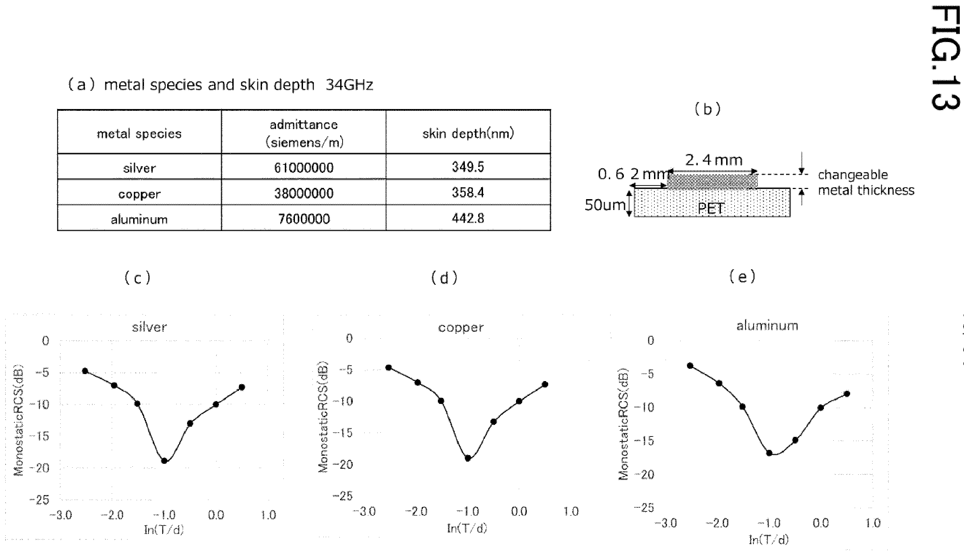

The results of the simulations will be described referring to Tables 1 and 2 and Figs. 10 to 13. Fig. 10 is a set of diagrams showing electromagnetic wave attenuation characteristics at 27 GHz in Example 1A. Fig. 11 is a set of diagrams showing electromagnetic wave attenuation characteristics at 28 GHz in Example 1A. Fig. 12 is a set of diagrams showing electromagnetic wave attenuation characteristics at 31 GHz in Example 1A. Fig. 13 is a set of diagrams showing electromagnetic wave attenuation characteristics at 34 GHz in Example 1A. In Figs. 10 to 13, (a) shows values of admittance and skin depth, (b) shows the structure of the electromagnetic wave attenuation film, and (c) to (e) are graphs showing attenuation characteristics of silver, copper and aluminum. The graphs show correlations between natural logarithms of values plotted on the horizontal axes obtained by normalizing the thickness T1 of the metal plates by the skin depth d thereof, and amounts of attenuation in the patterned metal plates plotted on the vertical axes, with the reflection amount of the metal plates having the same area as that of the dielectric substrate defined to be 100 (reflectance).

[Table 1]

| | | 27 GHz | | | | 28 GHz | | | |
|---|---|---|---|---|---|---|---|---|---|
| | Mul | Skn D (nm) | Fil Thk (nm) | LN (Fil Thk / Skn D | Abs | Skn D (nm) | Fil Thk (nm) | LN (Fil Thk / Skn D | Abs |
| Silver | 1.65 | 392.2 | 647.1 | 0.5 | -7.8 | 385.1 | 635.4 | 0.5 | -8.8 |
| | 1 | | 392.2 | 0.0 | -10.1 | | 385.1 | 0.0 | -10.1 |
| | 0.61 | | 239.2 | -0.5 | -10.7 | | 234.9 | -0.5 | -11.1 |
| | 0.37 | | 145.1 | -1.0 | -10.8 | | 142.5 | -1.0 | -11.2 |
| | 0.22 | | 86.3 | -1.5 | -8.0 | | 84.7 | -1.5 | -8.5 |
| | 0.14 | | 54.9 | -2.0 | -5.5 | | 53.9 | -2.0 | -6.0 |
| | 0.08 | | 31.4 | -2.5 | -3.3 | | 30.8 | -2.5 | -3.6 |
| Copper | 1.65 | 402.2 | 663.6 | 0.5 | -7.8 | 394.9 | 651.6 | 0.5 | -9.0 |
| | 1 | | 402.2 | 0.0 | -10.0 | | 394.9 | 0.0 | -10.1 |
| | 0.61 | | 245.3 | -0.5 | -10.4 | | 240.9 | -0.5 | -11.2 |
| | 0.37 | | 148.8 | -1.0 | -10.7 | | 146.1 | -1.0 | -10.9 |
| | 0.22 | | 88.5 | -1.5 | -7.8 | | 86.9 | -1.5 | -8.4 |
| | 0.14 | | 56.3 | -2.0 | -5.4 | | 55.3 | -2.0 | -5.8 |
| | 0.08 | | 32.2 | -2.5 | -3.2 | | 31.6 | -2.5 | -3.5 |
| Aluminum | 1.65 | 496.9 | 819.8 | 0.5 | -9.9 | 487.9 | 805.1 | 0.5 | -9.9 |
| | 1 | | 496.9 | 0.0 | -10.3 | | 487.9 | 0.0 | -11.6 |
| | 0.61 | | 303.1 | -0.5 | -10.3 | | 297.6 | -0.5 | -12.0 |
| | 0.37 | | 183.8 | -1.0 | -10.0 | | 180.5 | -1.0 | -10.6 |
| | 0.22 | | 109.3 | -1.5 | -6.5 | | 107.3 | -1.5 | -7.2 |
| | 0.14 | | 69.6 | -2.0 | -4.4 | | 68.3 | -2.0 | -4.8 |
| | 0.08 | | 39.7 | -2.5 | -2.6 | | 39.0 | -2.5 | -2.9 |

| 31 GHz | | | | 34 GHz | | | |
|---|---|---|---|---|---|---|---|
| Skn D (nm) | Fil Thk (nm) | LN (Fil Thk / Skn D | Abs | Skn D (nm) | Fil Thk (nm) | LN (Fil Thk / Skn D | Abs |
| 366.0 | 603.9 | 0.5 | -9.3 | 349.5 | 576.6 | 0.5 | -7.3 |
| | 366.0 | 0.0 | -11.7 | | 349.5 | 0.0 | -10.0 |
| | 223.3 | -0.5 | -17.8 | | 213.2 | -0.5 | -13.0 |
| | 135.4 | -1.0 | -20.4 | | 129.3 | -1.0 | -18.9 |
| | 80.5 | -1.5 | -9.9 | | 76.9 | -1.5 | -9.9 |
| | 51.2 | -2.0 | -6.8 | | 48.9 | -2.0 | -7.0 |
| | 29.3 | -2.5 | -4.0 | | 28.0 | -2.5 | -4.7 |
| 375.3 | 619.3 | 0.5 | -9.4 | 358.4 | 591.4 | 0.5 | -7.3 |
| | 375.3 | 0.0 | -11.9 | | 358.4 | 0.0 | -10.0 |
| | 229.0 | -0.5 | -19.1 | | 218.6 | -0.5 | -13.2 |
| | 138.9 | -1.0 | -19.6 | | 132.6 | -1.0 | -19.0 |
| | 82.6 | -1.5 | -9.9 | | 78.8 | -1.5 | -9.9 |
| | 52.5 | -2.0 | -6.6 | | 50.2 | -2.0 | -7.0 |
| | 30.0 | -2.5 | -3.9 | | 28.7 | -2.5 | -4.6 |
| 463.7 | 765.1 | 0.5 | -9.9 | 442.8 | 730.6 | 0.5 | -8.0 |
| | 463.7 | 0.0 | -13.5 | | 442.8 | 0.0 | -10.1 |
| | 282.9 | -0.5 | -23.0 | | 270.1 | -0.5 | -14.9 |
| | 171.6 | -1.0 | -14.7 | | 163.8 | -1.0 | -16.8 |
| | 102.0 | -1.5 | -8.4 | | 97.4 | -1.5 | -9.9 |
| | 64.9 | -2.0 | -5.4 | | 62.0 | -2.0 | -6.4 |
| | 37.1 | -2.5 | -3.2 | | 35.4 | -2.5 | -3.8 |

[Table 2]

|  | 27 GHz | 28 GHz | 31 GHz | 34 GHz |
|---|---|---|---|---|
| W1 (mm) | 3.05 | 2.9 | 2.7 | 2.4 |
| W3 (mm) | 1.57 | 1.49 | 1.39 | 1.24 |

As will be clear from Table 1 and Figs. 10 to 13, when 10 dB or more absorption by an electromagnetic wave attenuation film is used as an index of good attenuation, films satisfying $-1.0 \leq \ln(T1/d) \leq 0.0$ could achieve good attenuation in the frequency range of 27 GHz to 34 GHz.

Good attenuation characteristics of around 10 dB are not limited to those achieved by the numerical values of the parameters used in Example 1A, but can be expected to be achieved, as a matter of course, in the structures having some range of parameter values. For example, good attenuation characteristics of around 10 dB can be expected with a structure in which the metal plates have a width W1 of 2.4 mm to 3 mm, adjacent metal plates have a distance W3 therebetween of 1.2 mm to 1.5 mm, the dielectric substrate has a thickness H1 of 5 $\mu$m to 300 $\mu$m, and the planar inductor has a thickness T2 of 0.5 $\mu$m to 5 mm.

(Example 1B)

As in Example 1A, a dielectric substrate was prepared, including a PET film having a thickness (H1) of 50 $\mu$m, and metal plates as thin-film conductive layer portions provided on one surface of the PET film, with the ratio of the total area of the metal plates to the entire area of the dielectric substrate in the XY plane being changed. A planar aluminum inductor having a thickness (T2) of about 2 mm was provided to the other surface of the dielectric substrate, and simulations were conducted. The metal species used for the metal plates was aluminum, the metal plates had a width W1 of 2.9 mm and a thickness T1 of 297.6 nm, and the percentage of the metal area was changed by controlling the distance W3 between the metal plates.

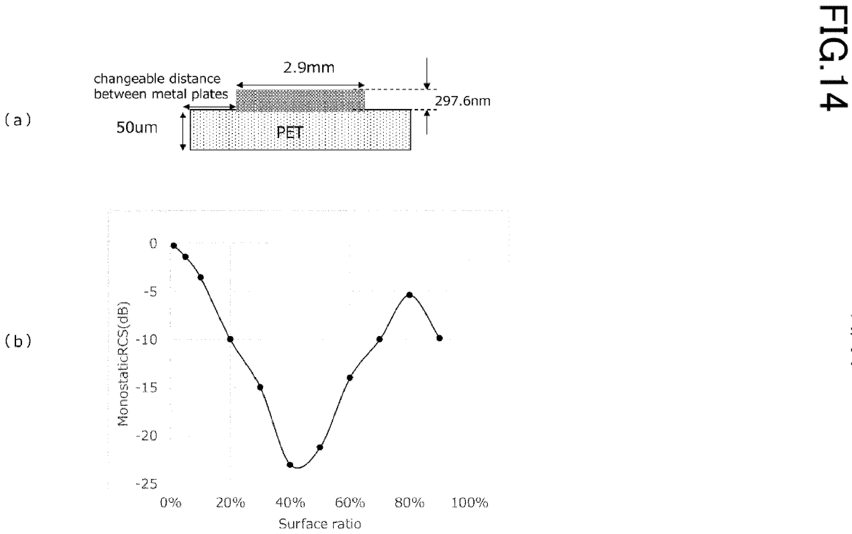

The results of the simulation will be described referring to Table 3 and Fig. 14. Fig. 14 is a set of diagrams showing electromagnetic wave attenuation characteristics at 28 GHz in Example 1B as a function of the percentage of the metal area. (a) shows the structure of the electromagnetic wave attenuation film, and (b) shows attenuation characteristics.

[Table 3]

| Metal area ratio | 1% | 5% | 10% | 20% | 30% | 40% | 50% | 60% | 70% | 80% | 90% |
|---|---|---|---|---|---|---|---|---|---|---|---|
| W3 (mm) | 26.10 | 10.07 | 6.27 | 3.58 | 2.39 | 1.69 | 1.20 | 0.84 | 0.57 | 0.34 | 0.16 |
| Abs | -0.3 | -1.4 | -3.5 | -10.0 | -15.0 | -23.0 | -21.2 | -14.0 | -10.0 | -5.4 | -9.9 |

As can be seen from Table 3 and Fig. 14, when 10 dB or more absorption by an electromagnetic wave attenuation film is used as an index of good attenuation, films in which the percentage of the metal area was 20% or more could achieve good attenuation in Example 1B.

(Example 1C)

As in Example 1A, a dielectric substrate was prepared, including a PET film having a thickness (H1) of 50 $\mu$m, metal plates as thin-film conductive layer portions arranged on one surface of the PET film with the same pattern array as shown in Fig. 6, with the shape of the metal plates changed to shapes other than square, and a planar aluminum inductor having a thickness (T2) of about 2mm provided to the other surface of the dielectric substrate, and simulations were conducted. The metal species used for the metal plates was aluminum, and the metal plates were designed to have a thickness T1 of 297.6 nm.

[Circular shape]

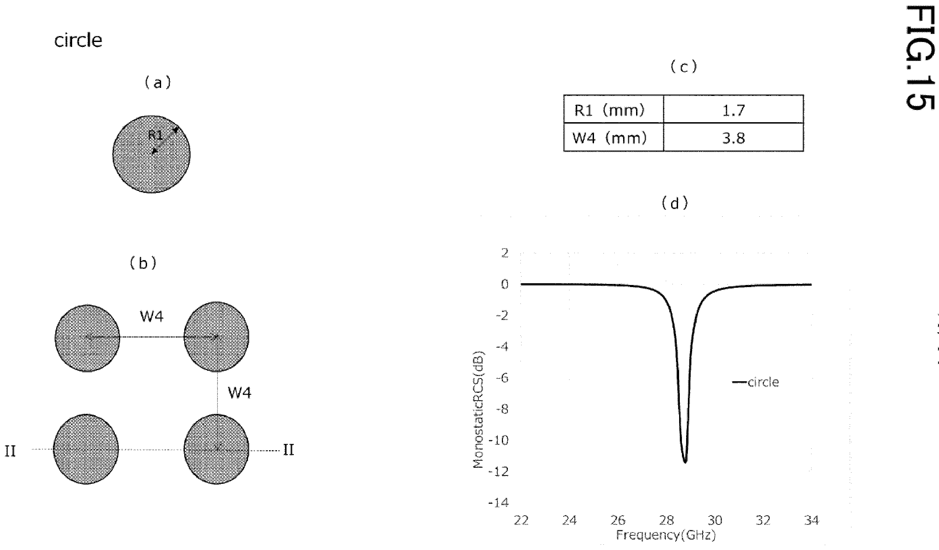

Fig. 15 is a set of diagrams showing electromagnetic wave attenuation characteristics when the metal plates have a circular shape in Example 1C. (a) shows the shape of the metal plates, in which R1 represents the radius of the circular shape. (b) is an enlarged view showing a part in the vicinity of the array pattern taken along the line II-II of Fig. 6, in which W4 represents the distance between the centers of the circular shapes. (c) shows dimensions of R1 and W4. (d) shows attenuation characteristics with frequencies plotted on the horizontal axis.

The simulation showed that good attenuation characteristics of 10dB or more absorption were achieved in the vicinity of 28.8 GHz.

[Rectangular shape]

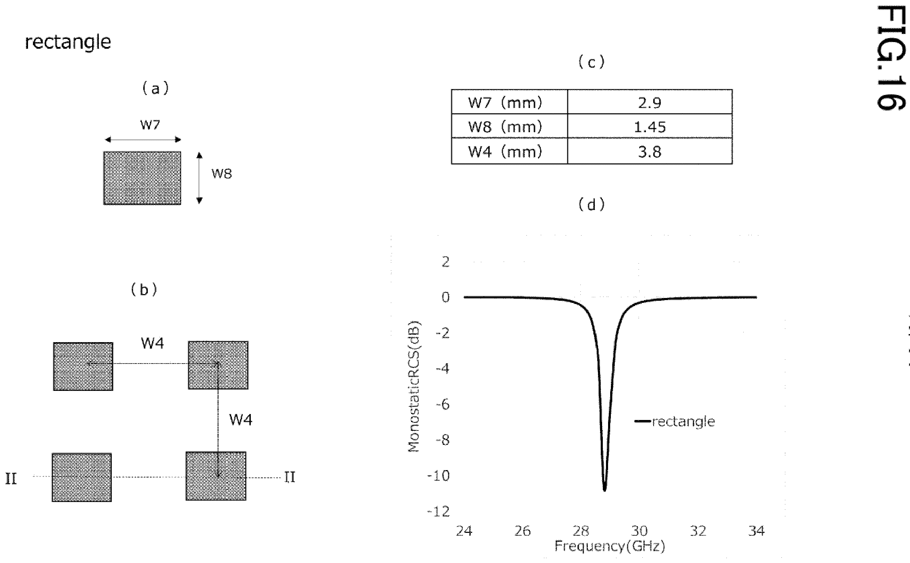

Fig. 16 is a set of diagrams showing electromagnetic wave attenuation characteristics when the metal plates have a rectangular shape in Example 1C. (a) shows the shape of the metal plates, in which W7 represents the length of the long side of the rectangular shape, and W8 represents the length of the short side thereof. (b) is an enlarged view showing a part in the vicinity of the array pattern taken along the line II-II of Fig. 6, in which W4 represents the distance between the centers of the rectangular shapes. (c) shows dimensions of W7 and W8. (d) shows attenuation characteristics with frequencies plotted on the horizontal axis.

The simulation showed that good attenuation characteristics of 10dB or more absorption were achieved in the vicinity of 28.8 GHz.

[Hexagonal shape]

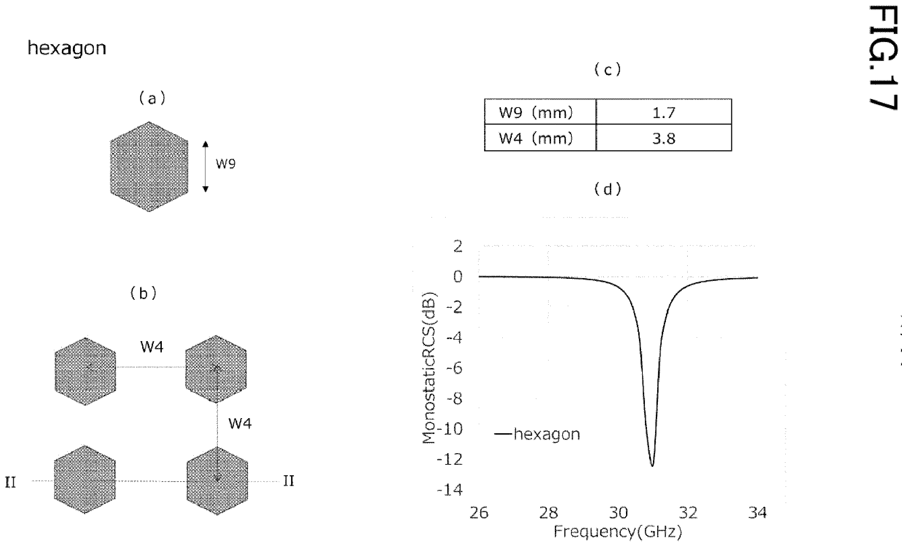

Fig. 17 is a set of diagrams showing electromagnetic wave attenuation characteristics when the metal plates have a hexagonal shape in Example 1C. (a) shows the shape of the metal plates, in which W9 represents the length of one side of the hexagonal shape. (b) is an enlarged view showing a part in the vicinity of the array pattern taken along the line II-II of Fig. 6, in which W4 represents the distance between the centers of the hexagonal shapes. (c) shows dimensions of W9 and W4. (d) shows attenuation characteristics with frequencies plotted on the horizontal axis.

The simulation showed that good attenuation characteristics of 10dB or more absorption were achieved in the vicinity of 31 GHz.

[Convex shape]

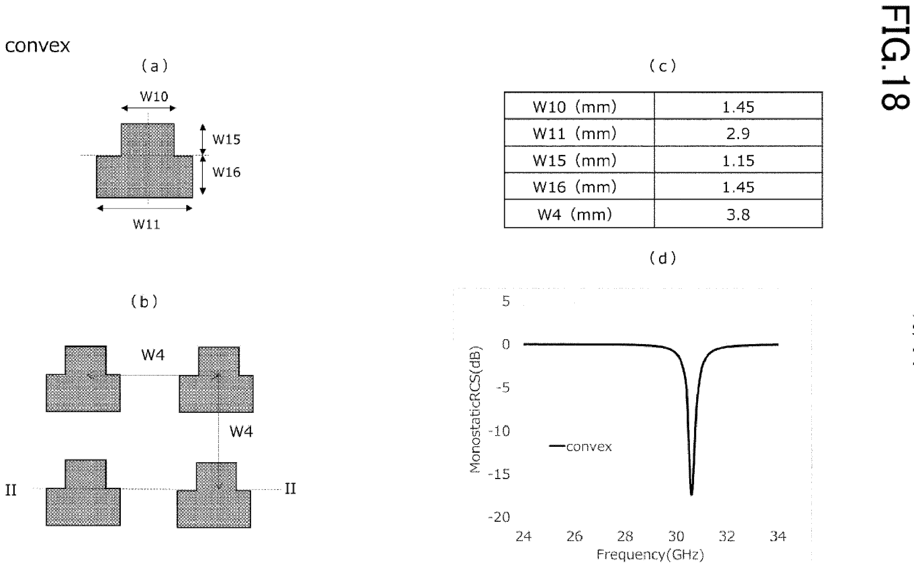

Fig. 18 is a set of diagrams showing electromagnetic wave attenuation characteristics when the metal plates have a convex shape in Example 1C. (a) shows the shape of the metal plates. W10 represents the length of the top of the protrusion in the upper part of the convex shape, W11 represents the length of the base in the lower part of the convex shape, W15 represents the height of the upper part, and W16 represents the height of the lower part. The convex shape is bilaterally symmetrical about the line connecting between the midpoints of the top and base of the upper and lower parts. The center of a rectangular shape contacting the base of the lower part, the lateral vertical sides of the lower part, and the top of the upper part, and enclosing the convex shape is regarded as the center of the convex shape. (b) is an enlarged view showing a part in the vicinity of the array pattern taken along the line II-II of Fig. 6, in which W4 represents the distance between the centers of the convex shapes. (c) shows dimensions of W10, W11, W15, W16 and W4. (d) shows attenuation characteristics with frequencies plotted on the horizontal axis.

The simulation showed that good attenuation characteristics of 10dB or more absorption were achieved in the vicinity of 30.6 GHz.

[Triangular shape]

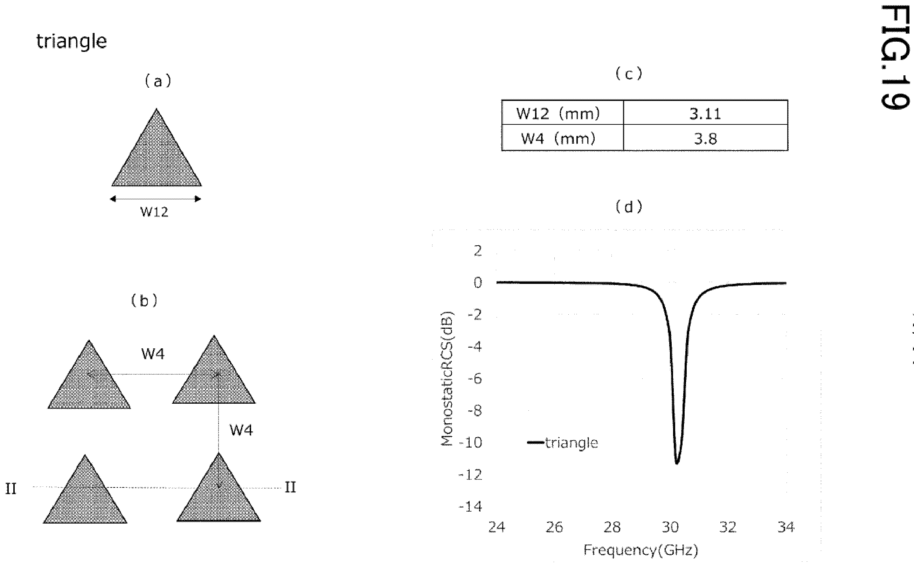

Fig. 19 is a set of diagrams showing electromagnetic wave attenuation characteristics when the metal plates have a triangular shape in Example 1C. (a) shows the shape of the metal plates, in which W12 represents the length of one side of the equilateral triangular shape. (b) is an enlarged view showing a part in the vicinity of the array pattern taken along the line II-II of Fig. 6, in which W4 represents the distance between the centers of the triangular shapes. (c) shows dimensions of W12 and W4. (d) shows attenuation characteristics with frequencies plotted on the horizontal axis.

The simulation showed that good attenuation characteristics of 10dB or more absorption were achieved in the vicinity of 30.2 GHz.

[Cross shape]

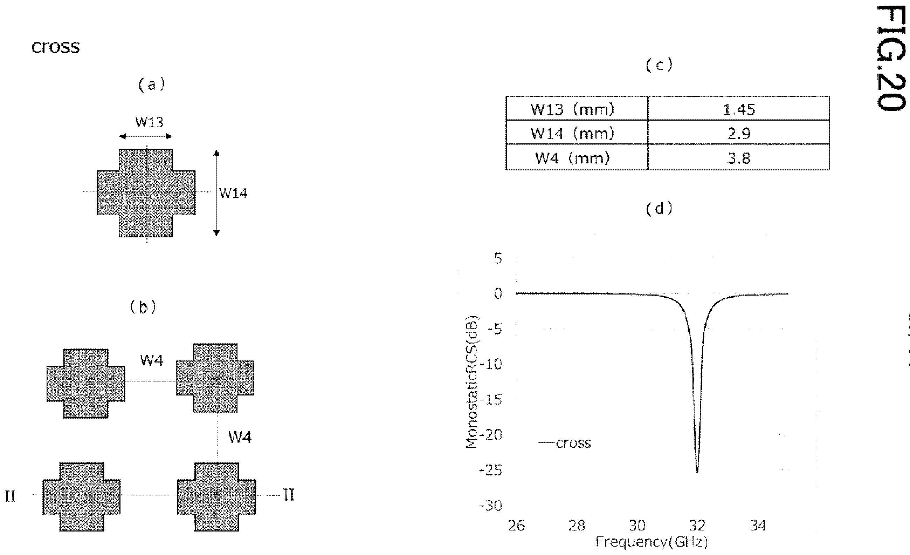

Fig. 20 is a set of diagrams showing electromagnetic wave attenuation characteristics when the metal plates have a cross shape in Example 1C. (a) shows the shape of the metal plates. The cross shape is vertically and horizontally symmetrical and is also symmetrical with respect to rotation of 90 degrees. W13 represents the length of the outer sides of the cross shape facing each other on the top and bottom, and on the left and right, and W14 represents the length of one side of a square contacting the outer sides facing each other on the top and bottom, and on the left and right. The center of the square is regarded as the center of the cross shape. (b) is an enlarged view showing a part in the vicinity of the array pattern taken along the line II-II of Fig. 6, in which W4 represents the distance between the centers of the cross shapes. (c) shows dimensions of W13, W14 and W4. (d) shows attenuation characteristics with frequencies plotted on the horizontal axis.

The simulation showed that good attenuation characteristics of 10dB or more absorption were achieved in the vicinity of 32 GHz.

(Example 1D)

A square PET film with a thickness of 50 $\mu$m and a side of 14 cm was prepared as a dielectric substrate. A thin-film aluminum conductive layer having a thickness of 100 nm was formed over one entire surface of the dielectric substrate using vacuum vapor deposition. After that, the thin-film conductive layer was etched using a mask so that metal plates could be formed at regular intervals in both of the X and Y coordinates. A planar aluminum inductor was bonded to the other surface via an adhesive layer. Simulations were conducted for this structure.

The above is the production procedure in Example 1D of the second embodiment. The parameters of Example 1D were as follows.

Width W1 of metal plates: 2.236 mm to 3.481 mm; 16 different types of metal plates, which were obtained by dividing a metal layer into 16 parts every 0.083 mm with an equal width, were arranged in a 4 $\times$ 4 matrix with even intervals of 0.1 mm therebetween in the same orientation to provide a metal plate set. A plurality of such metal plate sets were arranged in the same orientation with intervals of 0.1 mm therebetween. These metal plate sets were all identical. Specifically, the metal plates forming each metal plate set were not different between the metal plate sets.

Distance W3 between adjacent metal plates: 0.1 mm
Thickness T1 of metal plate: 297.6 nm
Thickness T2 of planar inductor: about 2 mm
Thickness H1 of dielectric substrate: 50 $\mu$m

To examine the suitability of the attenuation mechanism resulting from the experiments, simulations were conducted using this structure.

The electromagnetic wave attenuation films of the examples without including planar inductors all had a thickness of about 60 $\mu$m and a weight of about 0.02 g and thus were thin and light. Accordingly, these films can be easily attached to parts that are desired to be prevented from being affected by radiation noise due to electromagnetic waves or other parts in the housings of mobile phones, on-vehicle radar devices, and the like.

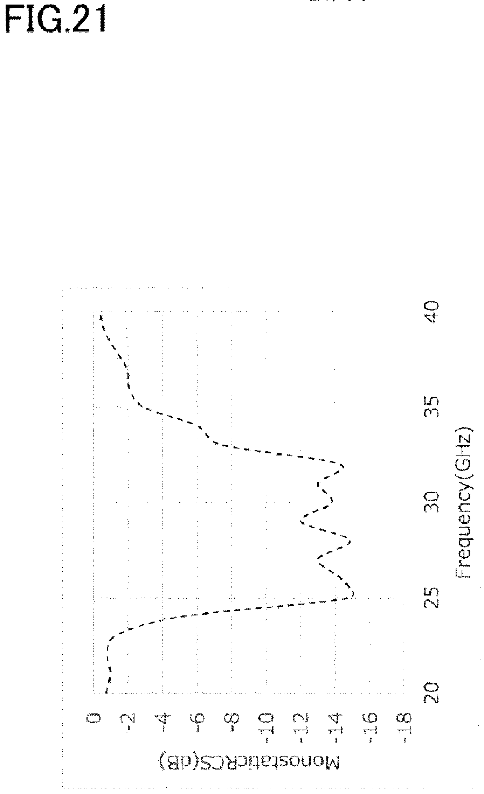

In the simulations, all of Examples 1A to 1D showed good attenuation for electromagnetic waves in the millimeter-wave bands. The results of the simulation of Example D1 are shown in Fig. 21.

(Modification with top coat layer provided to Example 1A of second embodiment)

In Example 1A of the second embodiment, an electromagnetic wave attenuation film was prepared using aluminum so that the metal plates had a thickness T1 of 298 nm, by providing a top coat layer 200 produced through the following procedure to the film.

An acrylic resin composition that was a mixture of 80 parts by mass of methyl methacrylate monomer and 20 parts by mass of cyclohexyl methacrylate was prepared as a main component, and 6 parts by mass of hydroxyphenyltriazine UV absorber (ADK STAB LA-46 manufactured by ADEKA Corp.), 6 parts by mass of hydroxyphenyltriazine UV absorber with a different composition (Tinuvin 479 manufactured by Ciba Specialty Chemicals Corp.), 3 parts by mass of benzotriazole UV absorber (Tinuvin 329 manufactured by Ciba Specialty Chemicals Corp.), and 5 parts by mass of hindered amine radical scavenger (Tinuvin 292 manufactured by Ciba Specialty Chemicals Corp.) were added to the acrylic resin composition, with respect to 100 parts by mass of the solid content of the composition, followed by further mixing thereto a base resin solution with a solid content of 33 parts by mass to which an ethyl acetate solvent was added for solid content control and a hexamethylene diisocyanate-type curing agent solution with a solid content of 75 parts by mass to which an ethyl acetate solvent was added for solid content control so that the ratio of the base resin solution to the curing agent solution was 10:1 (in this case, the ratio of the number of hydroxyl groups in the base resin solution to the number of isocyanate groups in the curing agent solution was 1:2), further adding methyl acetate as the solvent component to prepare a coating liquid with the solid content controlled to 20 parts by mass, and this coating liquid was applied so that the thickness after solvent volatilization was 6 $\mu$m, thereby obtaining a top coat layer 200. The thickness of the top coat layer was 6 $\mu$m.

(Comparative Example 1)

An electromagnetic wave attenuation film was prepared according to Example 1A without providing a top coat layer.

The electromagnetic wave attenuation films of the modification and Comparative Example 1 were pressure bonded to respective stainless steel plates and subjected to exposure equivalent to 10-year outdoor exposure using a sunshine weather meter. After that, the surfaces of the electromagnetic wave attenuation films were wiped off with a cotton cloth to examine the change in state of the top coat layers and the electromagnetic wave attenuation layers, and in monostatic RCS attenuation characteristics.

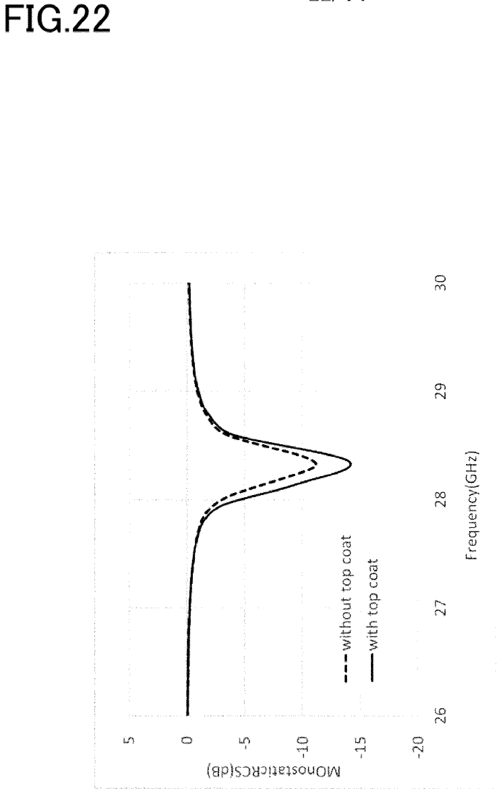

As a result, in the structure of the modification, neither the top coat layer nor the electromagnetic wave attenuation layer was deteriorated, impedance matching was achieved due to the formation of the top coat layer, and the monostatic RCS attenuation characteristics were improved as shown in Fig. 22.

[35 GHz to 50 GHz]

(Example 2A)

For the general theory described for Formula 4, a range of the Relational Formula ln(T/d) of the thickness T and the skin depth d of the metal plates showing preferred electromagnetic wave attenuation could be found in specific frequency ranges in the millimeter-wave bands, and this will be described below.

Simulations conducted for the range of 35 GHz to 50 GHz will be described. As a dielectric substrate, a PET film having a thickness (H1) of 50 $\mu$m was prepared and metal plates as thin-film conductive layer portions were provided to one surface thereof at regular intervals in both of the X and Y coordinates. A planar aluminum inductor having a thickness (T2) of about 2 mm was provided to the other surface of the dielectric substrate, and simulations were conducted.

Simulations were conducted for the frequencies of 35 GHz, 39 GHz, 41 GHz, 45 GHz and 50 GHz for individual metal species in terms of the relationship between electromagnetic wave attenuation and ln(T1/d).

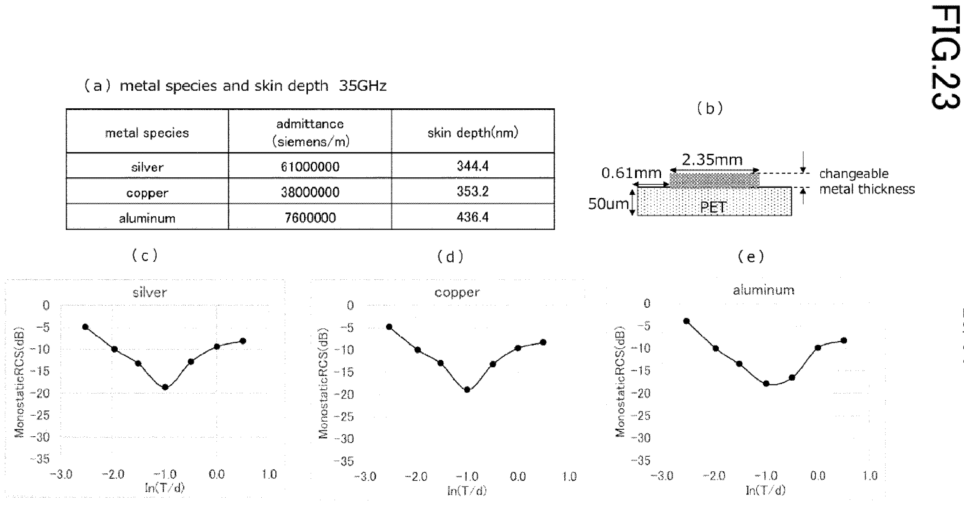

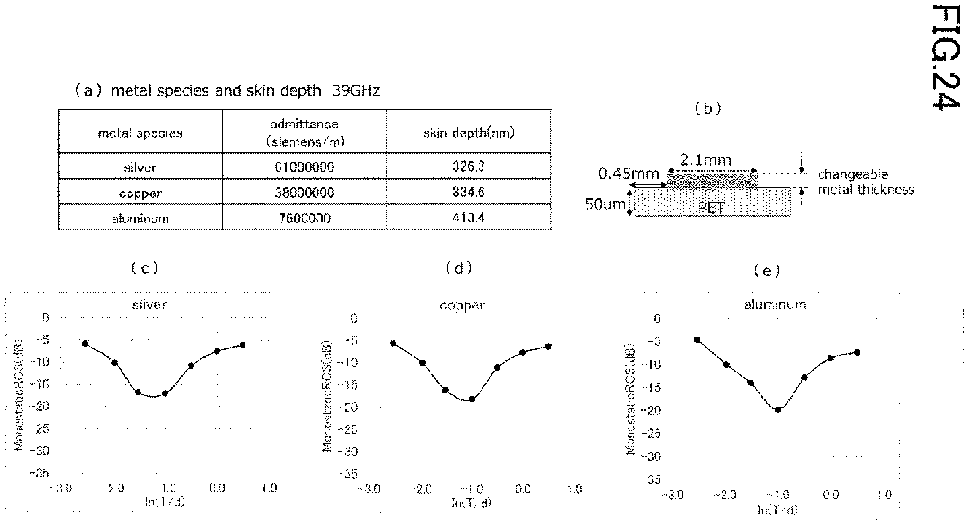

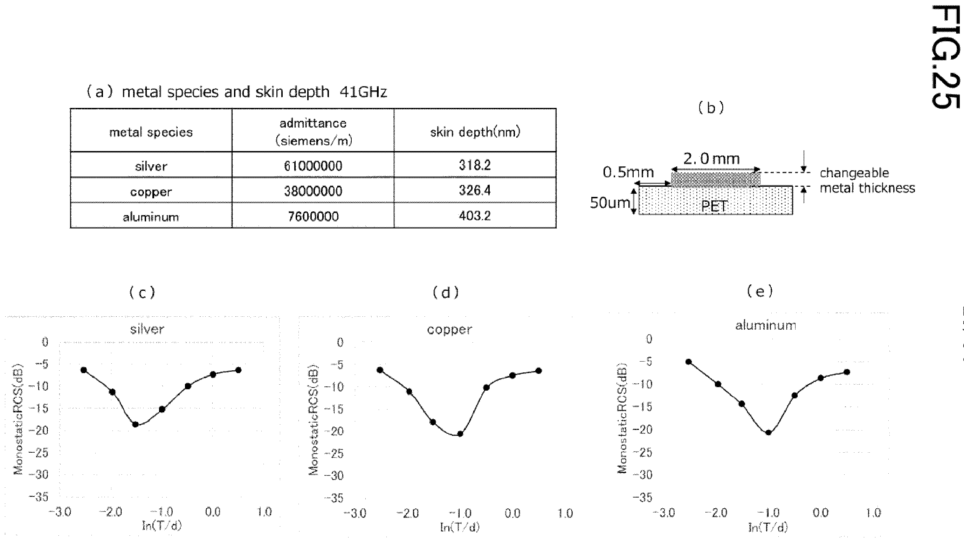

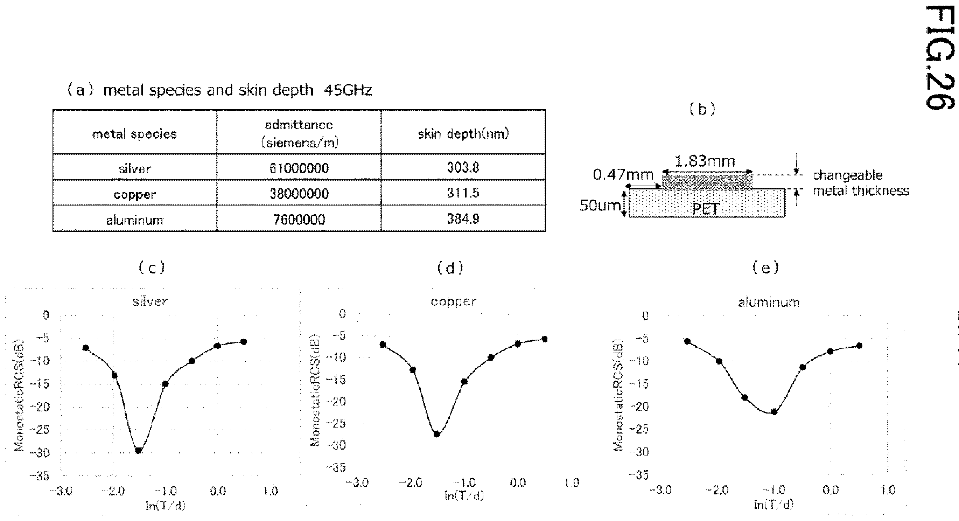

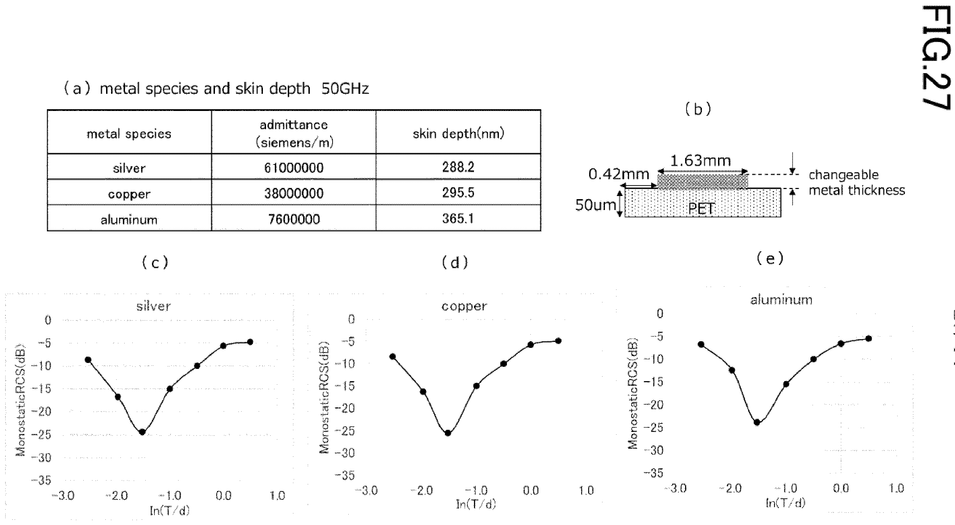

The results of the simulations will be described referring to Tables 4 and 5 and Figs. 23 to 27. Fig. 23 is a set of diagrams showing electromagnetic wave attenuation characteristics at 35 GHz in Example 2A. Fig. 24 is a set of diagrams showing electromagnetic wave attenuation characteristics at 39 GHz in Example 2A. Fig. 25 is a set of diagrams showing electromagnetic wave attenuation characteristics at 41 GHz in Example 2A. Fig. 26 is a set of diagrams showing electromagnetic wave attenuation characteristics at 45 GHz in Example 2A. Fig. 27 is a set of diagrams showing electromagnetic wave attenuation characteristics at 50 GHz in Example 2A. In Figs. 23 to 27, (a) shows values of admittance and skin depth, (b) shows the structure of the electromagnetic wave attenuation film, and (c) to (e) are graphs showing attenuation characteristics of silver, copper and aluminum. The graphs show correlations between natural logarithms of values plotted on the horizontal axes obtained by normalizing the thickness T1 of the metal plates by the skin depth d thereof, and amounts of attenuation in the patterned metal plates plotted on the vertical axes, with the reflection amount of the metal plates having the same area as that of the dielectric substrate defined to be 100 (reflectance).

[Table 4]

| | | | 35 GHz | | | | 39 GHz | | |
|---|---|---|---|---|---|---|---|---|---|
| | Mul | Skn D (nm) | Fil Thk (nm) | LN (Fil Thk / Skn D) | Abs | Skn D (nm) | Fil Thk (nm) | LN (Fil Thk / Skn D) | Abs |
| Silver | 1.65 | | 568.3 | 0.5 | -8.1 | | 603.9 | 0.5 | -6.2 |
| | 1 | | 344.4 | 0.0 | -9.4 | | 366.0 | 0.0 | -7.5 |
| | 0.61 | | 210.1 | -0.5 | -12.8 | | 223.3 | -0.5 | -10.8 |
| | 0.37 | 344.4 | 127.4 | -1.0 | -18.6 | 366.0 | 135.4 | -1.0 | -17.1 |
| | 0.22 | | 75.8 | -1.5 | -13.3 | | 80.5 | -1.5 | -16.8 |
| | 0.14 | | 48.2 | -2.0 | -10.0 | | 51.2 | -2.0 | -10.1 |
| | 0.08 | | 27.6 | -2.5 | -4.9 | | 29.3 | -2.5 | -5.8 |
| Copper | 1.65 | | 582.9 | 0.5 | -8.3 | | 552.2 | 0.5 | -6.3 |
| | 1 | | 353.2 | 0.0 | -9.6 | | 334.6 | 0.0 | -7.7 |
| | 0.61 | | 215.5 | -0.5 | -13.2 | | 204.1 | -0.5 | -11.1 |
| | 0.37 | 353.2 | 130.7 | -1.0 | -18.9 | 334.6 | 123.8 | -1.0 | -18.2 |
| | 0.22 | | 77.7 | -1.5 | -13.0 | | 73.6 | -1.5 | -16.1 |
| | 0.14 | | 49.5 | -2.0 | -10.0 | | 46.8 | -2.0 | -10.0 |
| | 0.08 | | 28.3 | -2.5 | -4.8 | | 26.8 | -2.5 | -5.7 |
| Aluminum | 1.65 | | 720.1 | 0.5 | -8.3 | | 682.1 | 0.5 | -7.3 |
| | 1 | | 436.4 | 0.0 | -9.9 | | 413.4 | 0.0 | -8.6 |
| | 0.61 | | 266.2 | -0.5 | -16.5 | | 252.2 | -0.5 | -12.8 |
| | 0.37 | 436.4 | 161.5 | -1.0 | -17.9 | 413.4 | 153.0 | -1.0 | -19.8 |
| | 0.22 | | 96.0 | -1.5 | -13.5 | | 91.0 | -1.5 | -14.0 |
| | 0.14 | | 61.1 | -2.0 | -10.0 | | 57.9 | -2.0 | -10.0 |
| | 0.08 | | 34.9 | -2.5 | -3.9 | | 33.1 | -2.5 | -4.6 |

| 41 GHz | | | | 45 GHz | | | | 50 GHz | | | |
|---|---|---|---|---|---|---|---|---|---|---|---|
| Skn D (nm) | Fil Thk (nm) | LN (Fil Thk / Skn D) | Abs | Skn D (nm) | Fil Thk (nm) | LN (Fil Thk / Skn D) | Abs | Skn D (nm) | Fil Thk (nm) | LN (Fil Thk / Skn D) | Abs |
| | 525.1 | 0.5 | -6.3 | | 501.2 | 0.5 | -5.7 | | 475.5 | 0.5 | -4.7 |
| | 318.2 | 0.0 | -7.3 | | 303.8 | 0.0 | -6.7 | | 288.2 | 0.0 | -5.6 |
| | 194.1 | -0.5 | -10.0 | | 185.3 | -0.5 | -10.0 | | 175.8 | -0.5 | -10.0 |
| 318.2 | 117.8 | -1.0 | -15.2 | 303.8 | 112.4 | -1.0 | -15.0 | 288.19 | 106.6 | -1.0 | -15.0 |
| | 70.0 | -1.5 | -18.6 | | 66.8 | -1.5 | -29.5 | | 63.4 | -1.5 | -24.4 |
| | 44.6 | -2.0 | -11.3 | | 42.5 | -2.0 | -13.2 | | 40.3 | -2.0 | -16.7 |
| | 25.5 | -2.5 | -6.4 | | 24.3 | -2.5 | -7.2 | | 23.1 | -2.5 | -8.6 |
| | 665.3 | 0.5 | -6.4 | | 635.0 | 0.5 | -5.8 | | 487.6 | 0.5 | -4.8 |
| | 403.2 | 0.0 | -7.4 | | 384.9 | 0.0 | -6.8 | | 295.5 | 0.0 | -5.7 |
| | 246.0 | -0.5 | -10.2 | | 234.8 | -0.5 | -10.0 | | 180.3 | -0.5 | -10.0 |
| 326.4 | 149.2 | -1.0 | -20.5 | 311.5 | 142.4 | -1.0 | 15.5 | 295.54 | 109.4 | -1.0 | -15.0 |
| | 88.7 | -1.5 | -17.9 | | 84.7 | -1.5 | -27.5 | | 65.0 | -1.5 | -25.5 |
| | 56.4 | -2.0 | -11.0 | | 53.9 | -2.0 | -12.8 | | 41.4 | -2.0 | -16.3 |
| | 32.3 | -2.5 | -6.2 | | 30.8 | -2.5 | -7.0 | | 23.6 | -2.5 | -8.4 |
| | 665.3 | 0.5 | -7.3 | | 635.0 | 0.5 | -6.5 | | 602.5 | 0.5 | -5.4 |
| | 403.2 | 0.0 | -8.7 | | 384.9 | 0.0 | -7.9 | | 365.1 | 0.0 | -6.5 |
| | 246.0 | -0.5 | -12.5 | | 234.8 | -0.5 | -11.4 | | 222.7 | -0.5 | -10.0 |
| 403.2 | 149.2 | -1.0 | -20.7 | 384.9 | 142.4 | -1.0 | -21.2 | 365.12 | 135.1 | -1.0 | -15.5 |
| | 88.7 | -1.5 | -14.4 | | 84.7 | -1.5 | -18.0 | | 80.3 | -1.5 | -23.9 |
| | 56.4 | -2.0 | -10.0 | | 53.9 | -2.0 | -10.1 | | 51.1 | -2.0 | -12.4 |
| | 32.3 | -2.5 | -5.1 | | 30.8 | -2.5 | -5.7 | | 29.2 | -2.5 | -6.7 |

[Table 5]

|  | 35 GHz | 39 GHz | 41 GHz | 45 GHz | 50 GHz |
|---|---|---|---|---|---|
| Metal dimension W1 | 2.35 | 2.1 | 2 | 1.83 | 1.63 |
| Inter-plate distance W3 | 1.21 | 1.08 | 1 | 0.94 | 0.84 |

As will be clear from Table 4 and Figs. 23 to 27, when 10 dB or more absorption by an electromagnetic wave attenuation film is used as an index of good attenuation, films satisfying -2.0 ≤ ln(T1/d) < -0.5 could achieve good attenuation in the frequency range of 35 GHz to 50 GHz.

Good attenuation characteristics of around 10 dB are not limited to those achieved by the numerical values of the parameters used in Example 2A, but can be expected to be achieved, as a matter of course, in structures having some range of parameter values. For example, good attenuation characteristics of around 10 dB can be expected with a structure in which the metal plates have a width W1 of 1.7 mm to 2.3 mm, adjacent metal plates have a distance W3 therebetween of 0.9 mm to 1.2 mm, the dielectric substrate has a thickness H1 of 5 $\mu$m to 300 $\mu$m, and the planar inductor has a thickness T2 of 0.5 $\mu$m to 5 mm.

(Example 2B)

As in Example 2A, a dielectric substrate was prepared, including a PET film having a thickness (H1) of 50 $\mu$m, and metal plates as thin-film conductive layer portions provided on one surface of the PET film, with the ratio of the total area of the metal plates to the entire area of the dielectric substrate in the XY plane being changed. A planar aluminum inductor having a thickness (T2) of about 2 mm was provided to the other surface of the dielectric substrate, and simulations were conducted. The metal species used for the metal plates was aluminum, the metal plates had a width W1 of 2.0 mm and a thickness T1 of 149.2 nm, and the percentage of the metal area was changed by controlling the distance W3 between the metal plates.

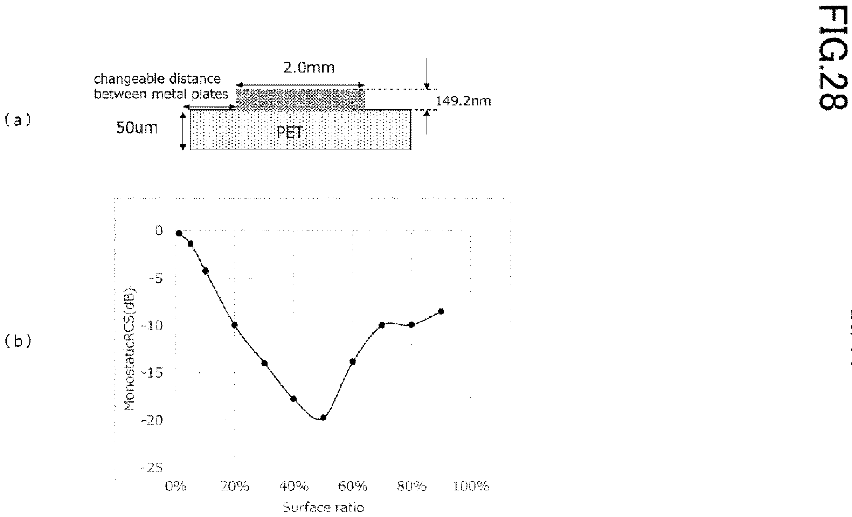

The results of the simulations will be described referring to Table 6 and Fig. 28. Fig. 28 is a set of diagrams showing electromagnetic wave attenuation characteristics at 39 GHz in Example 2B as a function of the percentage of metal area. (a) shows the structure of the electromagnetic wave attenuation film, and (b) shows attenuation characteristics.

[Table 6]

| Metal area ratio | 1% | 5% | 10% | 20% | 30% | 40% | 50% | 60% | 70% | 80% | 90% |
|---|---|---|---|---|---|---|---|---|---|---|---|
| W3 (mm) | 18.00 | 6.94 | 4.32 | 2.47 | 1.65 | 1.16 | 0.83 | 0.58 | 0.39 | 0.24 | 0.11 |
| Abs | -0.3 | -1.4 | -4.3 | -10.0 | -14.0 | -17.8 | -19.8 | -13.8 | -10.0 | -10.0 | -8.5 |

As can be seen from Table 6 and Fig. 28, when 10 dB or more absorption by an electromagnetic wave attenuation film is used as an index of good attenuation, films in which the percentage of the metal area was 20% or more could achieve good attenuation in Example 2B.

(Example 2C)

As in Example 2A, a dielectric substrate was prepared, including a PET film having a thickness (H1) of 50 $\mu$m, metal plates as thin-film conductive layer portions arranged on one surface of the PET film with the same pattern array as shown in Fig. 6, with the shape of the metal plates changed to shapes other than square, and a planar aluminum inductor having a thickness (T2) of about 2mm provided to the other surface of the dielectric substrate, and simulations were conducted. The metal species used for the metal plates was aluminum, and the metal plates were designed to have a thickness T1 of 149 nm.

[Circular shape]

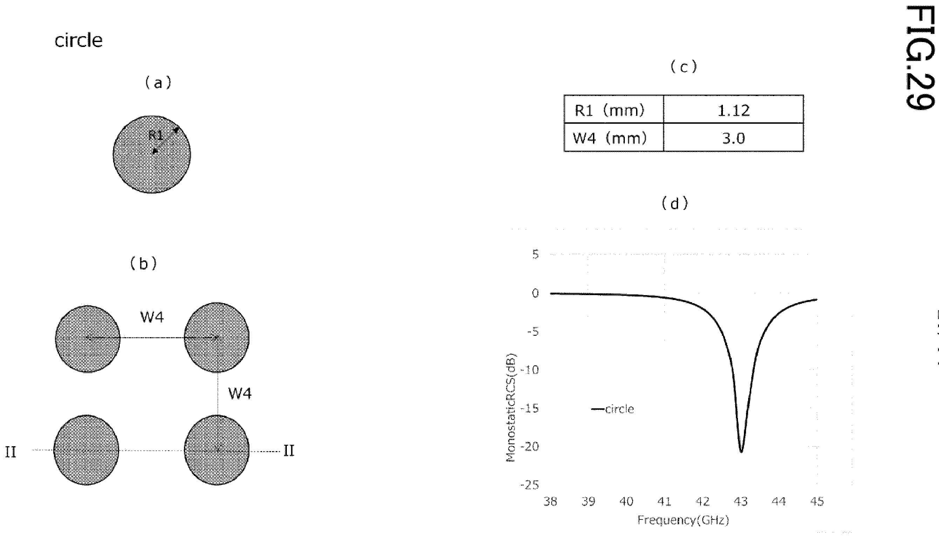

Fig. 29 is a set of diagrams showing electromagnetic wave attenuation characteristics when the metal plates have a circular shape in Example 2C. (a) shows the shape of the metal plates, in which R1 represents the radius of the circular shape. (b) is an enlarged view showing a part in the vicinity of the array pattern taken along the line II-II of Fig. 6, in which W4 represents the distance between the centers of the circular shapes. (c) shows dimensions of R1 and W4. (d) shows attenuation characteristics with frequencies plotted on the horizontal axis.

The simulation showed that good attenuation characteristics of 10dB or more absorption were achieved in the vicinity of 43 GHz.

[Rectangular shape]

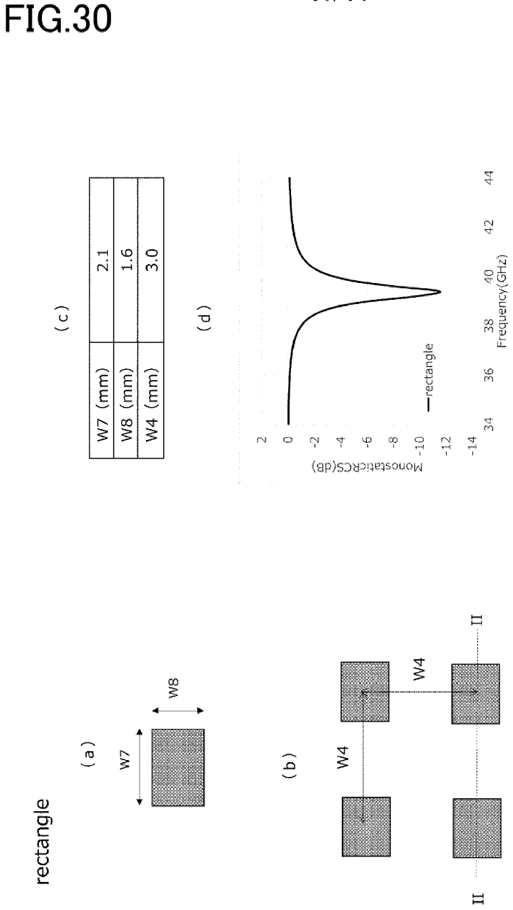

Fig. 30 is a set of diagrams showing electromagnetic wave attenuation characteristics when the metal plates have a rectangular shape in Example 2C. (a) shows the shape of the metal plates, in which W7 represents the length of the long side of the rectangular shape, and W8 represents the length of the short side thereof. (b) is an enlarged view showing a part in the vicinity of the array pattern taken along the line II-II of Fig. 6, in which W4 represents the distance between the centers of the rectangular shapes. (c) shows dimensions of W7 and W8. (d) shows attenuation characteristics with frequencies plotted on the horizontal axis.
The simulation showed that good attenuation characteristics of 10dB or more absorption were achieved in the vicinity of 39.4 GHz.

[Hexagonal shape]

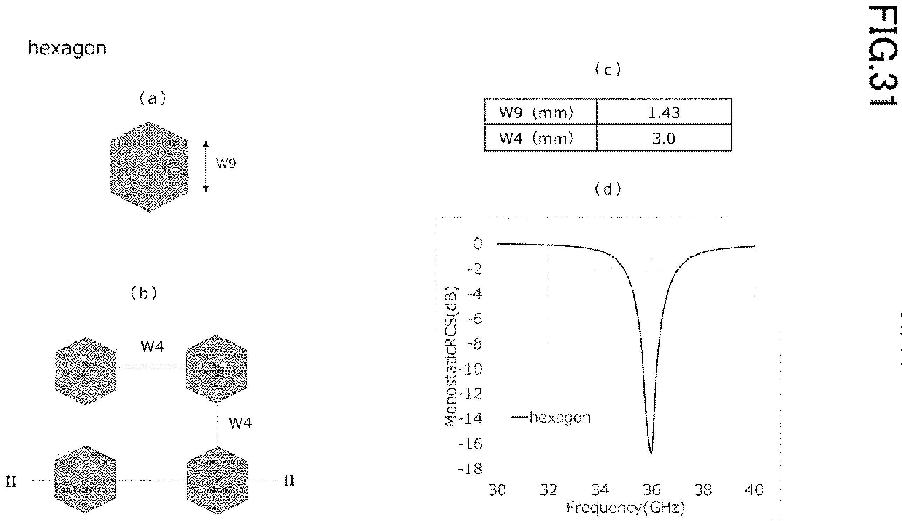

Fig. 31 is a set of diagrams showing electromagnetic wave attenuation characteristics when the metal plates have a hexagonal shape in Example 2C. (a) shows the shape of the metal plates, in which W9 represents the length of one side of the hexagonal shape. (b) is an enlarged view showing a part in the vicinity of the array pattern taken along the line II-II of Fig. 6, in which W4 represents the distance between the centers of the hexagonal shapes. (c) shows dimensions of W9 and W4. (d) shows attenuation characteristics with frequencies plotted on the horizontal axis.
The simulation showed that good attenuation characteristics of 10dB or more absorption were achieved in the vicinity of 36 GHz.

[Convex shape]

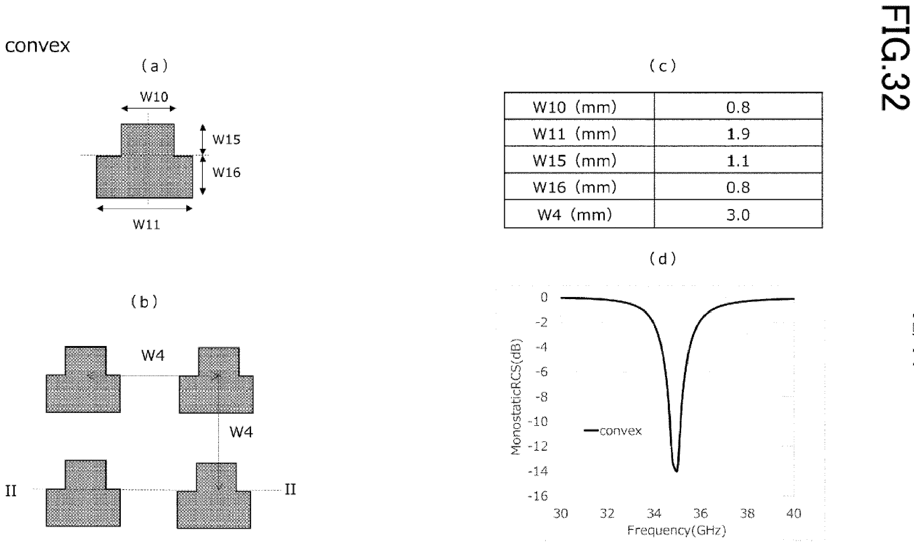

Fig. 32 is a set of diagrams showing electromagnetic wave attenuation characteristics when the metal plates have a convex shape in Example 2C. (a) shows the shape of the metal plates. W10 represents the length of the top of the protrusion in the upper part of the convex shape, W11 represents the length of the base in the lower part of the convex shape, W15 represents the height of the upper part, and W16 represents the height of the lower part. The convex shape is bilaterally symmetrical about the line connecting between the midpoints of the top and base of the upper and lower parts. The center of a rectangular shape contacting the base of the lower part, the lateral vertical sides of the lower part, and the top of the upper part, and enclosing the convex shape is regarded as the center of the convex shape. (b) is an enlarged view showing a part in the vicinity of the array pattern taken along the line II-II of Fig. 6, in which W4 represents the distance between the centers of the convex shapes. (c) shows dimensions of W10, W11, W15, W16 and W4. (d) shows attenuation characteristics with frequencies plotted on the horizontal axis.
The simulation showed that good attenuation characteristics of 10dB or more absorption were achieved in the vicinity of 35 GHz.

[Triangular shape]

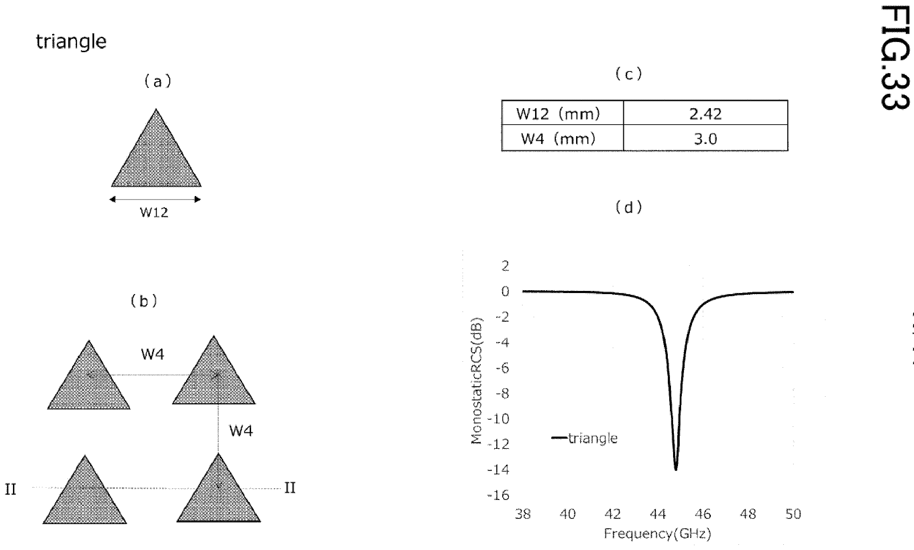

Fig. 33 is a set of diagrams showing electromagnetic wave attenuation characteristics when the metal plates have a triangular shape in Example 2C. (a) shows the shape of the metal plates, in which W12 represents the length of one side of the equilateral triangular shape. (b) is an enlarged view showing a part in the vicinity of the array pattern taken along the line II-II of Fig. 6, in which W4 represents the distance between the centers of the triangular shapes. (c) shows dimensions of W12 and W4. (d) shows attenuation characteristics with frequencies plotted on the horizontal axis.
The simulation showed that good attenuation characteristics of 10dB or more absorption were achieved in the vicinity of 44.8 GHz.

[Cross shape]

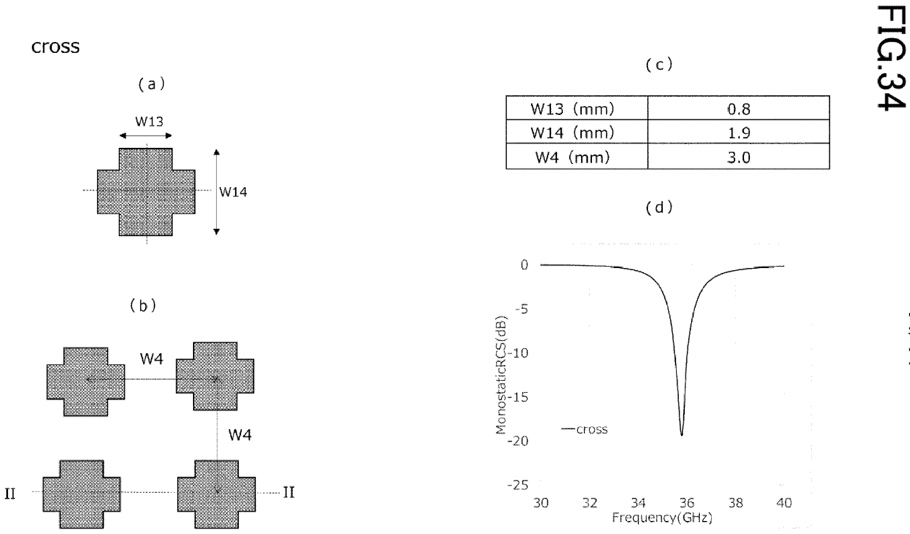

Fig. 34 is a set of diagrams showing electromagnetic wave attenuation characteristics when the metal plates have a cross shape in Example 2C. (a) shows the shape of the metal plates. The cross shape is vertically and horizontally symmetrical and is also symmetrical with respect to rotation of 90 degrees. W13 represents the length of the outer sides of the cross shape facing each other on the top and bottom, and on the left and right, and W14 represents the length of one side of a square contacting the outer sides facing each other on the top and bottom, and on the left and right. The center of the square is regarded as the center of the cross shape. (b) is an enlarged view showing a part in the vicinity of the array pattern taken along the line II-II of Fig. 6, in which W4 represents the distance between the centers of the cross shapes. (c) shows dimensions of W13, W14 and W4. (d) shows attenuation characteristics with frequencies plotted on the horizontal axis.

The simulation showed that good attenuation characteristics of 10dB or more absorption were achieved in the vicinity of 35.8 GHz.

[Loop-shape modification]

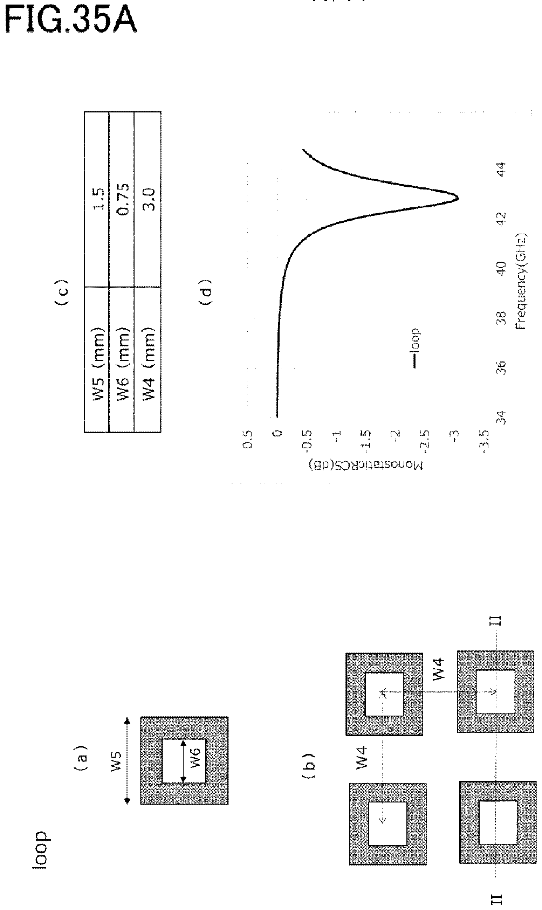

Fig. 35A is a set of diagrams showing electromagnetic wave attenuation characteristics when the metal plates have a loop shape in Example 2C. (a) shows the shape of the metal plates. W5 represents the length of one side of outer square, and W6 represents the length of one side of the inner square. The centers of the outer and inner squares coincide and are regarded to be the center of the loop shape. (b) is an enlarged view showing a part in the vicinity of the array pattern taken along the line II-II of Fig. 6, in which W4 represents the distance between the centers of the loop shapes, (c) shows dimensions of W5, W6 and W4. (d) shows attenuation characteristics with frequencies plotted on the horizontal axis.

The simulation showed that the peak of absorption was in the vicinity of 42.8 GHz but attenuation corresponding to 10 dB was not achieved.

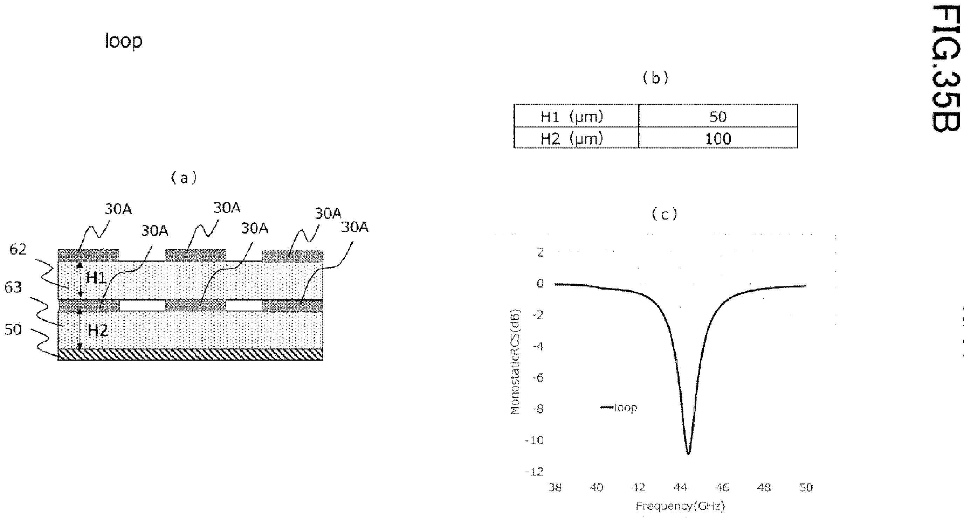

In this regard, a simulation was conducted for electromagnetic wave attenuation characteristics using a film in which two electromagnetic wave attenuation films having the same shape and array were overlapped with each other. Fig. 35B is a set of diagrams showing electromagnetic wave attenuation characteristics according to the modification in which two electromagnetic wave attenuation films whose metal plates have a loop shape are overlapped with each other in Example 2C. (a) shows the structure of the electromagnetic wave attenuation film according to the modification. Two layers each including the dielectric substrate and the metal plates used in Fig. 35A were overlapped with each other, and a planar inductor was provided to the dielectric substrate of the lower layer. H1 represents the thickness of the dielectric substrate of the upper layer, and H2 represents the thickness of the dielectric substrate of the lower layer. (b) shows dimensions of H1 and H2. (c) shows attenuation characteristics with frequencies plotted on the horizontal axis.

The simulation showed that good attenuation characteristics were achieved in the vicinity of 44.4 GHz.

(Example 2D)

A square PET film with a thickness of 50 $\mu$m and a side of 14 cm was prepared as a dielectric substrate. A thin-film aluminum conductive layer having a thickness of 100 nm was formed over one entire surface of the dielectric substrate using vacuum vapor deposition. After that, the thin-film conductive layer was etched using a mask so that metal plates could be formed at regular intervals in both of the X and Y coordinates. A planar aluminum inductor was bonded to the other surface via an adhesive layer. Simulations were conducted for this structure.

The above is the production procedure in Example 2D of the second embodiment. The parameters of Example 2D were as follows.

Width W1 of metal plates: 1.519 mm to 2.764 mm; 16 different types of metal plates, which were obtained by dividing a metal layer into 16 parts every 0.083 mm with an equal width, were arranged in a 4 × 4 matrix with even intervals of 0.1 mm therebetween in the same orientation to provide a metal plate set. A plurality of such metal plate sets were arranged in the same orientation with intervals of 0.1 mm therebetween. These metal plate sets were all identical. Specifically, the metal plates forming each metal plate set were not different between the metal plate sets.

Distance W3 between adjacent metal plates: 0.1 mm
Thickness T1 of metal plates: 149 nm
Thickness T2 of planar inductor: about 2 mm
Thickness H1 of dielectric substrate: 50 $\mu$m

To examine the suitability of the attenuation mechanism resulting from the experiments, simulations were conducted using this structure.

The electromagnetic wave attenuation films of the examples without including planar inductors all had a thickness of about 60 $\mu$m and a weight of about 0.02 g and thus were thin and light. Accordingly, these films can be easily attached to parts that are desired to be prevented from being affected by radiation noise due to electromagnetic waves or other parts in the housings of mobile phones, on-vehicle radar devices, and the like.

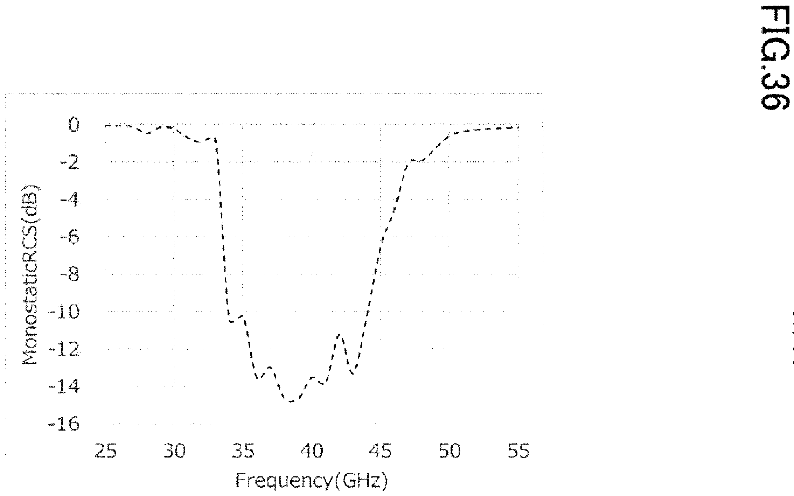

In the simulations, all of Examples 2A to 2D showed good attenuation for the electromagnetic waves in the millimeter-wave bands. The results of the simulation of Example 2D are shown in Fig. 36.

(Modification with top coat layer provided to Example 2A of second embodiment)

In Example 2A of the second embodiment, an electromagnetic wave attenuation film was prepared by providing a top coat layer 200 produced through the following procedure to the film that had been formed using aluminum so that the metal plates had a thickness T1 of 153 nm.

An acrylic resin composition that was a mixture of 80 parts by mass of methyl methacrylate monomer and 20 parts by mass of cyclohexyl methacrylate was prepared as a main component, and 6 parts by mass of hydroxyphenyltriazine UV absorber (ADK STAB LA-46 manufactured by ADEKA Corp.), 6 parts by mass of hydroxyphenyltriazine UV absorber with a different composition (Tinuvin 479 manufactured by Ciba Specialty Chemicals Corp.), 3 parts by mass of benzotriazole UV absorber (Tinuvin 329 manufactured by Ciba Specialty Chemicals Corp.), and 5 parts by mass of hindered amine radical scavenger (Tinuvin 292 manufactured by Ciba Specialty Chemicals Corp.) were added to the acrylic resin composition, with respect to 100 parts by mass of the solid content of the composition, followed by further mixing thereto a base resin solution with a solid content of 33 parts by mass to which an ethyl acetate solvent was added for solid content control and a hexamethylene diisocyanate-type curing agent solution with a solid content of 75 parts by mass to which an ethyl acetate solvent was added for solid content control so that the ratio of the base resin solution to the curing agent solution was 10:1 (in this case, the ratio of the number of hydroxyl groups in the base resin solution to the number of isocyanate groups in the curing agent solution was 1:2), further adding methyl acetate as the solvent component to prepare a coating liquid with the solid content controlled to 20 parts by mass, and this coating liquid was applied so that the thickness after solvent volatilization was 6 $\mu$m, thereby obtaining a top coat layer 200. The thickness of the top coat layer was 6 $\mu$m.

(Comparative Example 1)

An electromagnetic wave attenuation film was prepared according to Example 2A without providing a top coat layer.

The electromagnetic wave attenuation films of the modification and Comparative Example 1 were pressure bonded to respective stainless steel plates and subjected to exposure equivalent to 10-year outdoor exposure using a sunshine weather meter. After that, the surfaces of the electromagnetic wave attenuation films were wiped off with a cotton cloth to examine the change in state of the top coat layers and the electromagnetic wave attenuation layers, and in monostatic RCS attenuation characteristics.

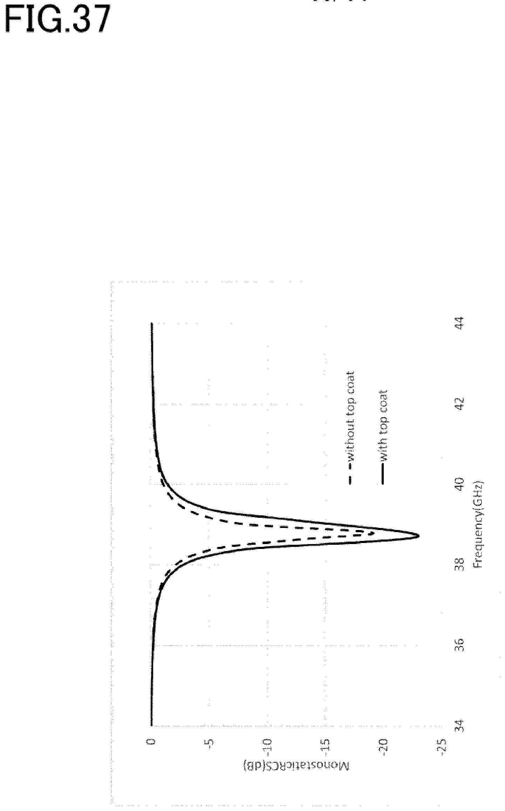

As a result, in the structure of the modification, neither the top coat layer nor the electromagnetic wave attenuation layer was deteriorated, impedance matching was achieved due to the formation of the top coat layer, and the monostatic RCS attenuation characteristics were improved as shown in Fig. 37.

[57 GHz to 90 GHz]

(Example 3A)

For the general theory described for Formula 4, a range of the Relational Formula ln(T/d) of the thickness T and the skin depth d of the metal plates showing preferred electromagnetic wave attenuation could be found in specific frequency ranges in the millimeter-wave bands, and this will be described below.

Simulations conducted for the range of 57 GHz to 90 GHz will be described. As a dielectric substrate, a PET film having a thickness (H1) of 50 $\mu$m was prepared and metal plates as thin-film conductive layer portions were provided to one surface thereof at regular intervals in both of the X and Y coordinates. A planar aluminum inductor having a thickness (T2) of about 2 mm was provided to the other surface of the dielectric substrate, and simulations were conducted.

Simulations were conducted for the frequencies of 57 GHz, 66 GHz, 71 GHz, 81 GHz, 86 GHz and 90 GHz for individual metal species in terms of the relationship between electromagnetic wave attenuation and ln(T1/d).

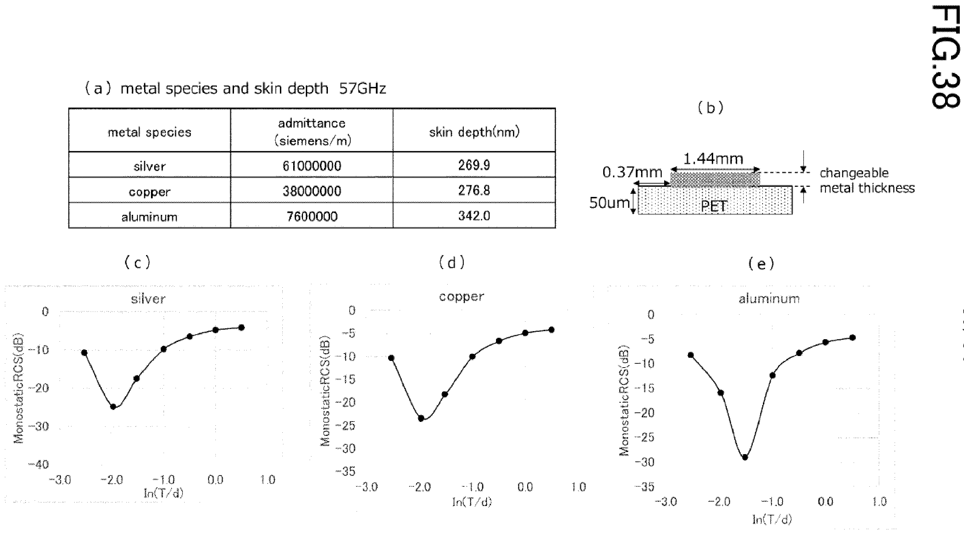

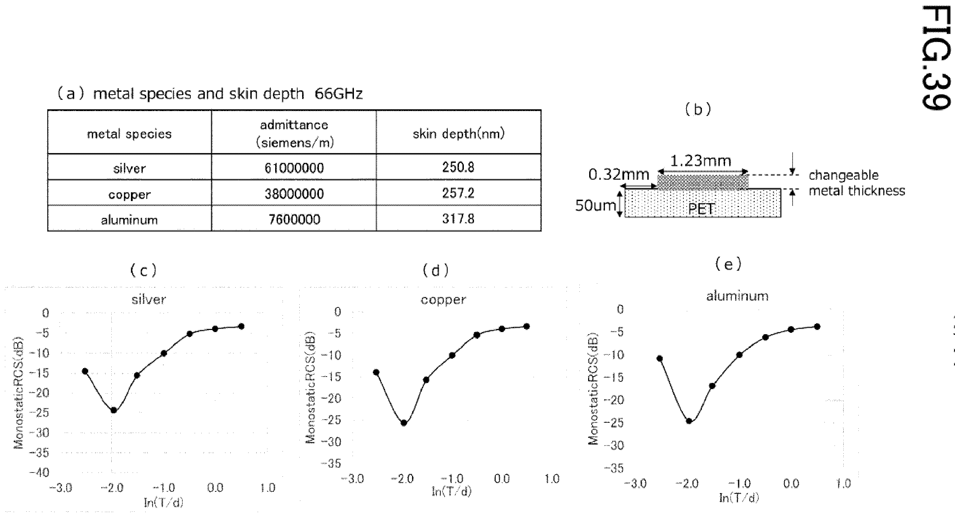

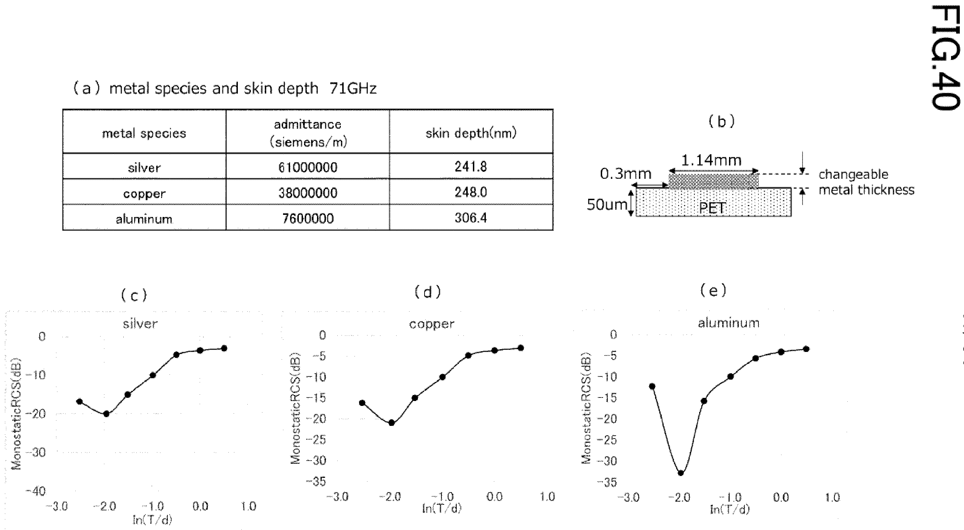

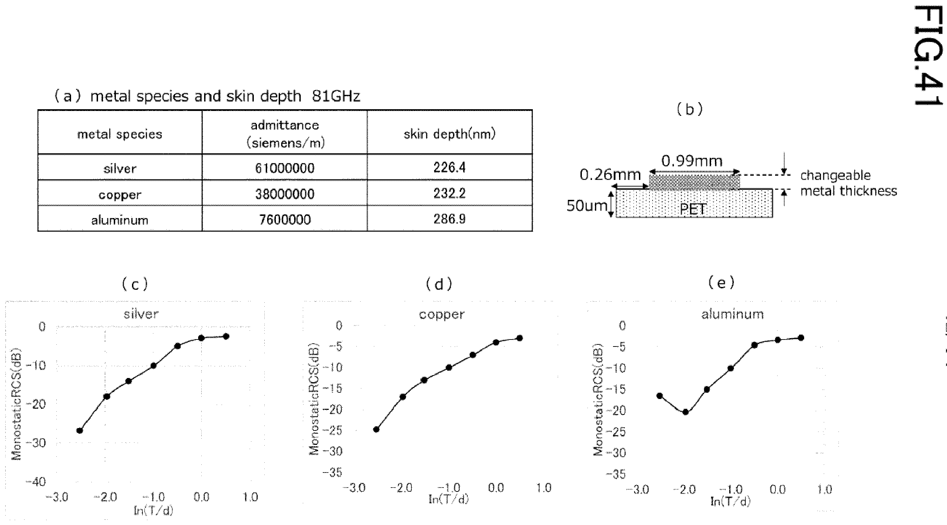

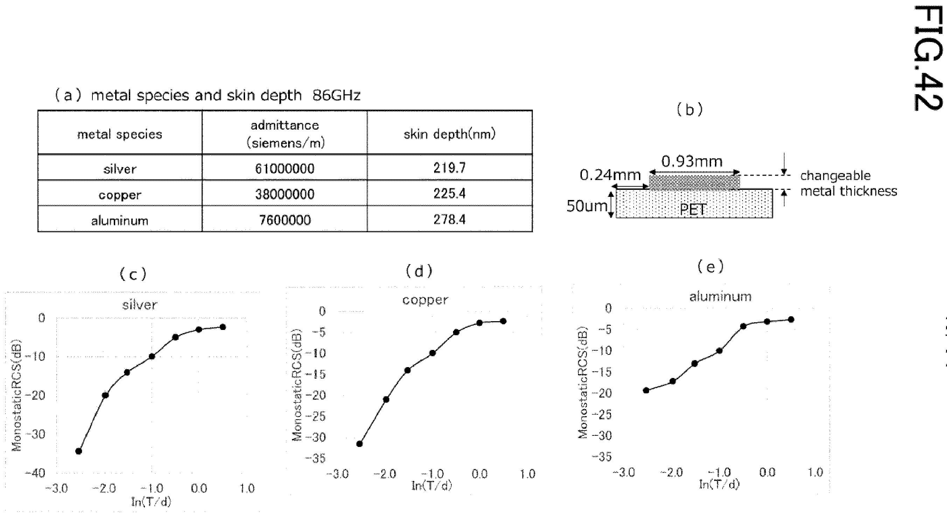

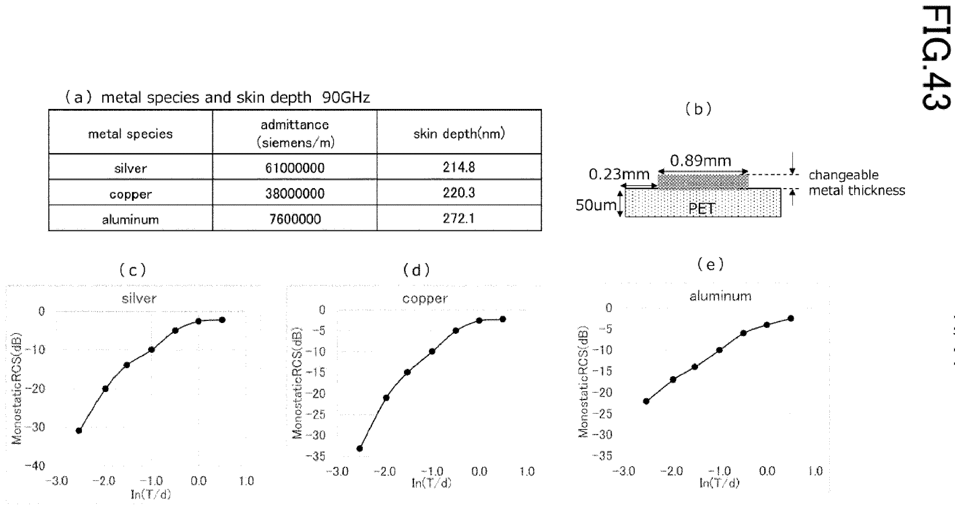

The results of the simulations will be described referring to Tables 7 and 8 and Figs. 38 to 43. Fig. 38 is a set of diagrams showing electromagnetic wave attenuation characteristics at 57 GHz in Example 3A. Fig. 39 is a set of diagrams showing electromagnetic wave attenuation characteristics at 66 GHz in Example 3A. Fig. 40 is a set of diagrams showing electromagnetic wave attenuation characteristics at 71 GHz in Example 3A. Fig. 41 is a set of diagrams showing electromagnetic wave attenuation characteristics at 81 GHz in Example 3A. Fig. 42 is a set of diagrams showing electromagnetic wave attenuation characteristics at 86 GHz in Example 3A. Fig. 43 is a set of diagrams showing electromagnetic wave attenuation characteristics at 90 GHz in Example 3A. In Figs. 38 to 43, (a) shows values of admittance and skin depth, (b) shows the structure of the electromagnetic wave attenuation film, and (c) to (e) are graphs showing attenuation characteristics of silver, copper and aluminum. The graphs show correlations between natural logarithms of values plotted on the horizontal axes obtained by normalizing the thickness T1 of the metal plates by the skin depth d thereof, and amounts of attenuation in the patterned metal plates plotted on the vertical axes, with the reflection amount of the metal plates having the same area as that of the dielectric substrate defined to be 100 (reflectance).

[Table 7]

| | | 57 GHz | | | | 66 GHz | | | | 71 GHz | | | |
|---|---|---|---|---|---|---|---|---|---|---|---|---|---|
| | Mul | Skn D (nm) | Fil Thk (nm) | LN (Fil Thk / Skn D) | Abs | Skn D (nm) | Fil Thk (nm) | LN (Fil Thk / Skn D) | Abs | Skn D (nm) | Fil Thk (nm) | LN (Fil Thk / Skn D) | Abs |
| Silver | 1.65 | | 445.4 | 0.5 | -4.1 | | 413.9 | 0.5 | -3.3 | | 399.0 | 0.5 | -3.0 |
| | 1 | | 269.9 | 0.0 | -4.8 | | 250.8 | 0.0 | -3.9 | | 241.8 | 0.0 | -3.6 |
| | 0.61 | | 164.6 | -0.5 | -6.5 | | 153.0 | -0.5 | -5.2 | | 147.5 | -0.5 | -4.7 |
| | 0.37 | 269.9 | 99.9 | -1.0 | -10.0 | 250.8 | 92.8 | -1.0 | -10.0 | 241.8 | 89.5 | -1.0 | -10.0 |
| | 0.22 | | 59.4 | -1.5 | -17.5 | | 55.2 | -1.5 | -15.6 | | 53.2 | -1.5 | -15.0 |
| | 0.14 | | 37.8 | -2.0 | -24.8 | | 35.1 | -2.0 | -24.4 | | 33.9 | -2.0 | -20.0 |
| | 0.08 | | 21.6 | -2.5 | -10.7 | | 20.1 | -2.5 | -14.5 | | 19.3 | -2.5 | -16.8 |
| Copper | 1.65 | | 456.7 | 0.5 | -4.2 | | 524.4 | 0.5 | -3.4 | | 409.2 | 0.5 | -3.1 |
| | 1 | | 276.8 | 0.0 | -4.9 | | 317.8 | 0.0 | -3.9 | | 248.0 | 0.0 | -3.6 |
| | 0.61 | | 168.8 | -0.5 | -6.6 | | 193.9 | -0.5 | -5.3 | | 151.3 | -0.5 | -4.8 |
| | 0.37 | 276.8 | 102.4 | -1.0 | -10.0 | 257.2 | 117.6 | -1.0 | -10.0 | 248.0 | 91.8 | -1.0 | -10.0 |
| | 0.22 | | 60.9 | -1.5 | -18.2 | | 69.9 | -1.5 | -15.7 | | 54.6 | -1.5 | -15.0 |
| | 0.14 | | 38.8 | -2.0 | -23.4 | | 44.5 | -2.0 | -25.6 | | 34.7 | -2.0 | -21.0 |
| | 0.08 | | 22.1 | -2.5 | -10.3 | | 25.4 | -2.5 | -13.9 | | 19.8 | -2.5 | -16.2 |
| Aluminum | 1.65 | | 564.2 | 0.5 | -4.7 | | 524.4 | 0.5 | -3.8 | | 505.6 | 0.5 | -3.4 |
| | 1 | | 342.0 | 0.0 | -5.6 | | 317.8 | 0.0 | -4.5 | | 306.4 | 0.0 | -4.1 |
| | 0.61 | | 208.6 | -0.5 | -7.8 | | 193.9 | -0.5 | -6.2 | | 186.9 | -0.5 | -5.6 |
| | 0.37 | 342.0 | 126.5 | -1.0 | -12.4 | 317.8 | 117.6 | -1.0 | -10.0 | 306.4 | 113.4 | -1.0 | -10.0 |
| | 0.22 | | 75.2 | -1.5 | -29.0 | | 69.9 | -1.5 | -16.8 | | 67.4 | -1.5 | -15.8 |
| | 0.14 | | 47.9 | -2.0 | -15.9 | | 44.5 | -2.0 | -24.6 | | 42.9 | -2.0 | -32.8 |
| | 0.08 | | 27.4 | -2.5 | -10.0 | | 25.4 | -2.5 | -10.8 | | 24.5 | -2.5 | -12.3 |

| 81 GHz | | | | 86 GHz | | | | 90 GHz | | | |
|---|---|---|---|---|---|---|---|---|---|---|---|
| Skn D (nm) | Fil Thk (nm) | LN (Fil Thk / Skn D) | Abs | Skn D (nm) | Fil Thk (nm) | LN (Fil Thk / Skn D) | Abs | Skn D (nm) | Fil Thk (nm) | LN (Fil Thk / Skn D) | Abs |
| | 373.6 | 0.5 | -2.5 | | 362.6 | 0.5 | -2.3 | | 354.4 | 0.5 | -2.2 |
| | 226.4 | 0.0 | -2.9 | | 219.7 | 0.0 | -3.0 | | 214.8 | 0.0 | -2.6 |
| | 138.1 | -0.5 | -5.0 | | 134.0 | -0.5 | -5.0 | | 131.0 | -0.5 | -5.0 |
| 226.4 | 83.8 | -1.0 | -10.0 | 219.74 | 81.3 | -1.0 | -10.0 | 214.8 | 79.5 | -1.0 | -10.0 |
| | 49.8 | -1.5 | -14.0 | | 48.3 | -1.5 | -14.0 | | 47.3 | -1.5 | -14.0 |
| | 31.7 | -2.0 | -18.0 | | 30.8 | -2.0 | -20.0 | | 30.1 | -2.0 | -20.0 |
| | 18.1 | -2.5 | -26.8 | | 17.6 | -2.5 | -34.4 | | 17.2 | -2.5 | -31.0 |
| | 383.1 | 0.5 | -3.0 | | 371.8 | 0.5 | -2.4 | | 363.5 | 0.5 | -2.2 |
| | 232.2 | 0.0 | -4.0 | | 225.4 | 0.0 | -2.8 | | 220.3 | 0.0 | -2.6 |
| | 141.6 | -0.5 | -7.0 | | 137.5 | -0.5 | -5.0 | | 134.4 | -0.5 | -5.0 |
| 232.2 | 85.9 | -1.0 | -10.0 | 225.35 | 83.4 | -1.0 | -10.0 | 220.3 | 81.5 | -1.0 | -10.0 |
| | 51.1 | -1.5 | -13.0 | | 49.6 | -1.5 | -14.0 | | 48.5 | -1.5 | -15.0 |
| | 32.5 | -2.0 | -17.0 | | 31.5 | -2.0 | -21.0 | | 30.8 | -2.0 | -21.0 |
| | 18.6 | -2.5 | -24.8 | | 18.0 | -2.5 | -31.6 | | 17.6 | -2.5 | -33.2 |
| | 473.3 | 0.5 | -2.8 | | 459.4 | 0.5 | -2.6 | | 449.0 | 0.5 | -2.5 |
| | 286.9 | 0.0 | -3.4 | | 278.4 | 0.0 | -3.1 | | 272.1 | 0.0 | -4.0 |
| | 175.0 | -0.5 | -4.6 | | 169.8 | -0.5 | -4.2 | | 166.0 | -0.5 | -6.0 |
| 286.9 | 106.1 | -1.0 | -10.0 | 278.40 | 103.0 | -1.0 | -10.0 | 272.1 | 100.7 | -1.0 | -10.0 |
| | 63.1 | -1.5 | -15.0 | | 61.2 | -1.5 | -13.0 | | 59.9 | -1.5 | -14.0 |
| | 40.2 | -2.0 | -20.3 | | 39.0 | -2.0 | -17.1 | | 38.1 | -2.0 | -17.0 |
| | 22.9 | -2.5 | -16.5 | | 22.3 | -2.5 | -19.3 | | 21.8 | -2.5 | -22.1 |

[Table 8]

|  | 57 GHz | 66 GHz | 71 GHz | 81 GHz | 86 GHz | 90 GHz |
|---|---|---|---|---|---|---|
| Metal dimension W1 | 1.44 | 1.23 | 1.14 | 0.99 | 0.93 | 0.89 |
| Inter-plate distance W3 | 0.74 | 0.63 | 0.59 | 0.51 | 0.48 | 0.46 |

As will be clear from Table 7 and Figs. 38 to 43, when 10 dB or more absorption by an electromagnetic wave attenuation film is used as an index of good attenuation, films satisfying $-2.5 \leq \ln(T1/d) < -1.0$ could achieve good attenuation in the frequency range of 57 GHz to 90 GHz.

Good attenuation characteristics of around 10 dB are not limited to those achieved by the numerical values of the parameters used in Example 3A, but can be expected to be achieved, as a matter of course, in the structures having some range of parameter values. For example, good attenuation characteristics of around 10 dB can be expected with a structure in which the metal plates have a width W1 of 0.9 mm to 1.4 mm, adjacent metal plates have a distance W3 therebetween of 0.5 mm to 0.7 mm, the dielectric substrate has a thickness H1 of 5 $\mu$m to 300 $\mu$m, and the planar inductor has a thickness T2 of 0.5 $\mu$m to 5 mm.

(Example 3B)

As in Example 3A, a dielectric substrate was prepared, including a PET film having a thickness (H1) of 50 $\mu$m, and metal plates as thin-film conductive layer portions provided on one surface of the PET film, with the ratio of the total area of the metal plates to the entire area of the dielectric substrate in the XY plane being changed. A planar aluminum inductor having a thickness (T2) of about 2 mm was provided to the other surface of the dielectric substrate, and simulations were conducted. The metal species used for the metal plates was aluminum, the metal plates had a width W1 of 1.0 mm and a thickness T1 of 80 nm, and the percentage of the metal area was changed by controlling the distance W3 between the metal plates.

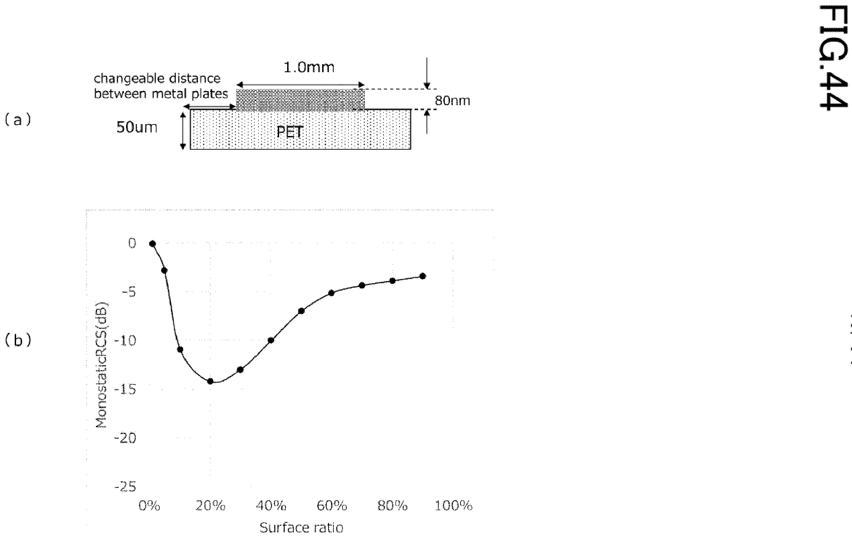

The results of the simulations will be described referring to Table 9 and Fig. 44. Fig. 44 is a set of diagrams showing electromagnetic wave attenuation characteristics at 81 GHz in Example 3B as a function of the percentage of metal area. (a) shows the structure of the electromagnetic wave attenuation film, and (b) shows attenuation characteristics.

[Table 9]

| Metal area ratio | 1% | 5% | 10% | 20% | 30% | 40% | 50% | 60% | 70% | 80% | 90% |
|---|---|---|---|---|---|---|---|---|---|---|---|
| W3 (mm) | 9.00 | 3.47 | 2.16 | 1.24 | 0.83 | 0.58 | 0.41 | 0.29 | 0.20 | 0.12 | 0.05 |
| Abs | -0.1 | -2.8 | -10.9 | -14.2 | -13.0 | -10.0 | -7.0 | -5.1 | -4.4 | -3.9 | -3.4 |

As can be seen from Table 9 and Fig. 44, when 10 dB or more absorption by an electromagnetic wave attenuation film is used as an index of good attenuation, films in which the percentage of the metal area was in the vicinity of 10 to 40% could achieve good attenuation in Example 3B.

(Example 3C)

As in Example 3A, a dielectric substrate was prepared, including a PET film having a thickness (H1) of 50 $\mu$m, metal plates as thin-film conductive layer portions arranged on one surface of the PET film with the same pattern array as shown in Fig. 6, with the shape of the metal plates changed to shapes other than square, and a planar aluminum inductor having a thickness (T2) of about 2mm provided to the other surface of the dielectric substrate, and simulations were conducted. The metal species used for the metal plates was aluminum, and the metal plates were designed to have a thickness T1 of 80 nm.

[Rectangular shape]

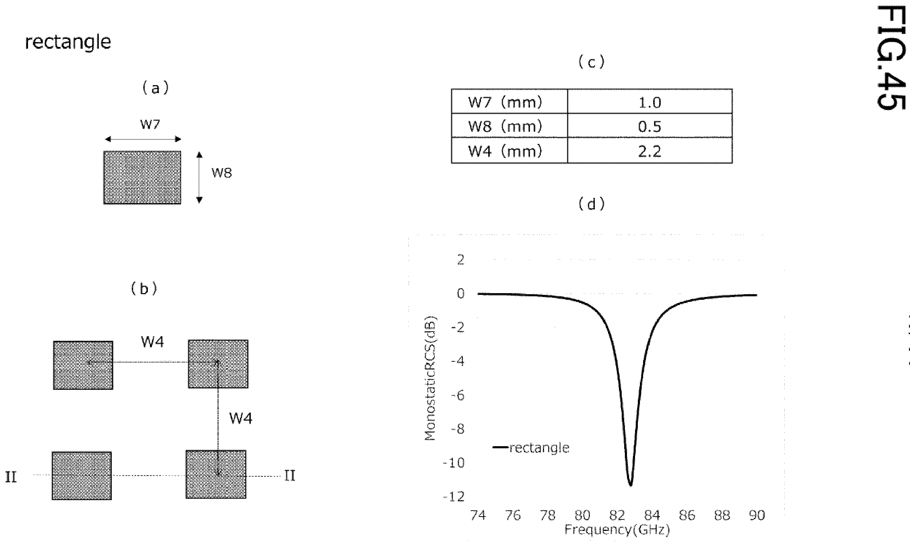

Fig. 45 is a set of diagrams showing electromagnetic wave attenuation characteristics when the metal plates have a rectangular shape in Example 3C. (a) shows the shape of the metal plates, in which W7 represents the length of the long side of the rectangular shape, and W8 represents the length of the short side thereof, (b) is an enlarged view showing a part in the vicinity of the array pattern taken along the line II-II of Fig. 6, in which W4 represents the distance between the centers of the rectangular shapes. (c) shows dimensions of W7 and W8. (d) shows attenuation characteristics with frequencies plotted on the horizontal axis.

The simulation showed that good attenuation characteristics of 10dB or more absorption were achieved in the vicinity of 82.8 GHz.

[Hexagonal shape]

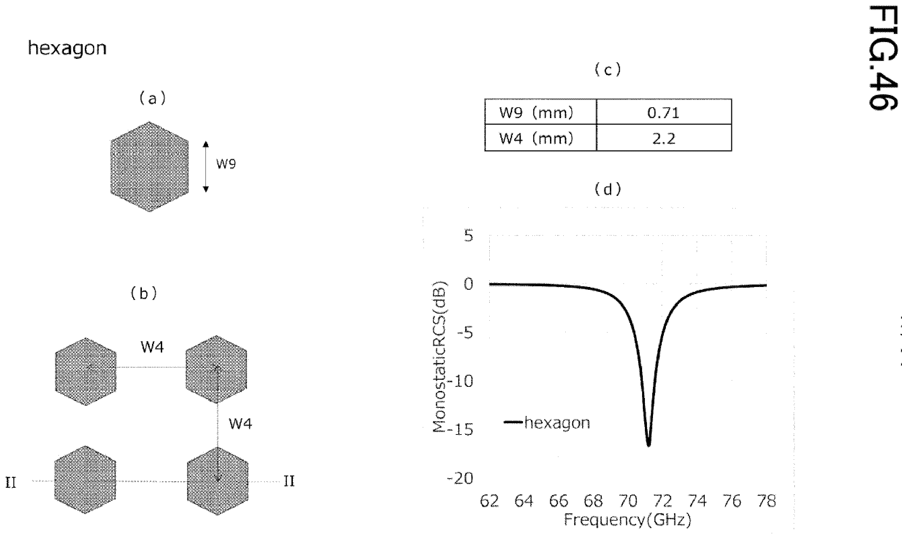

Fig. 46 is a set of diagrams showing electromagnetic wave attenuation characteristics when the metal plates have a hexagonal shape in Example 3C. (a) shows the shape of the metal plates, in which W9 represents the length of one side of the hexagonal shape. (b) is an enlarged view showing a part in the vicinity of the array pattern taken along the line II-II of Fig. 6, in which W4 represents the distance between the centers of the hexagonal shapes. (c) shows dimensions of W9 and W4. (d) shows attenuation characteristics with frequencies plotted on the horizontal axis.

The simulation showed that good attenuation characteristics of 10dB or more absorption were achieved in the vicinity of 71.2 GHz.

[Convex shape]

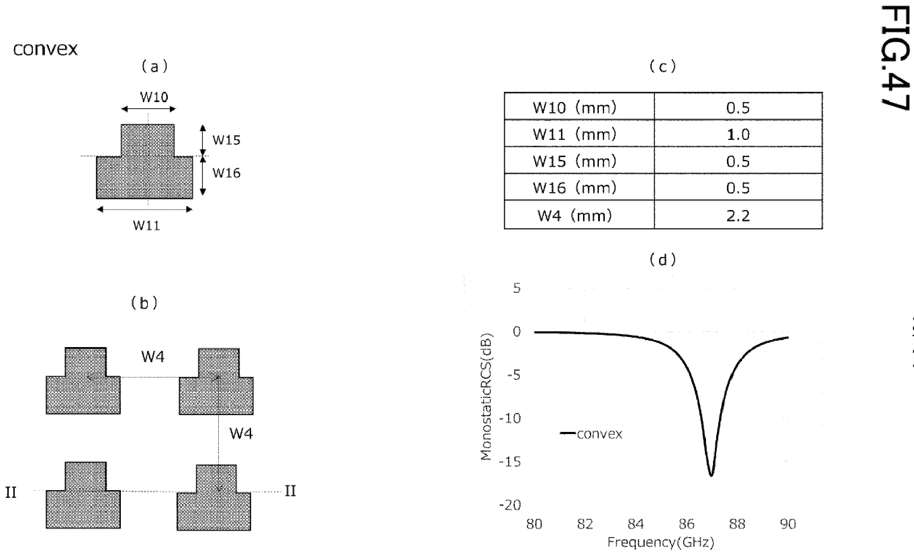

Fig. 47 is a set of diagrams showing electromagnetic wave attenuation characteristics when the metal plates have a convex shape in Example 3C. (a) shows the shape of the metal plates. W10 represents the length of the top of the protrusion in the upper part of the convex shape, W1 1 represents the length of the base in the lower part of the convex shape, W15 represents the height of the upper part, and W16 represents the height of the lower part. The convex shape is bilaterally symmetrical about the line connecting between the midpoints of the top and base of the upper and lower parts. The center of a rectangular shape contacting the base of the lower part, the lateral vertical sides of the lower part, and the top of the upper part, and enclosing the convex shape is regarded as the center of the convex shape. (b) is an enlarged view showing a part in the vicinity of the array pattern taken along the line II-II of Fig. 6, in which W4 represents the distance between the centers of the convex shapes. (c) shows dimensions of W10, W11, W15, W16 and W4. (d) shows attenuation characteristics with frequencies plotted on the horizontal axis.

The simulation showed that good attenuation characteristics of 10dB or more absorption were achieved in the vicinity of 87 GHz.

[Triangular shape]

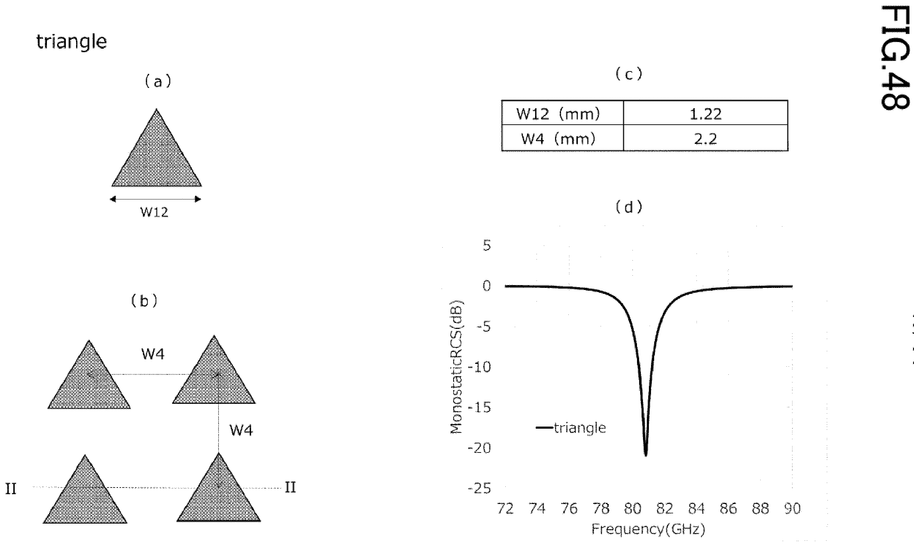

Fig. 48 is a set of diagrams showing electromagnetic wave attenuation characteristics when the metal plates have a triangular shape in Example 3C. (a) shows the shape of the metal plates, in which W12 represents the length of one side of the equilateral triangular shape, (b) is an enlarged view showing a part in the vicinity of the array pattern taken along the line II-II of Fig. 6, in which W4 represents the distance between the centers of the triangular shapes. (c) shows dimensions of W12 and W4. (d) shows attenuation characteristics with frequencies plotted on the horizontal axis.

The simulation showed that good attenuation characteristics of 10dB or more absorption were achieved in the vicinity of 80.8 GHz.

[Cross shape]

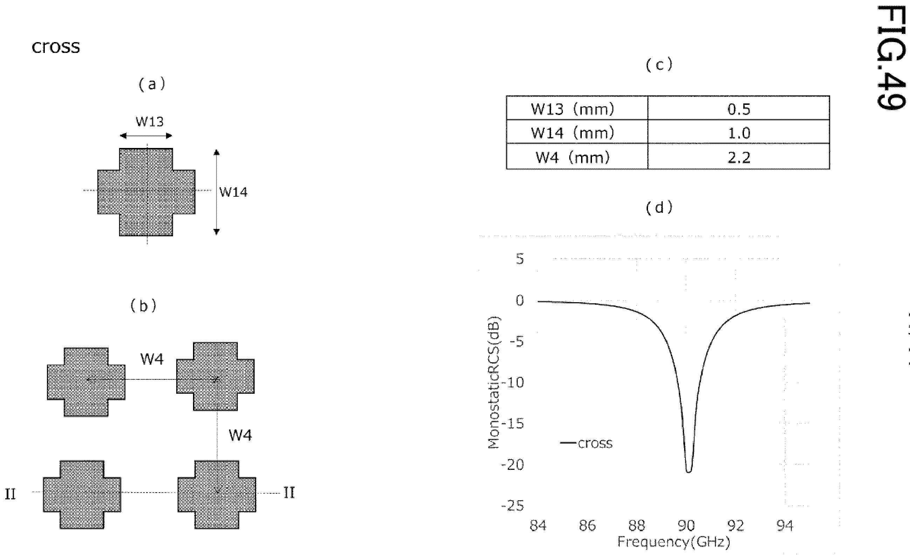

Fig. 49 is a set of diagrams showing electromagnetic wave attenuation characteristics when the metal plates have a cross shape in Example 3C. (a) shows the shape of the metal plates. The cross shape is vertically and horizontally symmetrical and is also symmetrical with respect to rotation of 90 degrees. W13 represents the length of the outer sides of the cross shape facing each other on the top and bottom, and on the left and right, and W14 represents the length of one side of a square contacting the outer sides facing each other on the top and bottom, and on the left and right. The center of the square is regarded as the center of the cross shape. (b) is an enlarged view showing a part in the vicinity of the array pattern taken along the line II-II of Fig. 6, in which W4 represents the distance between the centers of the cross shapes. (c) shows dimensions of W13, W14 and W4. (d) shows attenuation characteristics with frequencies plotted on the horizontal axis.

The simulation showed that good attenuation characteristics of 10dB or more absorption were achieved in the vicinity of 90 GHz.

(Example 3D)

A square PET film with a thickness of 50 $\mu$m and a side of 14 cm was prepared as a dielectric substrate. A thin-film aluminum conductive layer having a thickness of 100 nm was formed over one entire surface of the dielectric substrate using vacuum vapor deposition. After that, the thin-film conductive layer was etched using a mask so that metal plates could be formed at regular intervals in both of the X and Y coordinates. A planar aluminum inductor was bonded to the other surface via an adhesive layer. Simulations were conducted for this structure.

The above is the production procedure in Example 3D of the second embodiment. The parameters of Example 3D were as follows.

Width W1 of metal plates: 1.025 mm to 0.9 mm; 16 different types of metal plates, which were obtained by dividing a metal layer into 16 parts every 0.083 mm with an equal width, were arranged in a 4 × 4 matrix with even intervals of 0.1 mm therebetween in the same orientation to provide a metal plate set. A plurality of such metal plate sets were arranged in the same orientation with intervals of 0.1 mm therebetween. These metal plate sets were all identical. Specifically, the metal plates forming each metal plate set were not different between the metal plate sets.

Distance W3 between adjacent metal plates: 0.1 mm
Thickness T1 of metal plates: 80 nm
Thickness T2 of planar inductor: about 2 mm
Thickness H1 of dielectric substrate: 50 $\mu$m

To examine the suitability of the attenuation mechanism resulting from the experiments, simulations were conducted using this structure.

The electromagnetic wave attenuation films of the examples without including planar inductors all had a thickness of about 60 $\mu$m and a weight of about 0.02 g and thus were thin and light. Accordingly, these films can be easily attached to parts that are desired to be prevented from being affected by radiation noise due to electromagnetic waves or other parts in the housings of mobile phones, on-vehicle radar devices, and the like.

In the simulations, all of Examples 3A to 3D showed good attenuation for the electromagnetic waves in the millimeter-wave bands. Furthermore, attenuation rates were obtained in the actual measurements, and the present structure was confirmed to be effective. Although there are differences from the experimental results, which are considered to be due to effects other than attenuation based on various parameters and on Maxwell's equations as in the simulation, similar attenuation trends can be seen, and the mechanism suggested in the embodiments of the present invention is considered appropriate. Although there are differences in attenuation rate, it was shown that similar trends could be obtained between the simulations and the actual measurements, and the attenuation center frequency could be appropriately set.

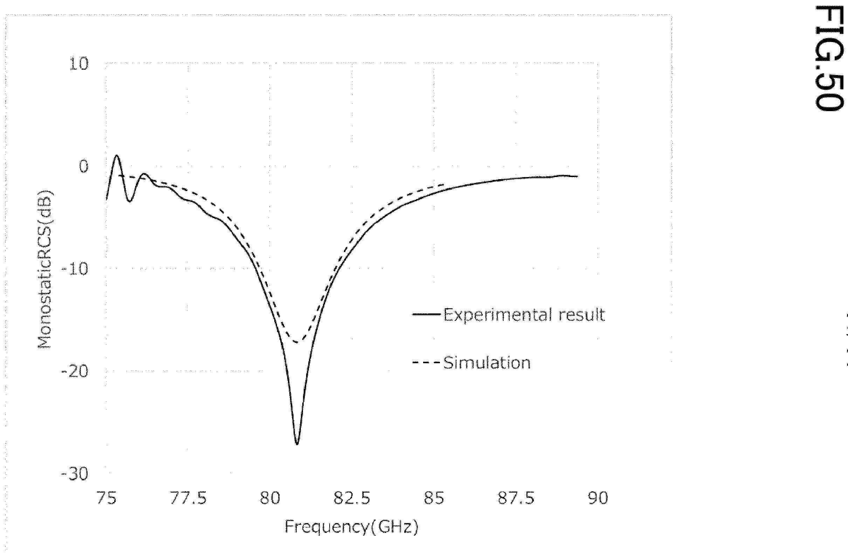

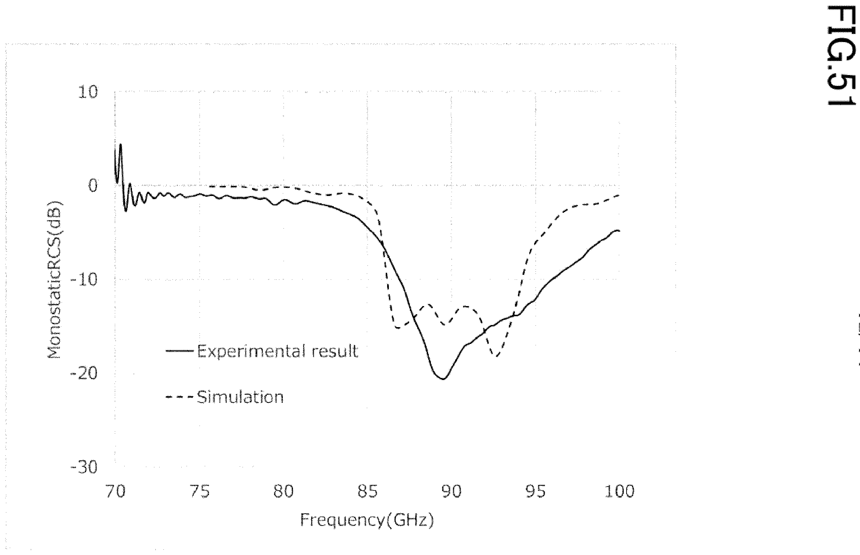

Figs. 50 and 51 show monostatic RCS attenuation characteristics in the simulations and the actual measurements of Examples 3A and 3D. Example 3 A used aluminum in which the metal plates had a width W1 of 1.0 mm, the adjacent metal plates had a distance W3 therebetween of 0.5 mm, and the metal plates had a thickness T1 of 100 nm. The procedure of the actual measurements was as follows.

Two metal plates having the same dimension were prepared, and the electromagnetic wave attenuation film of each example was attached to one of them so as to cover the entirety. In an anechoic chamber, radio waves were applied to the metal plates to which the electromagnetic wave attenuation film was attached and not attached, and the amount of the reflected radio waves was measured using a network analyzer (Model E5071C manufactured by Keysight Technologies). The amount of reflection by the metal plate not provided with the electromagnetic wave attenuation film was defined to be 100 (reference), and monostatic RCS attenuation was evaluated.

(Modification with top coat layer provided to Example 3A of second embodiment)

In Example 3A of the second embodiment, an electromagnetic wave attenuation film was prepared by providing a top coat layer 200 produced through the following procedure to the film that had been formed using aluminum so that the metal plates had a thickness T1 of 80 nm.

An acrylic resin composition that was a mixture of 80 parts by mass of methyl methacrylate monomer and 20 parts by mass of cyclohexyl methacrylate was prepared as a main component, and 6 parts by mass of hydroxyphenyltriazine UV absorber (ADK STAB LA-46 manufactured by ADEKA Corp.), 6 parts by mass of hydroxyphenyltriazine UV absorber with a different composition (Tinuvin 479 manufactured by Ciba Specialty Chemicals Corp.), 3 parts by mass of benzotriazole UV absorber (Tinuvin 329 manufactured by Ciba Specialty Chemicals Corp.), and 5 parts by mass of hindered amine radical scavenger (Tinuvin 292 manufactured by Ciba Specialty Chemicals Corp.) were added to the acrylic resin composition, with respect to 100 parts by mass of the solid content of the composition, followed by further mixing thereto a base resin solution with a solid content of 33 parts by mass to which an ethyl acetate solvent was added for solid content control and a hexamethylene diisocyanate-type curing agent solution with a solid content of 75 parts by mass to which an ethyl acetate solvent was added for solid content control so that the ratio of the base resin solution to the curing agent solution was 10:1 (in this case, the ratio of the number of hydroxyl groups in the base resin solution to the number of isocyanate groups in the curing agent solution was 1:2), further adding methyl acetate as the solvent component to prepare a coating liquid with the solid content controlled to 20 parts by mass, and this coating liquid was applied so that the thickness after solvent volatilization was 6 $\mu$m, thereby obtaining a top coat layer 200. The thickness of the top coat layer was 6 $\mu$m.

(Comparative Example 1)

An electromagnetic wave attenuation film was prepared according to Example 3A without providing a top coat layer.

The electromagnetic wave attenuation films of the modification and Comparative Example 1 were pressure bonded to respective stainless steel plates and subjected to exposure equivalent to 10-year outdoor exposure using a sunshine weather meter. After that, the surfaces of the electromagnetic wave attenuation films were wiped off with a cotton cloth to examine the change in state of the top coat layers and the electromagnetic wave attenuation layers, and in monostatic RCS attenuation characteristics.

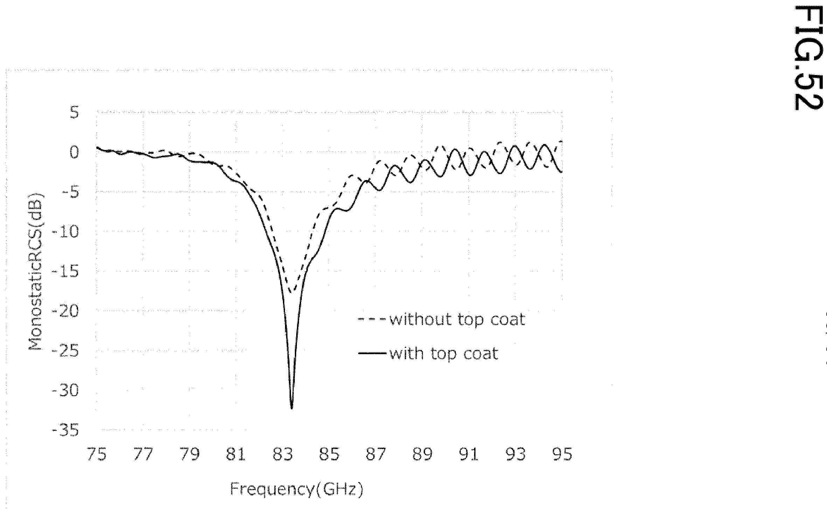

As a result, in the structure of the modification, neither the top coat layer nor the electromagnetic wave attenuation layer was deteriorated, impedance matching was achieved due to the formation of the top coat layer, and the monostatic RCS attenuation characteristics were improved as shown in Fig. 52.

The embodiments of the present invention have so far been described in detail with reference to the drawings; however, specific configurations are not limited to these embodiments, but the present invention should encompass modifications, combinations, or the like of these embodiments, in the range not departing from the spirit of the present invention. Some modifications will be exemplified below, but other modifications can also be made. Two or more of these modifications may be combined.

In the first embodiment, factors, such as the frequency ranges and the species of the metal plates, used in the second embodiment can be appropriately used.

In the first embodiment, the metal layer of the second region may be omitted and only the metal plates may be formed.

In the present invention, the planar inductor is not limited to the mode in which it is formed on the entire rear surface. For example, a plurality of metal plates may be arranged on the rear surface similarly to the front surface or in a lattice.

In the present invention, the metal plates are not limited to have a square shape, but may have various shapes, such as circular shape (including elliptical shape), polygonal shape other than square shape, various polygonal shapes with rounded corners, and irregular shapes.

The total area of the metal plates with respect to the projected area of the front surface is preferred to be 20% or more.

With this percentage, electromagnetic waves can be efficiently attenuated.

A plurality of electromagnetic wave attenuation films of the present invention may be laminated and used. The structural parameters of the plurality of films to be laminated may be made different from each other to more finely control attenuation.

In the first embodiment, the levels of the first and second regions may be reversed. In this case, the metal plates may be located at a relatively high level, and the support cage may be located at a relatively low level.

The electromagnetic wave attenuation film of the present embodiment may have a structure not provided with a planar inductor on the rear surface. For example, if the target of bonding the rear surface is metal, the second and third mechanisms can be developed due to the target of bonding being a metal surface without any problem even when no planar inductor is provided. In this case, a lamination layer such as an adhesive layer that can be bonded to the target may be provided to the rear surface.

In the electromagnetic wave attenuation film of the present invention, it is not essential that the parameters, such as structural period or metal plate dimension, be in perfect agreement in all sites. For example, if the parameters vary within the tolerance range (approximately 5% above and below) in the manufacturing process, the parameters are regarded to represent a constant shape and size in the present invention. Values in a predetermined range can be a regularity value range. This regularity can be a tolerance range in a gaussian distribution, binomial distribution, random or pseudo-random distribution with equal frequency within a given area, or manufacturing process.

The support cage may be formed of a plurality of conductive segments arranged with a gap therebetween. The gap in this case can be 1/10 or less the wavelength of the electromagnetic waves desired to be captured. The support cage can be formed using a plurality of conductive segments. In other words, the support cage may be formed of a plurality of conductive segments.

In the electromagnetic wave attenuation film of the present invention, a release layer may be provided to a support substrate, followed by providing the electromagnetic wave attenuation film of the first or second embodiment and further providing an adhesive, tackifier, or the like, for use as a transfer foil.

Specifically, a release layer may be applied to a support surface and dried, followed by providing a primer layer thereon. If the structure of the first embodiment is used, asperities may be imparted to the primer layer and a thin-film conductive layer may be vapor-deposited. After that, the thin-film conductive layer portions formed on the side surfaces of the second region may be removed, and a layer serving as a dielectric substrate may be provided. A planar inductor and an adhesive may be laminated in this order on the dielectric substrate to provide a transfer foil. If the structure of the second embodiment is used, a thin-film conductive layer may be provided to the primer layer, and a mask layer may be printed in a pattern of metal plates. After that, extra thin-film conductive layer portions may be etched away to provide metal plates. Furthermore, a dielectric substrate, planar inductor, and adhesive may be laminated in this order to provide a transfer foil. If the foil is transferred to a metal housing or the like, the layer of the planar inductor may be omitted.

Being provided as a transfer foil, the film can be made even thinner, can further improve conformability, and can be transferred to a complicated shape, thereby increasing the application range of the electromagnetic wave attenuation film of the present invention.

According to the embodiments and the modifications described above, the following supplementary statements can be derived.

[Statement 1]

An electromagnetic wave attenuation film including

a dielectric substrate having a front surface and a rear surface;
a thin-film conductive layer disposed on the front surface; and
a planar inductor or a lamination layer disposed on the rear surface, wherein
the thin-film conductive layer includes a plurality of metal plates; and the metal plates each have a thickness T of 1,000 nm or less.

[Statement 2]

An electromagnetic wave attenuation film including

a dielectric substrate having a front surface and a rear surface;
a thin-film conductive layer disposed on the front surface; and
a planar inductor or a lamination layer disposed on the rear surface, wherein
the thin-film conductive layer includes a plurality of metal plates; and the following formula (2) is satisfied:

$$-2 \leq \ln(T/d) \leq 0 \quad \ldots (2)$$

where T represents a thickness of the metal plates, and d represents the skin depth.

[Statement 3]

An electromagnetic wave attenuation film including

a dielectric substrate having a front surface and a rear surface;
a thin-film conductive layer disposed on the front surface; and
a planar inductor or a lamination layer disposed on the rear surface, wherein
the thin-film conductive layer includes a plurality of metal plates;
the dielectric layer has asperities on the front surface, the asperities including at least two first regions as concavities located at a relatively low level, and a second region located at a relatively high level;
the at least two first regions are discretely arranged;
the second region is located between the two first regions;
the metal plates are arranged in the at least two first regions; and the following formula (2) is satisfied:

$$-2 \leq \ln(T/d) \leq 0 \quad \ldots (2)$$

where T represents a thickness of the metal plates, and d represents the skin depth.

[Statement 4]

An electromagnetic wave attenuation film including

a dielectric substrate having a front surface and a rear surface;
a thin-film conductive layer disposed on the front surface; and
a planar inductor or a lamination layer disposed on the rear surface, wherein
the dielectric layer has asperities on the front surface, the asperities including at least two first regions as concavities located at a relatively low level, and a second region located at a relatively high level;
the thin-film conductive layer includes a plurality of metal plates arranged in the at least two first regions, and a support cage disposed in the at least two first regions;
the at least two first regions are discretely arranged; and
the second region is located between the two first regions;

In the above examples, attenuation of electromagnetic waves is studied; while conductors attenuating specific electromagnetic waves are known to serve as antennas that receive radio waves. Accordingly, the embodiments described above can be used as receiving antennas. In the embodiments described above, quanta with zero momentum can be captured in a two-dimensional system and, therefore, these embodiments can be used as devices that calculate and record data with the metal plates being in a quantum state.

As described above, in the embodiments of the present invention, the mechanism of interaction with electromagnetic waves is different from the conventional art and, therefore, products developing the equivalent mechanism should be construed as substantially using the embodiments of the present invention.

[Reference Signs List]

| 1, 61: | Electromagnetic wave attenuation film |
| 10, 62: | Dielectric substrate |
| 10a, 62a: | Front surface |
| 10b, 62b: | Rear surface |
| 30: | Thin-film conductive layer |
| 30A: | Metal plates |
| 50: | Planar inductor |
| 200: | Top coat layer |
| 121: | First regions |
| 122: | Second region |

**Claims**

1. An electromagnetic wave attenuation film, comprising

a dielectric substrate having a front surface and a rear surface;
a thin-film conductive layer disposed on the front surface, the thin-film conductive layer including a plurality of discretely arranged metal plates; and
a planar inductor disposed on the rear surface, wherein
the electromagnetic wave attenuation film is configured to attenuate millimeter waves within a predetermined frequency range.

2. The electromagnetic wave attenuation film according to claim 1, wherein

the predetermined frequency range is a frequency range of 27 GHz to 34 GHz; and
the electromagnetic wave attenuation film satisfies the following Formula (1):

$$-1.0 \leq \ln(T/d) \leq 0.0 \qquad \ldots (1)$$

where T represents a thickness of the metal plates, and d represents a skin depth.

3. The electromagnetic wave attenuation film according to claim 1, wherein

the predetermined frequency range is a frequency range of 35 GHz to 50 GHz; and
the electromagnetic wave attenuation film satisfies the following Formula (2):

$$-2.0 \le \ln(T/d) \le -0.5 \qquad ... (2)$$

where T represents a thickness of the metal plates, and d represents a skin depth.

4. The electromagnetic wave attenuation film according to claim 1, wherein

the predetermined frequency range is a frequency range of 57 GHz to 90 GHz; and
the electromagnetic wave attenuation film satisfies the following Formula (3):

$$-2.5 \le \ln(T/d) \le -1.0 \qquad ... (3)$$

where T represents a thickness of the metal plates, and d represents a skin depth.

5. The electromagnetic wave attenuation film according to claim 1, wherein

the predetermined frequency range is a frequency range of 27 GHz to 34 GHz;
the dielectric substrate has asperities on the front surface, the asperities including at least two first regions as concavities located at a relatively low level, and a second region located at a relatively high level;
the thin-film conductive layer includes a plurality of metal plates discretely arranged in the at least two first regions;
the at least two first regions are discretely arranged; and
the second region is located between the two first regions.

6. The electromagnetic wave attenuation film according to claim 1, wherein

the predetermined frequency range is a frequency range of 35 GHz to 50 GHz;
the dielectric substrate has asperities on the front surface, the asperities including at least two first regions as concavities located at a relatively low level, and a second region located at a relatively high level;
the thin-film conductive layer includes a plurality of metal plates arranged in the at least two first regions;
the at least two first regions are discretely arranged; and
the second region is located between the two first regions.

7. The electromagnetic wave attenuation film according to claim 1, wherein

the predetermined frequency range is a frequency range of 57 GHz to 90 GHz;
the dielectric substrate has asperities on the front surface, the asperities including at least two first regions as concavities located at a relatively low level, and a second region located at a relatively high level;
the thin-film conductive layer includes a plurality of metal plates arranged in the at least two first regions;
the at least two first regions are discretely arranged; and
the second region is located between the two first regions.

8. The electromagnetic wave attenuation film according to any one of claims 1 to 7, wherein the thin-film conductive layer and the planar inductor are separated from each other in a thickness direction of the dielectric substrate.

9. The electromagnetic wave attenuation film according to any one of claims 1 to 8, comprising a lamination layer in place of the planar inductor.

10. The electromagnetic wave attenuation film according to any one of claims 1 to 9, wherein each of the metal plates have two opposing sides.

**11.** The electromagnetic wave attenuation film according to claim 10, wherein the two opposing sides in each of the metal plates have a length of 0.25 mm or more and 4 mm or less.

**12.** The electromagnetic wave attenuation film according to any one of claims 1 to 11, comprising a top coat layer on the thin-film conductive layer.

**13.** The electromagnetic wave attenuation film according to claim 12, wherein the top coat layer is configured to match an impedance thereof to an impedance of air through which the electromagnetic waves are propagative.

**14.** The electromagnetic wave attenuation film according to any one of claims 1 to 13, wherein the metal plates are made of any of silver, copper and aluminum.

**15.** The electromagnetic wave attenuation film according to any one of claims 1 to 14, wherein the plurality of metal plates having a constant shape and a constant size are arranged spaced apart from each other by a distance in a predetermined range.

# FIG.1

# FIG.2

# FIG.3

# FIG.4

# FIG.5

FIG.6

# FIG.7

# FIG.8

# FIG.9

# FIG.10

(a) metal species and skin depth 27GHz

| metal species | admittance (siemens/m) | skin depth(nm) |
|---|---|---|
| silver | 61000000 | 392.2 |
| copper | 38000000 | 402.2 |
| aluminum | 7600000 | 496.9 |

(b)

3.05mm
0.79mm
50um
changeable metal thickness
PET

(c) silver

Monostatic RCS(dB) / ln(T/d)

(d) copper

Monostatic RCS(dB) / ln(T/d)

(e) aluminum

Monostatic RCS(dB) / ln(T/d)

FIG.11

EP 4 250 890 A1

(a) metal species and skin depth 28GHz

| metal species | admittance (siemens/m) | skin depth(nm) |
|---|---|---|
| silver | 61000000 | 385.1 |
| copper | 38000000 | 394.9 |
| aluminum | 7600000 | 487.9 |

(b)

2.9mm
0.75mm
changeable metal thickness
50um
PET

(c) silver

(d) copper

(e) aluminum

# FIG.12

(a) metal species and skin depth　31GHz

| metal species | admittance (siemens/m) | skin depth(nm) |
|---|---|---|
| silver | 61000000 | 366.0 |
| copper | 38000000 | 375.3 |
| aluminum | 7600000 | 463.7 |

(b)

(c) silver

(d) copper

(e) aluminum

FIG.13

(a) metal species and skin depth 34GHz

| metal species | admittance (siemens/m) | skin depth(nm) |
|---|---|---|
| silver | 61000000 | 349.5 |
| copper | 38000000 | 358.4 |
| aluminum | 7600000 | 442.8 |

(b)

2.4mm
0.6 2mm
changeable metal thickness
50um
PET

(c)

silver

MonostaticRCS(dB)

ln(T/d)

(d)

copper

MonostaticRCS(dB)

ln(T/d)

(e)

aluminum

MonostaticRCS(dB)

ln(T/d)

EP 4 250 890 A1

# FIG.14

(a)

(b)

# FIG.15

# FIG.16

rectangle

( a )

W7

W8

( b )

W4

W4

II ---- II

( c )

| W7 (mm) | 2.9 |
|---------|------|
| W8 (mm) | 1.45 |
| W4 (mm) | 3.8 |

( d )

# FIG.17

(c)

| | |
|---|---|
| W9 (mm) | 1.7 |
| W4 (mm) | 3.8 |

(d)

hexagon

Frequency(GHz)

MonostaticRCS(dB)

hexagon

(a)

W9

(b)

W4

W4

II

II

# FIG.18

convex

(a)

W10 · W15 · W16 · W11

(b)

W4 · W4 · II · II

(c)

| | |
|---|---|
| W10 (mm) | 1.45 |
| W11 (mm) | 2.9 |
| W15 (mm) | 1.15 |
| W16 (mm) | 1.45 |
| W4 (mm) | 3.8 |

(d)

MonostaticRCS(dB) vs Frequency(GHz)

—— convex

# FIG.19

triangle

(a)

W12

(b)

W4

W4

W4

II

II

(c)

| | |
|---|---|
| W12 (mm) | 3.11 |
| W4 (mm) | 3.8 |

(d)

triangle

Monostatic RCS(dB) vs Frequency(GHz)

# FIG.20

cross

(a)

W14

W13

(b)

W4

W4

II

II

(c)

| | |
|---|---|
| W13 (mm) | 1.45 |
| W14 (mm) | 2.9 |
| W4 (mm) | 3.8 |

(d)

MonostaticRCS(dB)

—cross

Frequency(GHz)

# FIG.21

# FIG.22

# FIG.23

(a) metal species and skin depth 35GHz

| metal species | admittance (siemens/m) | skin depth(nm) |
|---|---|---|
| silver | 61000000 | 344.4 |
| copper | 38000000 | 353.2 |
| aluminum | 7600000 | 436.4 |

(b)

2.35mm  0.61mm  50um  changeable metal thickness  PET

(c) silver

(d) copper

(e) aluminum

# FIG.24

(a) metal species and skin depth  39GHz

| metal species | admittance (siemens/m) | skin depth(nm) |
|---|---|---|
| silver | 61000000 | 326.3 |
| copper | 38000000 | 334.6 |
| aluminum | 7600000 | 413.4 |

(b)

(c) silver

(d) copper

(e) aluminum

# FIG.25

(a) metal species and skin depth 41GHz

| metal species | admittance (siemens/m) | skin depth(nm) |
|---|---|---|
| silver | 61000000 | 318.2 |
| copper | 38000000 | 326.4 |
| aluminum | 7600000 | 403.2 |

(b)

(c) silver

(d) copper

(e) aluminum

# FIG.26

(a) metal species and skin depth 45GHz

| metal species | admittance (siemens/m) | skin depth(nm) |
|---|---|---|
| silver | 61000000 | 303.8 |
| copper | 38000000 | 311.5 |
| aluminum | 7600000 | 384.9 |

(b)

changeable metal thickness

1.83mm  0.47mm  50um  PET

(c) silver

(d) copper

(e) aluminum

FIG.27

(a) metal species and skin depth　50GHz

| metal species | admittance (siemens/m) | skin depth(nm) |
|---|---|---|
| silver | 61000000 | 288.2 |
| copper | 38000000 | 295.5 |
| aluminum | 7600000 | 365.1 |

(b)

1.63mm

0.42mm

50um

PET

changeable metal thickness

(c)

silver

(d)

copper

(e)

aluminum

EP 4 250 890 A1

# FIG.28

(a)

(b)

# FIG.29

circle

(a)

(b)

(c)

| | |
|---|---|
| R1 (mm) | 1.12 |
| W4 (mm) | 3.0 |

(d)

rectangle

(a)

W7

W8

(b)

W4

W4

II ———— II

FIG.30

EP 4 250 890 A1

(c)

| W7 (mm) | 2.1 |
|---------|-----|
| W8 (mm) | 1.6 |
| W4 (mm) | 3.0 |

(d)

rectangle

MonostaticRCS(dB) vs Frequency(GHz)

Frequency(GHz)

# FIG.31

hexagon

(a)

(b)

(c)

| | |
|---|---|
| W9 (mm) | 1.43 |
| W4 (mm) | 3.0 |

(d)

# FIG.32

(c)

| | |
|---|---|
| W10 (mm) | 0.8 |
| W11 (mm) | 1.9 |
| W15 (mm) | 1.1 |
| W16 (mm) | 0.8 |
| W4 (mm) | 3.0 |

(d)

convex

(a)

(b)

# FIG.33

triangle

(a)

W12

(b)

W4

W4

II

II

(c)

| | |
|---|---|
| W12 (mm) | 2.42 |
| W4 (mm) | 3.0 |

(d)

MonostaticRCS(dB) vs Frequency(GHz)

— triangle

# FIG.34

cross

(a)

(b)

(c)

| | | |
|---|---|---|
| W13 (mm) | | 0.8 |
| W14 (mm) | | 1.9 |
| W4 (mm) | | 3.0 |

(d)

# FIG.35A

loop

(a)

W5

W6

(b)

W4

W4

II

II

(c)

| | | |
|---|---|---|
| W5 (mm) | | 1.5 |
| W6 (mm) | | 0.75 |
| W4 (mm) | | 3.0 |

(d)

loop

Frequency(GHz)

MonostaticRCS(dB)

0.5  0  -0.5  -1  -1.5  -2  -2.5  -3  -3.5

34  36  38  40  42  44

FIG.35B

EP 4 250 890 A1

loop

(b)

| H1 (μm) | 50 |
|---|---|
| H2 (μm) | 100 |

(a)

30A  30A  30A  30A  30A  30A

62
63
50

H1
H2

(c)

MonostaticRCS(dB)

2
0
-2
-4
-6
-8
-10
-12

loop

38  40  42  44  46  48  50

Frequency(GHz)

# FIG.36

# FIG.37

FIG.38

(a) metal species and skin depth 57GHz

| metal species | admittance (siemens/m) | skin depth(nm) |
|---|---|---|
| silver | 61000000 | 269.9 |
| copper | 38000000 | 276.8 |
| aluminum | 7600000 | 342.0 |

(b)

(c)

(d)

(e)

EP 4 250 890 A1

# FIG.39

(a) metal species and skin depth  66GHz

| metal species | admittance (siemens/m) | skin depth(nm) |
|---|---|---|
| silver | 61000000 | 250.8 |
| copper | 38000000 | 257.2 |
| aluminum | 7600000 | 317.8 |

(b)

(c) silver

(d) copper

(e) aluminum

FIG.40

EP 4 250 890 A1

(a) metal species and skin depth 71GHz

| metal species | admittance (siemens/m) | skin depth(nm) |
|---|---|---|
| silver | 61000000 | 241.8 |
| copper | 38000000 | 248.0 |
| aluminum | 7600000 | 306.4 |

(b)

(c)

(d)

(e)

FIG.41

EP 4 250 890 A1

(a) metal species and skin depth 81GHz

| metal species | admittance (siemens/m) | skin depth(nm) |
|---|---|---|
| silver | 61000000 | 226.4 |
| copper | 38000000 | 232.2 |
| aluminum | 7600000 | 286.9 |

(b)

0.99mm
0.26mm
50um    PET
changeable metal thickness

(c)
silver

(d)
copper

(e)
aluminum

# FIG.42

(a) metal species and skin depth  86GHz

| metal species | admittance (siemens/m) | skin depth(nm) |
|---|---|---|
| silver | 61000000 | 219.7 |
| copper | 38000000 | 225.4 |
| aluminum | 7600000 | 278.4 |

(b)

changeable metal thickness

0.93mm

0.24mm

50um

PET

(c) silver

(d) copper

(e) aluminum

# FIG.43

(a) metal species and skin depth 90GHz

| metal species | admittance (siemens/m) | skin depth(nm) |
|---|---|---|
| silver | 61000000 | 214.8 |
| copper | 38000000 | 220.3 |
| aluminum | 7600000 | 272.1 |

(b)

changeable metal thickness

0.89mm
0.23mm
50um
PET

(c) silver
Monostatic RCS(dB)
ln(T/d)

(d) copper
Monostatic RCS(dB)
ln(T/d)

(e) aluminum
Monostatic RCS(dB)
ln(T/d)

FIG.44

(a)

changeable distance
between metal plates

1.0mm

80nm

50um

PET

(b)

# FIG.45

(a)

rectangle

(b)

(c)

| | |
|---|---|
| W7 (mm) | 1.0 |
| W8 (mm) | 0.5 |
| W4 (mm) | 2.2 |

(d)

# FIG.46

# FIG.47

(c)

| | |
|---|---|
| W10 (mm) | 0.5 |
| W11 (mm) | 1.0 |
| W15 (mm) | 0.5 |
| W16 (mm) | 0.5 |
| W4 (mm) | 2.2 |

(d)

(a)

convex

(b)

# FIG.48

triangle

(a)

W12

(b)

W4

W4

II

II

(c)

| | |
|---|---|
| W12 (mm) | 1.22 |
| W4 (mm) | 2.2 |

(d)

Monostatic RCS(dB) vs Frequency(GHz)

triangle

FIG.49

EP 4 250 890 A1

cross

( a )

W13

W14

( b )

W4

W4

II          II

( c )

| W13 （mm) | 0.5 |
|---|---|
| W14 （mm) | 1.0 |
| W4 （mm) | 2.2 |

( d )

MonostaticRCS(dB)

—cross

Frequency(GHz)

# FIG.50

# FIG.51

# FIG.52

FIG.53

EP 4 250 890 A1

## INTERNATIONAL SEARCH REPORT

| International application No. |
|---|
| **PCT/JP2021/041096** |

### A.    CLASSIFICATION OF SUBJECT MATTER

*H05K 9/00*(2006.01)i; *B32B 7/025*(2019.01)i; *B32B 15/04*(2006.01)i; *B32B 15/08*(2006.01)i; *B32B 27/18*(2006.01)i; *H01Q 17/00*(2006.01)i

FI:    H05K9/00 M; H01Q17/00; B32B7/025; B32B15/04 Z; B32B27/18 A; B32B15/08 E

According to International Patent Classification (IPC) or to both national classification and IPC

### B.    FIELDS SEARCHED

Minimum documentation searched (classification system followed by classification symbols)

H05K9/00; B32B7/025; B32B15/04; B32B15/08; B32B27/18; H01Q17/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| Y | JP 2007-073662 A (MITSUBISHI GAS CHEM CO INC) 22 March 2007 (2007-03-22)<br>paragraphs [0001], [0018]-[0020], [0036], fig. 1-2 | 1-15 |
| Y | JP 2005-012204 A (NITTA KK) 13 January 2005 (2005-01-13)<br>paragraph [0036] | 1-15 |
| Y | JP 2001-156491 A (MITSUBISHI ELECTRIC CORP) 08 June 2001 (2001-06-08)<br>paragraphs [0011]-[0016] | 2-4, 8-15 |
| Y | CN 208029314 U (JIANGXI LINE PRINTING TAIHE NEW MATERIAL CO., LTD.) 30 October 2018 (2018-10-30)<br>paragraphs [0034]-[0041], fig. 1-2 | 5-15 |
| Y | JP 7-193387 A (FUJI ELELCTROCHEM CO LTD) 28 July 1995 (1995-07-28)<br>paragraphs [0002]-[0005] | 9-15 |
| Y | CN 110972459 A (CENTRAL SOUTH UNIVERSITY OF FORESTRY AND TECHNOLOGY) 07 April 2020 (2020-04-07)<br>paragraph [0030] | 12-15 |

☑ Further documents are listed in the continuation of Box C.          ☑ See patent family annex.

| \*   Special categories of cited documents: | "T"   later document published after the international filing date or priority date and not in conflict with the application but cited to understand the principle or theory underlying the invention |
|---|---|
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **25 January 2022** | **08 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2021/041096**

**C.    DOCUMENTS CONSIDERED TO BE RELEVANT**

| Category* | Citation of document, with indication, where appropriate, of the relevant passages | Relevant to claim No. |
|---|---|---|
| Y | CN 206807974 U (DALIAN DONGSHIN MICROWAVE TECHNOLOGY CO., LTD.) 26 December 2017 (2017-12-26) <br> paragraph [0028] | 12-15 |
| A | CN 111755837 A (CHONGQING UNIVERSITY OF POSTS AND TELECOMMUNICATIONS) 09 October 2020 (2020-10-09) <br> entire text, all drawings | 1-15 |

Form PCT/ISA/210 (second sheet) (January 2015)

## INTERNATIONAL SEARCH REPORT
### Information on patent family members

International application No.

**PCT/JP2021/041096**

| Patent document cited in search report | | | Publication date (day/month/year) | Patent family member(s) | Publication date (day/month/year) |
|---|---|---|---|---|---|
| JP | 2007-073662 | A | 22 March 2007 | (Family: none) | |
| JP | 2005-012204 | A | 13 January 2005 | (Family: none) | |
| JP | 2001-156491 | A | 08 June 2001 | (Family: none) | |
| CN | 208029314 | U | 30 October 2018 | (Family: none) | |
| JP | 7-193387 | A | 28 July 1995 | (Family: none) | |
| CN | 110972459 | A | 07 April 2020 | (Family: none) | |
| CN | 206807974 | U | 26 December 2017 | (Family: none) | |
| CN | 111755837 | A | 09 October 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011233834 A
- JP 2015198163 A
- JP 2008060484 A
- WO 2010093027 A
- JP 2020009829 A
- JP 2612592 B
- JP 2006086422 A